(19) **Europäisches Patentamt**
**European Patent Office**
**Office européen des brevets**

(11) **EP 3 783 652 B1**

(12) **EUROPEAN PATENT SPECIFICATION**

(45) Date of publication and mention
of the grant of the patent:
**21.09.2022 Bulletin 2022/38**

(51) International Patent Classification (IPC):
***H01L 27/146*** *(2006.01)*    ***H01L 31/10*** *(2006.01)*
***H01L 51/42*** *(2006.01)*    ***H04N 5/369*** *(2011.01)*

(21) Application number: **19787979.4**

(22) Date of filing: **16.04.2019**

(52) Cooperative Patent Classification (CPC):
**H01L 27/14601; H01L 27/146; H01L 31/10;**
**H01L 51/42; H04N 5/369;** Y02E 10/549

(86) International application number:
**PCT/JP2019/016292**

(87) International publication number:
**WO 2019/203222 (24.10.2019 Gazette 2019/43)**

(54) **IMAGING ELEMENT, MULTILAYER IMAGING ELEMENT, AND SOLID-STATE IMAGING DEVICE**

BILDGEBUNGSELEMENT, MEHRSCHICHTIGES BILDGEBUNGSELEMENT UND
FESTKÖRPERBILDGEBUNGSVORRICHTUNG

ÉLÉMENT D'IMAGERIE, ÉLÉMENT D'IMAGERIE MULTICOUCHE ET DISPOSITIF D'IMAGERIE À
SEMI-CONDUCTEURS

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**

(30) Priority: **20.04.2018 JP 2018081252**
**31.08.2018 JP 2018162972**

(43) Date of publication of application:
**24.02.2021 Bulletin 2021/08**

(73) Proprietor: **Sony Group Corporation**
**Tokyo 108-0075 (JP)**

(72) Inventors:
• **MORIWAKI Toshiki**
**Tokyo 108-0075 (JP)**
• **NAKANO Hiroshi**
**Tokyo 108-0075 (JP)**

(74) Representative: **Müller Hoffmann & Partner**
**Patentanwälte mbB**
**St.-Martin-Strasse 58**
**81541 München (DE)**

(56) References cited:
**WO-A1-2017/029877    WO-A1-2018/025540**
**JP-A- 2007 123 698    JP-A- 2012 049 210**
**JP-A- 2016 063 165    US-A1- 2016 037 098**

**EP 3 783 652 B1**

**Description**

TECHNICAL FIELD

The present disclosure relates to an imaging element, a laminated imaging element, and a solid-state imaging device.

BACKGROUND ART

In recent years, a laminated imaging element has attracted attention as an imaging element constituting an image sensor and the like. The laminated imaging element has a structure in which a photoelectric conversion layer (light receiving layer) is sandwiched between two electrodes. In addition, the laminated imaging element requires a structure in which signal charges generated in the photoelectric conversion layer on the basis of photoelectric conversion are accumulated and transferred. A conventional structure requires a structure in which signal charges are accumulated in and transferred to a floating drain (FD) electrode, and requires high-speed transfer such that the signal charges are not delayed. The document WO 2018/025540 A1 is a related prior art.
An imaging element (photoelectric conversion element) for solving such a problem is disclosed in, for example, Japanese Patent Application Laid-Open No. 2016-63165. This imaging element includes:

an accumulation electrode formed on a first insulating layer;
a second insulating layer formed on the accumulation electrode;
a semiconductor layer formed so as to cover the accumulation electrode and the second insulating layer;
a collecting electrode formed in contact with the semiconductor layer and apart from the accumulation electrode;
a photoelectric conversion layer formed on the semiconductor layer; and
an upper electrode formed on the photoelectric conversion layer.

An imaging element using an organic semiconductor material for the photoelectric conversion layer can photoelectrically convert a specific color (wavelength band). In addition, because of such a characteristic, in a case where the imaging element is used as an imaging element in a solid-state imaging device, it is possible to obtain a structure having sub-pixels laminated (laminated imaging element), not possible with a conventional solid-state imaging device, in which each of the sub-pixels includes a combination of an on-chip color filter layer (OCCF) and an imaging element and the sub-pixels are arrayed two-dimensionally (see, for example, Japanese Patent Application Laid-Open No. 2011-138927). Furthermore, there is an advantage that a false color is not generated because demosaic processing is not required. In the following description, an imaging element including a photoelectric conversion unit disposed on or above a semiconductor substrate may be referred to as "first type imaging element" for convenience, a photoelectric conversion unit constituting the first type imaging element may be referred to as "first type photoelectric conversion unit" for convenience, an imaging element disposed in the semiconductor substrate may be referred to as "second type imaging element" for convenience, and a photoelectric conversion unit constituting the second type imaging element may be referred to as "second type photoelectric conversion unit" for convenience.

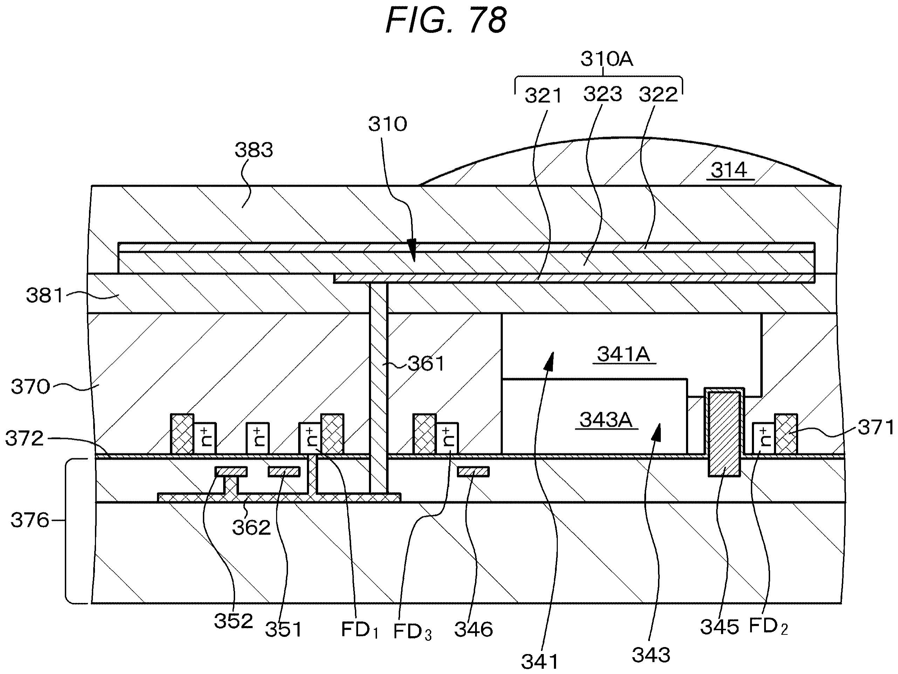

Fig. 78 illustrates a configuration example of a conventional laminated imaging element (laminated solid-state imaging device). In the example illustrated in Fig. 78, a third photoelectric conversion unit 343A and a second photoelectric conversion unit 341A which are second type photoelectric conversion units constituting a third imaging element 343 and a second imaging element 341 which are second type imaging elements, respectively, are laminated and formed in a semiconductor substrate 370. Furthermore, above the semiconductor substrate 370 (specifically, above the second imaging element 341), a first photoelectric conversion unit 310A which is a first type photoelectric conversion unit is disposed. Here, the first photoelectric conversion unit 310A includes a first electrode 321, a photoelectric conversion layer 323 including an organic material, and a second electrode 322, and constitutes a first imaging element 310 which is a first type imaging element. In the second photoelectric conversion unit 341A and the third photoelectric conversion unit 343A, for example, blue light and red light are photoelectrically converted due to a difference in absorption coefficient, respectively. Furthermore, in the first photoelectric conversion unit 310A, for example, green light is photoelectrically converted.
Charges generated by photoelectric conversion in the second photoelectric conversion unit 341A and the third photoelectric conversion unit 343A are temporarily accumulated in the second photoelectric conversion unit 341A and the third photoelectric conversion unit 343A, then transferred to a second floating diffusion layer (floating diffusion) $FD_2$ and a third floating diffusion layer $FD_3$ by a vertical transistor (a gate portion 345 is illustrated) and a transfer transistor (a gate portion 346 is illustrated), and further output to an external readout circuit (not illustrated), respectively. These transistors and floating diffusion layers $FD_2$ and $FD_3$ are also formed in the semiconductor substrate 370.
Charges generated by photoelectric conversion in the first photoelectric conversion unit 310A are accumulated in the first floating diffusion layer $FD_1$ formed in the semiconductor substrate 370 via a contact hole portion 361 and a wiring layer 362. Furthermore, the first photoelectric conversion unit 310A is also connected to a gate portion 352 of an amplification transistor for converting a charge amount into a voltage via the contact hole portion 361 and the wiring layer 362. In addition, the first floating diffusion layer $FD_1$ constitutes a part of a reset transistor (a gate portion 351 is illustrated). Reference numeral 371 represents an element isolation region, reference numeral 372 represents an oxide film formed on a surface of the semiconductor substrate 370, reference numerals 376 and 381 represent interlayer insulating layers, reference numeral 383 represents an insulating layer, and reference numeral 314 represents an on-chip micro lens.

CITATION LIST

PATENT DOCUMENT

Patent Document 1: Japanese Patent Application Laid-Open No. 2016-63165

Patent Document 2: Japanese Patent Application Laid-Open No. 2011-138927

EP 3 496 147 A1 describes an imaging element, multilayer imaging element, and solid-state imaging device. Herein, an imaging element includes an organic photoelectric conversion layer formed of a mixture of an electron transport material, an organic pigment material, and a hole transport material. The electron transport material has higher electron mobility than the organic pigment material. The hole transport material has higher hole mobility than the organic pigment material. A relation between values of electron affinity of the electron transport material and the organic pigment material, a relation between values of ionization potentials of the hole transport material and the organic pigment material, and a relation between a value of the electron affinity of the electron transport material and a value of an ionization potential of the hole transport material have predetermined relations.

SUMMARY OF THE INVENTION

PROBLEMS TO BE SOLVED BY THE INVENTION

However, in the technique disclosed in Japanese Patent Application Laid-Open No. 2016-63165 described above, there is a limitation that the accumulation electrode and the second insulating layer formed on the accumulation electrode need to be formed with the same length, and a gap from the collecting electrode and the like are finely defined. This complicates a manufacturing process and may cause a reduction in manufacturing yield. Moreover, some materials constituting a semiconductor layer are mentioned, but a composition of more specific materials or a configuration thereof is not mentioned. Furthermore, a correlation formula between a carrier mobility of the semiconductor layer and accumulated charges is mentioned. However, matters relating to improvement of charge transfer, such as matters relating to the carrier mobility of the semiconductor layer, which are important for transfer of generated charges, or matters relating to an energy level relationship between the semiconductor layer and a portion of the photoelectric conversion layer adjacent to the semiconductor layer, are not mentioned at all.

Therefore, an object of the present disclosure is to provide an imaging element, a laminated imaging element, and a solid-state imaging device having excellent transfer characteristics of charges accumulated in a photoelectric conversion layer in spite of having a simple configuration and structure.

This object is solved by the teachings of the independent claims. The invention is defined by the appended claims. References to embodiments which do not fall under the scope of the claims are to be understood as examples useful for understanding the invention.

An imaging element according to a first aspect includes

a photoelectric conversion unit formed by laminating a first electrode, a photoelectric conversion layer, and a second electrode, in which
an inorganic oxide semiconductor material layer is formed between the first electrode and the photoelectric conversion layer, and
the inorganic oxide semiconductor material layer contains a gallium (Ga) atom and a tin (Sn) atom.

An imaging element according to a second aspect includes

a photoelectric conversion unit formed by laminating a first electrode, a photoelectric conversion layer, and a second electrode, in which

an inorganic oxide semiconductor material layer is formed between the first electrode and the photoelectric conversion layer, and

the inorganic oxide semiconductor material layer contains a gallium (Ga) atom and an indium (In) atom.

A laminated imaging element includes at least one of the above-described imaging elements according to the first and second aspects.

A solid-state imaging device according to a first aspect includes a plurality of the above-described imaging elements according to the first and second aspects of the present disclosure. Furthermore, a solid-state imaging device according to a second aspect includes a plurality of the above-described laminated imaging elements of the present disclosure.

BRIEF DESCRIPTION OF DRAWINGS

Fig. 1 is a schematic partial cross-sectional view of an imaging element of Example 1.
Fig. 2 is an equivalent circuit diagram of the imaging element of Example 1.
Fig. 3 is an equivalent circuit diagram of the imaging element of Example 1.
Fig. 4 is a schematic arrangement diagram of a first electrode and a charge accumulation electrode constituting the imaging element of Example 1, and a transistor constituting a control unit.
Fig. 5 is a diagram schematically illustrating a potential state at each part during an operation of the imaging element of Example 1.
Figs. 6A, 6B, and 6C are equivalent circuit diagrams of imaging elements of Examples 1, 4, and 6 for explaining each part of Fig. 5 (Example 1), Figs. 20 and 21 (Example 4), and Figs. 32 and 33 (Example 6), respectively.
Fig. 7 is a schematic arrangement diagram of a first electrode and a charge accumulation electrode constituting the imaging element of Example 1.
Fig. 8 is a schematic perspective view of a first electrode, a charge accumulation electrode, a second electrode, and a contact hole portion constituting the imaging element of Example 1.
Fig. 9 is an equivalent circuit diagram of a modification of the imaging element of Example 1.
Fig. 10 is a schematic arrangement diagram of a first electrode and a charge accumulation electrode constituting the modification of the imaging element of Example 1 illustrated in Fig. 9, and a transistor constituting a control unit.
Fig. 11 is a schematic partial cross-sectional view of an imaging element of Example 2.
Fig. 12 is a schematic partial cross-sectional view of an imaging element of Example 3.
Fig. 13 is a schematic partial cross-sectional view of a modification of the imaging element of Example 3.
Fig. 14 is a schematic partial cross-sectional view of another modification of the imaging element of Example 3.
Fig. 15 is a schematic partial cross-sectional view of still another modification of the imaging element of Example 3.
Fig. 16 is a schematic partial cross-sectional view of a part of an imaging element of Example 4.
Fig. 17 is an equivalent circuit diagram of the imaging element of Example 4.
Fig. 18 is an equivalent circuit diagram of the imaging element of Example 4.
Fig. 19 is a schematic arrangement diagram of a first electrode, a transfer control electrode, and a charge accumulation electrode constituting the imaging element of Example 4, and a transistor constituting a control unit.
Fig. 20 is a diagram schematically illustrating a potential state at each part during an operation of the imaging element of Example 4.
Fig. 21 is a diagram schematically illustrating a potential state at each part during another operation of the imaging element of Example 4.
Fig. 22 is a schematic arrangement diagram of a first electrode, a transfer control electrode, and a charge accumulation electrode constituting the imaging element of Example 4.
Fig. 23 is a schematic perspective view of a first electrode, a transfer control electrode, a charge accumulation electrode, a second electrode, and a contact hole portion constituting the imaging element of Example 4.
Fig. 24 is a schematic arrangement diagram of a first electrode, a transfer control electrode, and a charge accumulation electrode constituting a modification of the imaging element of Example 4, and a transistor constituting a control unit.
Fig. 25 is a schematic partial cross-sectional view of a part of an imaging element of Example 5.
Fig. 26 is a schematic arrangement diagram of a first electrode, a charge accumulation electrode, and a charge discharge electrode constituting the imaging element of Example 5.
Fig. 27 is a schematic perspective view of a first electrode, a charge accumulation electrode, a charge discharge electrode, a second electrode, and a contact hole portion constituting the imaging element of Example 5.

Fig. 28 is a schematic partial cross-sectional view of an imaging element of Example 6.

Fig. 29 is an equivalent circuit diagram of the imaging element of Example 6.

Fig. 30 is an equivalent circuit diagram of the imaging element of Example 6.

Fig. 31 is a schematic arrangement diagram of a first electrode and a charge accumulation electrode constituting the imaging element of Example 6, and a transistor constituting a control unit.

Fig. 32 is a diagram schematically illustrating a potential state at each part during an operation of the imaging element of Example 6.

Fig. 33 is a diagram schematically illustrating a potential state at each part during another operation (during transfer) of the imaging element of Example 6.

Fig. 34 is a schematic arrangement diagram of a first electrode and a charge accumulation electrode constituting the imaging element of Example 6.

Fig. 35 is a schematic perspective view of a first electrode, a charge accumulation electrode, a second electrode, and a contact hole portion constituting the imaging element of Example 6.

Fig. 36 is a schematic arrangement diagram of a first electrode and a charge accumulation electrode constituting a modification of the imaging element of Example 6.

Fig. 37 is a schematic partial cross-sectional view of an imaging element of Example 7.

Fig. 38 is a schematic partial cross-sectional view obtained by enlarging a portion where a charge accumulation electrode, a photoelectric conversion layer, and a second electrode are laminated in the imaging element of Example 7.

Fig. 39 is a schematic arrangement diagram of a first electrode and a charge accumulation electrode constituting a modification of the imaging element of Example 7, and a transistor constituting a control unit.

Fig. 40 is a schematic partial cross-sectional view obtained by enlarging a portion where a charge accumulation electrode, a photoelectric conversion layer, and a second electrode are laminated in the imaging element of Example 8.

Fig. 41 is a schematic partial cross-sectional view of an imaging element of Example 9.

Fig. 42 is a schematic partial cross-sectional view of an imaging element of Examples 10 and 11.

Figs. 43A and 43B are schematic plan views of charge accumulation electrode segments in Example 11.

Figs. 44A and 44B are schematic plan views of charge accumulation electrode segments in Example 11.

Fig. 45 is a schematic arrangement diagram of a first electrode and a charge accumulation electrode constituting the imaging element of Example 11, and a transistor constituting a control unit.

Fig. 46 is a schematic arrangement diagram of a first electrode and a charge accumulation electrode constituting a modification of the imaging element of Example 11.

Fig. 47 is a schematic partial cross-sectional view of an imaging element of Examples 12 and 11.

Figs. 48A and 48B are schematic plan views of charge accumulation electrode segments in Example 12.

Fig. 49 is a schematic plan view of first electrodes and charge accumulation electrode segments in a solid-state imaging device of Example 13.

Fig. 50 is a schematic plan view of first electrodes and charge accumulation electrode segments in a first modification of the solid-state imaging device of Example 13.

Fig. 51 is a schematic plan view of first electrodes and charge accumulation electrode segments in a second modification of the solid-state imaging device of Example 13.

Fig. 52 is a schematic plan view of first electrodes and charge accumulation electrode segments in a third modification of the solid-state imaging device of Example 13.

Fig. 53 is a schematic plan view of first electrodes and charge accumulation electrode segments in a fourth modification of the solid-state imaging device of Example 13.

Fig. 54 is a schematic plan view of first electrodes and charge accumulation electrode segments in a fifth modification of the solid-state imaging device of Example 13.

Fig. 55 is a schematic plan view of first electrodes and charge accumulation electrode segments in a sixth modification of the solid-state imaging device of Example 13.

Fig. 56 is a schematic plan view of first electrodes and charge accumulation electrode segments in a seventh modification of the solid-state imaging device of Example 13.

Fig. 57 is a schematic plan view of first electrodes and charge accumulation electrode segments in an eighth modification of the solid-state imaging device of Example 13.

Fig. 58 is a schematic plan view of first electrodes and charge accumulation electrode segments in a ninth modification of the solid-state imaging device of Example 13.

Figs. 59A, 59B, and 59C are charts each illustrating a readout driving example in an imaging element block of Example 13.

Fig. 60 is a schematic plan view of first electrodes and charge accumulation electrode segments in a solid-state imaging device of Example 14.

Fig. 61 is a schematic plan view of first electrodes and charge accumulation electrode segments in a modification of the solid-state imaging device of Example 14.

Fig. 62 is a schematic plan view of first electrodes and charge accumulation electrode segments in a modification of the solid-state imaging device of Example 14.

Fig. 63 is a schematic plan view of first electrodes and charge accumulation electrode segments in a modification of the solid-state imaging device of Example 14.

Fig. 64 is a schematic partial cross-sectional view of another modification of the imaging element of Example 1.

Fig. 65 is a schematic partial cross-sectional view of still another modification of the imaging element of Example 1.

Figs. 66A, 66B, and 66C are each an enlarged schematic partial cross-sectional view of a first electrode portion and the like of still another modification of the imaging element of Example 1.

Fig. 67 is an enlarged schematic partial cross-sectional view of a charge discharge electrode portion and the like of another modification of the imaging element of Example 5.

Fig. 68 is a schematic partial cross-sectional view of still another modification of the imaging element of Example 1.

Fig. 69 is a schematic partial cross-sectional view of still another modification of the imaging element of Example 1.

Fig. 70 is a schematic partial cross-sectional view of still another modification of the imaging element of Example 1.

Fig. 71 is a schematic partial cross-sectional view of another modification of the imaging element of Example 4.

Fig. 72 is a schematic partial cross-sectional view of still another modification of the imaging element of Example 1.

Fig. 73 is a schematic partial cross-sectional view of still another modification of the imaging element of Example 4.

Fig. 74 is a schematic partial cross-sectional view obtained by enlarging a portion where a charge accumulation electrode, a photoelectric conversion layer, and a second electrode are laminated in a modification of the imaging element of Example 7.

Fig. 75 is a schematic partial cross-sectional view obtained by enlarging a portion where a charge accumulation electrode, a photoelectric conversion layer, and a second electrode are laminated in a modification of the imaging element of Example 8.

Fig. 76 is a conceptual diagram of a solid-state imaging device of Example 1.

Fig. 77 is a conceptual diagram of an example in which a solid-state imaging device including the imaging element and the like of the present disclosure is used for an electronic device (camera).

Fig. 78 is a conceptual diagram of a conventional laminated imaging element (laminated solid-state imaging device) .

Fig. 79 is a graph illustrating a relationship between $V_{gs}$ and $I_d$ in a TFT having a channel formation region constituted by $Ga_aSn_bO_c$.

Figs. 80A and 80B are electron micrographs illustrating an evaluation result of surface roughness in an evaluation sample in Example 1. Fig. 80C is a graph illustrating a result of measuring light absorption/transmission characteristics when an inorganic oxide semiconductor material layer is constituted by $Ga_aSn_bO_c$.

Fig. 81 is an electron micrograph illustrating a result of determining a change between roughness of a surface of an inorganic oxide semiconductor material layer before annealing and that after annealing, obtained on the basis of a second condition.

Fig. 82 is a block diagram illustrating an example of a schematic configuration of a vehicle control system.

Fig. 83 is an explanatory diagram illustrating examples of installation positions of a vehicle external information detection unit and an imaging unit.

Fig. 84 is a diagram illustrating an example of a schematic configuration of an endoscopic surgical system.

Fig. 85 is a block diagram illustrating examples of functional configurations of a camera head and a CCU.

## MODE FOR CARRYING OUT THE INVENTION

Hereinafter, the present disclosure will be described on the basis of Examples with reference to the drawings. However, the present disclosure is not limited to Examples, and various numerical values and materials in Example are illustrative.

Note that description will be made in the following order.

1. General description on imaging elements according to first and second aspects of the present disclosure, laminated imaging element of the present disclosure, and solid-state imaging devices according to first and second aspects of the present disclosure

2. Example 1 (laminated imaging elements of the present disclosure according to first and second aspects of the present disclosure, and solid-state imaging device according to second aspect of the present disclosure)

3. Example 2 (modification of Example 1)

4. Example 3 (modification of Examples 1 and 2, and solid-state imaging device according first aspect of the present disclosure)

5. Example 4 (modification of Examples 1 to 3, and imaging element including transfer control electrode)

6. Example 5 (modification of Examples 1 to 4, and imaging element including charge discharge electrode)

7. Example 6 (modification of Examples 1 to 5, and imaging element including a plurality of charge accumulation electrode segments)

8. Example 7 (imaging elements of first and sixth configurations)

9. Example 8 (imaging elements of second and sixth configurations of the present disclosure)

10. Example 9 (imaging element of third configuration)

11. Example 10 (imaging element of fourth configuration)

12. Example 11 (imaging element of fifth configuration)

13. Example 12 (imaging element of sixth configuration)

14. Example 13 (solid-state imaging devices of first and second configurations)

15. Example 14 (modification of Example 13)

16. Others

When the inorganic oxide semiconductor material layer is represented by $Ga_aSn_bO_c$, the imaging element and the like according to the first aspect of the present disclosure preferably adopt a form in which $a > b$ is satisfied, and the imaging element and the like according to the first aspect of the present disclosure including such a form preferably adopt a form in which

$$a + b + c = 1.00$$

and

$$0.20 < b/(a + b) < 0.40,$$

preferably

$$0.20 < b/(a + b) < 0.35$$

are satisfied. Furthermore, when the inorganic oxide semiconductor material layer is represented by $Ga_dIn_eO_f$, the imaging element and the like according to the second aspect of the present disclosure preferably adopt a form in which $d > e$ is satisfied, and the imaging element and the like according to the second aspect of the present disclosure including such a form preferably adopt a form in which

$$d + e + f = 1.00$$

and

$$0.20 < e/(d + e) < 0.40$$

are satisfied. Values of a, b, d, and e correspond to values of atomic percentage. The composition of the inorganic oxide semiconductor material layer can be determined, for example, on the basis of ICP emission spectroscopy (high frequency inductively coupled plasma emission spectroscopy, ICP-AES) or X-ray photoelectron spectroscopy (XPS).

Note that in a process of forming the inorganic oxide semiconductor material layer, in some cases, other impurities such as hydrogen, other metals, or metal compounds may be mixed, but a trace amount (for example, 3% or less in molar fraction) of the impurities may be mixed.

In the imaging element and the like of the present disclosure including the preferable forms described above, the photoelectric conversion unit can further include an insulating layer and a charge accumulation electrode disposed apart from the first electrode so as to face the inorganic oxide semiconductor material layer via the insulating layer.

Moreover, the imaging element and the like of the present disclosure including the various preferable forms described above can adopt a form in which a LUMO value $E_1$ of a material constituting a portion of the photoelectric conversion layer located near the inorganic oxide semiconductor material layer and a LUMO value $E_2$ of a material constituting the inorganic oxide semiconductor material layer satisfy preferably

$$E_2 - E_1 \geq 0.1 \text{ eV,}$$

more preferably

$$E_2 - E_1 > 0.1 \text{ eV.}$$

A HOMO value can be determined, for example, on the basis of ultraviolet photoelectron spectroscopy (UPS method). Furthermore, a LUMO value can be determined from {(valence band energy, HOMO value) + $E_b$}. Moreover, the bandgap energy $E_b$ can be determined from a wavelength $\lambda$ optically absorbed (optical absorption edge wavelength, the unit of which is nm) on the basis of the following formula.

$$E_b = h\nu = h(c/\lambda) = 1239.8/\lambda\,[\text{eV}]$$

Here, the "portion of the photoelectric conversion layer located near the inorganic oxide semiconductor material layer" refers to a portion of the photoelectric conversion layer located in a region corresponding to 10% or less of the thickness of the photoelectric conversion layer based on an interface between the inorganic oxide semiconductor material layer and the photoelectric conversion layer (that is, a region extending from 0% to 10% of the thickness of the photoelectric conversion layer). The LUMO value $E_1$ of the material constituting the portion of the photoelectric conversion layer located near the inorganic oxide semiconductor material layer is an average value in the portion of the photoelectric conversion layer located near the inorganic oxide semiconductor material layer, and the LUMO value $E_2$ of the material constituting the inorganic oxide semiconductor material layer is an average value in the inorganic oxide semiconductor material layer.

Moreover, the imaging element and the like of the present disclosure including the various preferable forms described above can adopt a form in which the material constituting the inorganic oxide semiconductor material layer has a carrier mobility of 10 cm$^2$/V·s or more.

Moreover, the imaging element and the like of the present disclosure including the various preferable forms described above can adopt a form in which the inorganic oxide semiconductor material layer is amorphous (for example, amorphous without a local crystal structure). Whether or not the inorganic oxide semiconductor material layer is amorphous can be determined on the basis of X-ray diffraction analysis.

Moreover, the imaging element and the like of the present disclosure including the various preferable forms described above can adopt a form in which the inorganic oxide semiconductor material layer has a thickness of $1 \times 10^{-8}$ m to $1.5 \times 10^{-7}$ m, preferably $2 \times 10^{-8}$ m to $1.0 \times 10^{-7}$ m, more preferably $3 \times 10^{-8}$ m to $1.0 \times 10^{-7}$ m.

Moreover, the imaging element and the like of the present disclosure including the various preferable forms described above can adopt a form in which

light is incident from the second electrode,
surface roughness Ra of a surface of the inorganic oxide semiconductor material layer at an interface between the photoelectric conversion layer and the inorganic oxide semiconductor material layer is 1.5 nm or less, and a value of root mean square roughness Rq of the surface of the inorganic oxide semiconductor material layer is 2.5 nm or less. Values of surface roughness Ra and Rq are determined on the basis of the provisions of JIS B0601:2013. Furthermore, surface roughness $R_{max}$ of the inorganic oxide semiconductor material layer at the interface between the photoelectric conversion layer and the inorganic oxide semiconductor material layer is preferably 7 nm or less. Such smoothness of the surface of the inorganic oxide semiconductor material layer at the interface between the photoelectric conversion layer and the inorganic oxide semiconductor material layer can suppress scattering reflection at the surface of the inorganic oxide semiconductor material layer and improve bright current characteristics in photoelectric conversion. A form can be adopted in which surface roughness Ra of the surface of the charge accumulation electrode is 1.5 nm or less, and a value of root mean square roughness Rq of the surface of the charge accumulation electrode is 2.5 nm or less.

Moreover, in the imaging element and the like of the present disclosure including the various preferable forms described above, the inorganic oxide semiconductor material layer preferably has a carrier concentration of less than $1 \times 10^{16}$/cm$^3$.

Moreover, the imaging element and the like of the present disclosure including the preferable forms described above can adopt a form in which charges generated in the photoelectric conversion layer move to the first electrode via the inorganic oxide semiconductor material layer, in which the charges can be electrons.

In a conventional imaging element illustrated in Fig. 78, charges generated by photoelectric conversion in the second photoelectric conversion unit 341A and the third photoelectric conversion unit 343A are temporarily accumulated in the second photoelectric conversion unit 341A and the third photoelectric conversion unit 343A, and then transferred to the second floating diffusion layer $FD_2$ and the third floating diffusion layer $FD_3$, respectively. Therefore, the second photoelectric conversion unit 341A and the third photoelectric conversion unit 343A can be completely depleted. However, charges generated by photoelectric conversion in the first photoelectric conversion unit 310A are directly accumulated in the first floating diffusion layer $FD_1$. Therefore, it is difficult to completely deplete the first photoelectric conversion unit 310A. In addition, as a result, a kTC noise increases, a random noise deteriorates, and the quality of an imaged image may deteriorate.

As described above, the imaging element and the like of the present disclosure include the charge accumulation electrode which is disposed apart from the first electrode so as to face the inorganic oxide semiconductor material layer via an insulating layer. Therefore, when the photoelectric conversion unit is irradiated with light, and the light is photoelectrically converted in the photoelectric conversion unit, charges can be stored in the inorganic oxide semiconductor material layer (or the inorganic oxide semiconductor material layer and the photoelectric conversion layer in some cases). Therefore, at the time of start of exposure, a charge accumulation portion can be completely depleted and the charge can be erased. As a result, it is possible to suppress occurrence of a phenomenon that a kTC noise increases, a random noise deteriorates, and the quality of an imaged image deteriorates. Note that in the following description, the inorganic oxide semiconductor material layer, or the inorganic oxide semiconductor material layer and the photoelectric conversion layer may be collectively referred to as "inorganic oxide semiconductor material layer and the like".

The inorganic oxide semiconductor material layer may have a single layer configuration or a multilayer configuration. Furthermore, a material constituting the inorganic oxide semiconductor material layer located above the charge accumulation electrode may be different from a material constituting the inorganic oxide semiconductor material layer located above the first electrode.

The inorganic oxide semiconductor material layer can be formed, for example, on the basis of a sputtering method. Specifically, in the light emitting element and the like according to the first aspect of the present disclosure, for example, a sputtering method using a parallel plate sputtering device, a DC magnetron sputtering device, or an RF sputtering device as a sputtering device, using an argon (Ar) gas as a process gas, and using a $Ga_aSn_bO_c$ sintered body as a target can be exemplified, and in the light emitting element and the like according to the second aspect of the present disclosure, for example, a sputtering method using a parallel plate sputtering device, a DC magnetron sputtering device, or an RF sputtering device as a sputtering device, using an argon (Ar) gas as a process gas, and using a $Ga_dIn_eO_f$ sintered body as a target can be exemplified.

Note that the energy level of the inorganic oxide semiconductor material layer can be controlled by controlling the amount of oxygen gas introduced (oxygen gas partial pressure) when the inorganic oxide semiconductor material layer is formed on the basis of the sputtering method. Specifically, when the inorganic oxide semiconductor material layer is formed on the basis of the sputtering method,

$$\text{an oxygen gas partial pressure} = (O_2 \text{ gas pressure})/(\text{total pressure of Ar gas and } O_2 \text{ gas})$$

is preferably set to 0.005 to 0.10. Moreover, the imaging element and the like of the present disclosure can adopt a form in which the oxygen content in the inorganic oxide semiconductor material layer is less than that in a stoichiometric composition. Here, the energy level of the inorganic oxide semiconductor material layer can be controlled on the basis of the oxygen content. As the oxygen content is lower than the oxygen content in the stoichiometric composition, that is, as oxygen deficiency increases, the energy level can be deepened.

Examples of the imaging element and the like of the present disclosure include a CCD element, a CMOS imaging element, a contact image sensor (CIS), and a charge modulation device (CMD) type signal amplification imaging element. For example, a digital still camera, a video camera, a camcorder, a surveillance camera, a vehicle-mounted camera, a smartphone camera, a game user interface camera, and a biometric authentication camera can be constituted by the solid-state imaging devices according to the first and second aspects of the present disclosure and the solid-state imaging devices of the first and second configurations described later.

[Example 1]

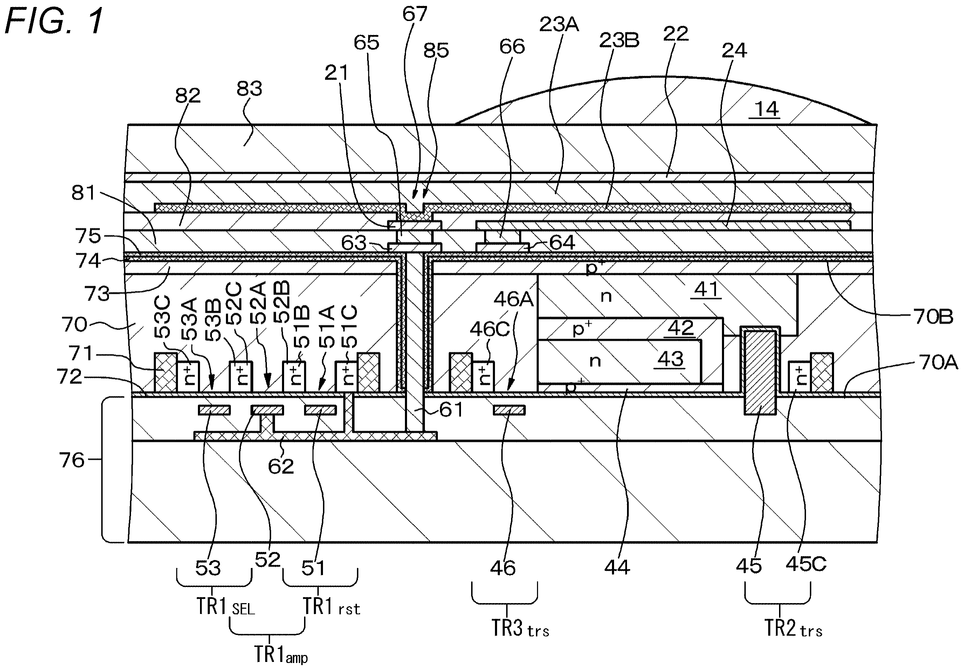

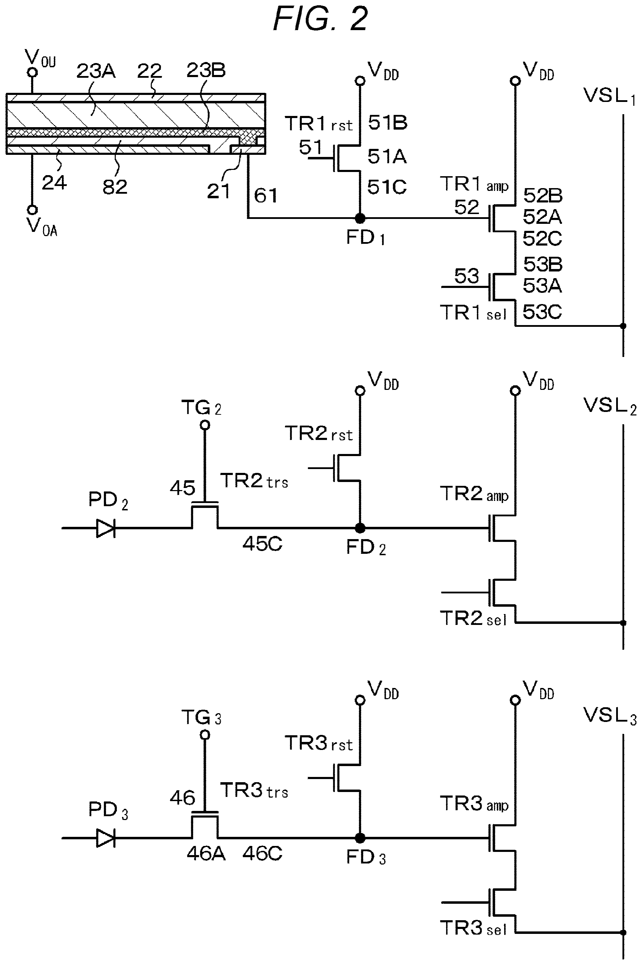

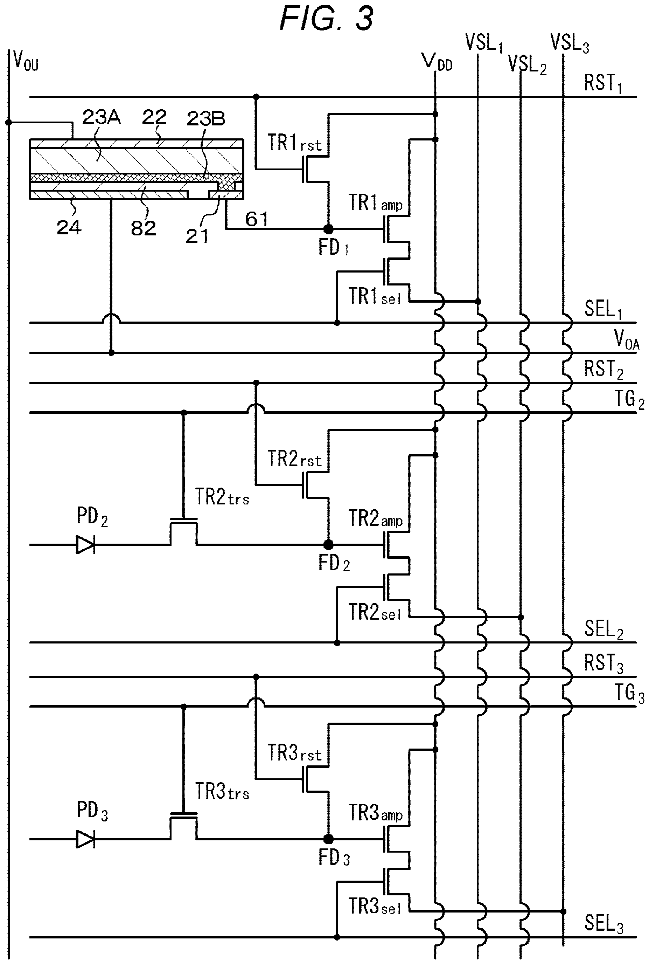

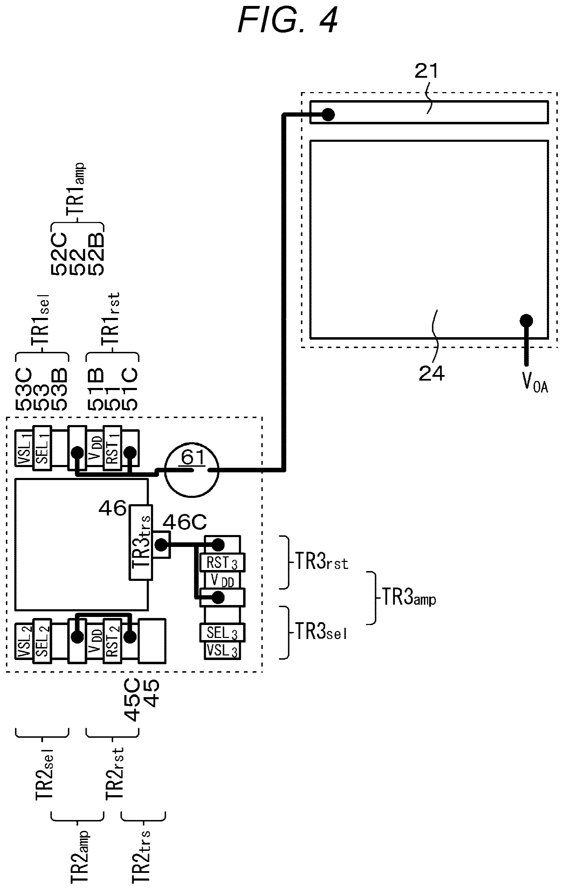

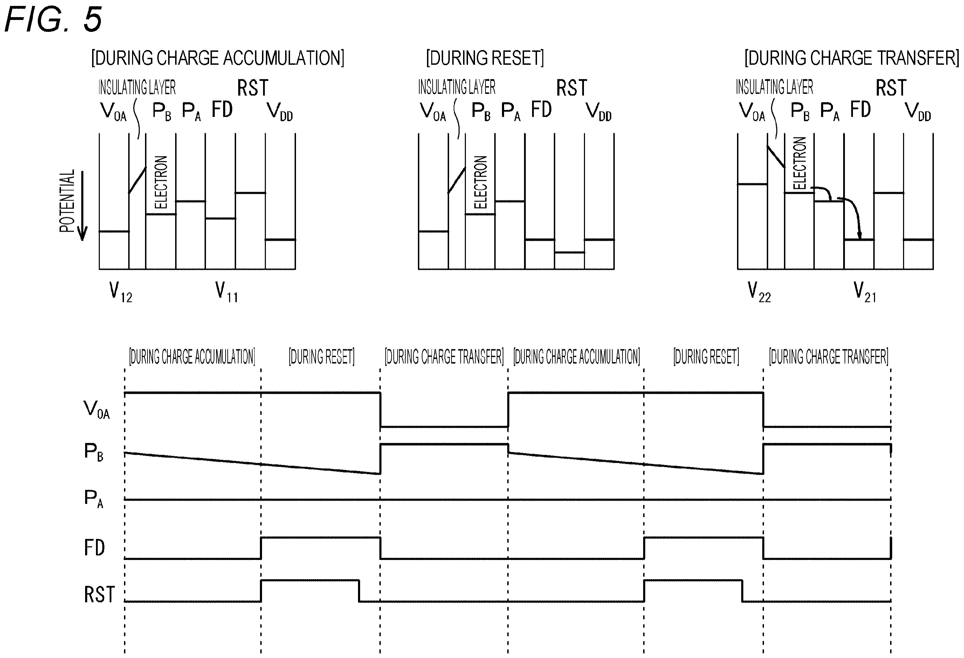

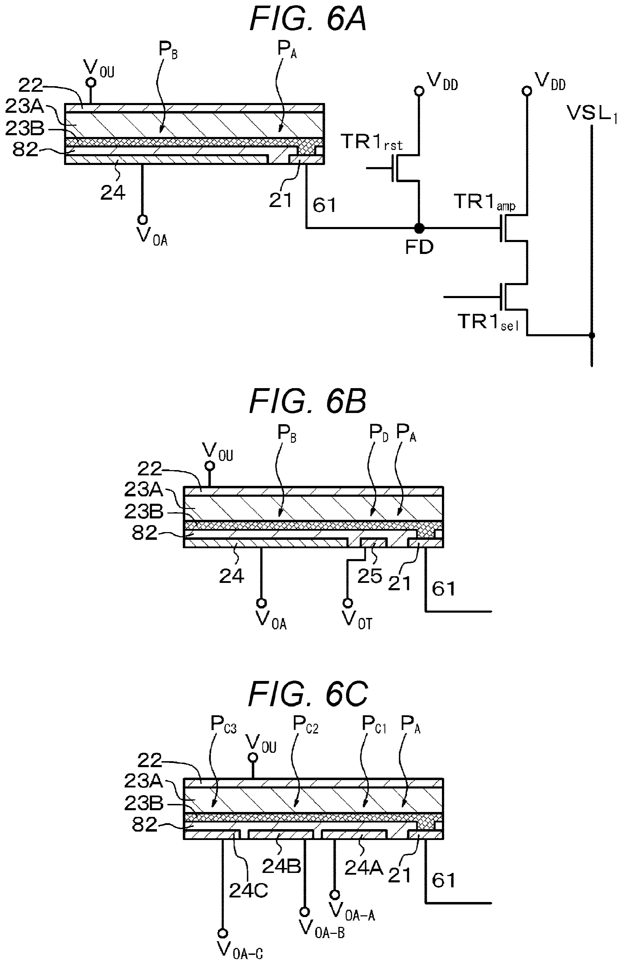

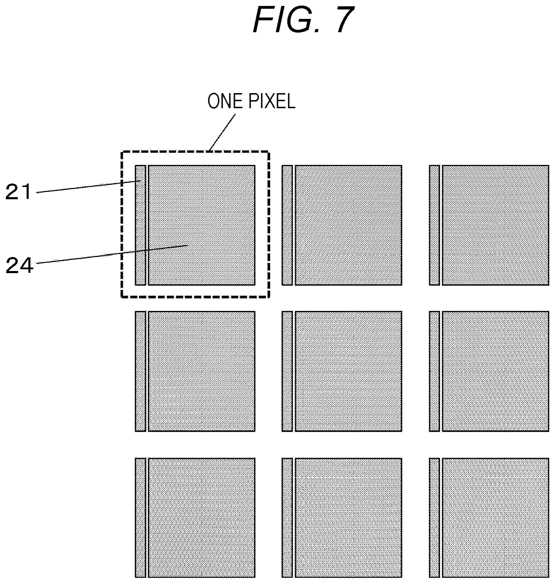

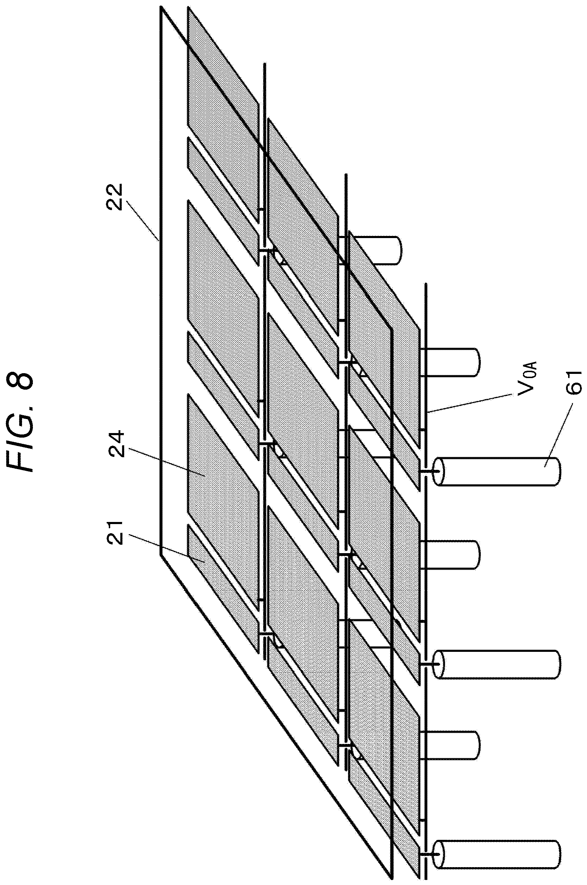

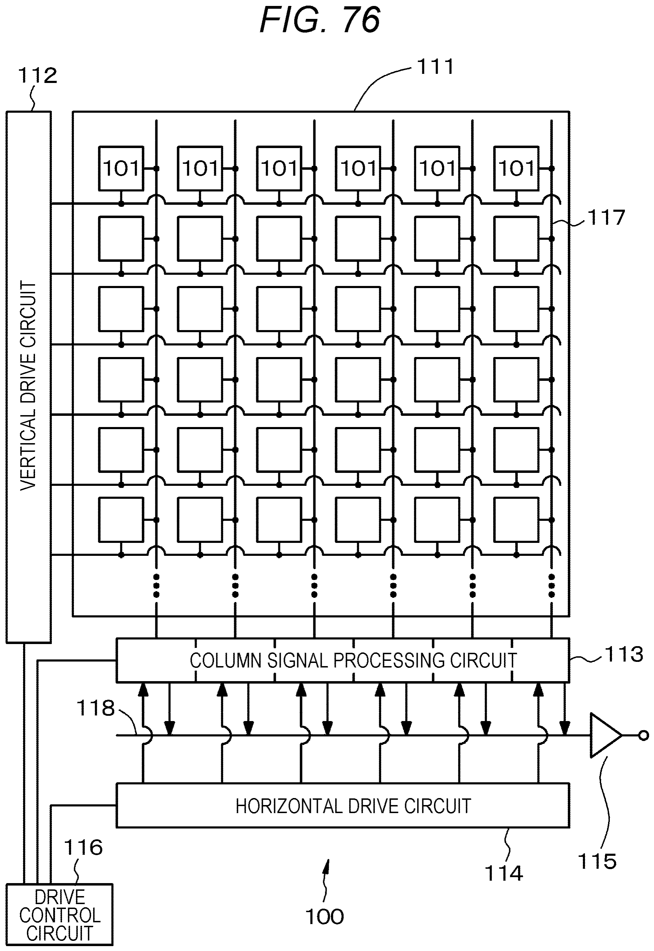

Example 1 relates to the imaging elements according to the first and second aspects of the present disclosure, the laminated imaging element of the present disclosure, and the solid-state imaging device according to the second aspect of the present disclosure. Fig. 1 illustrates a schematic partial cross-sectional view of the imaging element and the laminated imaging element of Example 1 (hereinafter, simply referred to as "imaging element"). Figs. 2 and 3 illustrate an equivalent circuit diagram of the imaging element of Example 1. Fig. 4 illustrates a schematic arrangement diagram of the first electrode and the charge accumulation electrode constituting the photoelectric conversion unit of the imaging element of Example 1, and a transistor constituting a control unit. Fig. 5 schematically illustrates a potential state in each part during operation of the imaging element of Example 1. Fig. 6A illustrates an equivalent circuit diagram for explaining each part of the imaging element of Example 1. Furthermore, Fig. 7 illustrates a schematic arrangement diagram of the first electrode and the charge accumulation electrode constituting the photoelectric conversion unit of the imaging element of Example 1. Fig. 8 illustrates a schematic perspective view of the first electrode, the charge accumulation electrode, the second electrode, and the contact hole portion. Moreover, Fig. 76 illustrates a conceptual diagram of the solid-state imaging device of Example 1.

The imaging element of Example 1 includes a photoelectric conversion unit formed by laminating a first electrode 21, a photoelectric conversion layer 23A, and a second electrode 22. Between the first electrode 21 and the photoelectric conversion layer 23A, an inorganic oxide semiconductor material layer 23B is formed. In addition, the inorganic oxide semiconductor material layer 23B contains a gallium (Ga) atom and a tin (Sn) atom (the imaging element and the like according to the first aspect of the present disclosure), or contains a gallium (Ga) atom and an indium (In) atom (the imaging element and the like according to the second aspect of the present disclosure). The inorganic oxide semiconductor material layer 23B does not contain a zinc (Zn) atom. That is, the inorganic oxide semiconductor material layer 23B is constituted by a composite oxide containing a gallium (Ga) atom and a tin (Sn) atom, and specifically constituted by a composite oxide containing a gallium oxide and a tin oxide (the imaging element and the like according to the first aspect of the present disclosure). Alternatively, the inorganic oxide semiconductor material layer 23B is constituted by a composite oxide containing a gallium (Ga) atom and an indium (In) atom, and specifically constituted by a composite oxide containing a gallium oxide and an indium oxide (the imaging element and the like according to the second aspect of the present disclosure).

The laminated imaging element of Example 1 includes at least one imaging element of Example 1. Furthermore, the solid-state imaging device of Example 1 includes a plurality of the laminated imaging elements of Example 1. In addition, for example, a digital still camera, a video camera, a camcorder, a surveillance camera, a vehicle-mounted camera, a smartphone camera, a game user interface camera, a biometric authentication camera, and the like are constituted by the solid-state imaging device of Example 1.

In addition, in the imaging element of Example 1, when the inorganic oxide semiconductor material layer is represented by $Ga_aSn_bO_c$, $a > b$ is satisfied, and

$$a + b + c = 1.00$$

and

$$0.20 < b/(a + b) < 0.40,$$

preferably

$$0.20 < b/(a + b) < 0.35$$

are satisfied (the imaging element and the like according to the first aspect of the present disclosure). Alternatively, when the inorganic oxide semiconductor material layer is represented by $Ga_dIn_eO_f$, $d > e$ is satisfied, and

$$d + e + f = 1.00$$

and

$$0.20 < e/(d + e) < 0.40$$

are satisfied (the imaging element and the like according to the second aspect of the present disclosure). Furthermore, the inorganic oxide semiconductor material layer is amorphous, and the inorganic oxide semiconductor material layer 23B has a thickness of $1 \times 10^{-8}$ m to $1.5 \times 10^{-7}$ m.

Here, in Example 1, the photoelectric conversion unit further includes an insulating layer 82 and a charge accumulation electrode 24 disposed apart from the first electrode 21 so as to face the inorganic oxide semiconductor material layer 23B via the insulating layer 82. The inorganic oxide semiconductor material layer 23B has a region which is in contact with the first electrode 21, a region which is in contact with the insulating layer 82 and below which the charge accumulation electrode 24 is not present, and a region which is in contact with the insulating layer 82 and below which the charge accumulation electrode 24 is present. In addition, light is incident from the second electrode 22, surface roughness Ra of the inorganic oxide semiconductor material layer 23B at an interface between the photoelectric conversion layer 23A and the inorganic oxide semiconductor material layer 23B is 1.5 nm or less, and a value of root mean square roughness Rq of the inorganic oxide semiconductor material layer 23B is 2.5 nm or less.

Furthermore, the LUMO value $E_1$ of a material constituting a portion of the photoelectric conversion layer 23A located near the inorganic oxide semiconductor material layer 23B and the LUMO value $E_2$ of a material constituting the inorganic oxide semiconductor material layer 23B satisfy the following formula,

$$E_2 - E_1 \geq 0.1 \ eV,$$

and
preferably satisfy

$$E_2 - E_1 > 0.1 \ eV.$$

Moreover, the material constituting the inorganic oxide semiconductor material layer 23B has a carrier mobility of 10 cm$^2$/V·s or more. Furthermore, the inorganic oxide semiconductor material layer 23B has a carrier concentration of less than $1 \times 10^{16}$/cm$^3$.

By controlling the amount of oxygen gas introduced (oxygen gas partial pressure) when the inorganic oxide semiconductor material layer 23B is formed on the basis of the sputtering method, the energy level of the inorganic oxide semiconductor material layer 23B can be controlled. The oxygen gas partial pressure is preferably 0.005 (0.5%) to 0.10 (10%).

When the film thickness of the inorganic oxide semiconductor material layer 23B is 50 nm, and the inorganic oxide semiconductor material layer 23B is constituted by $Ga_aSn_bO_c$, a result of determining a relationship between an oxygen gas partial pressure and an energy level determined from inverse photoelectron spectroscopy is illustrated in Table 1-A below. When the film thickness of the inorganic oxide semiconductor material layer 23B is 50 nm, and the inorganic oxide semiconductor material layer 23B is constituted by $Ga_dIn_eO_f$, a result of determining a relationship between an oxygen gas partial pressure and an energy level determined from inverse photoelectron spectroscopy is illustrated in Table 1-B below. In the imaging element of Example 1, by controlling the amount of oxygen gas introduced (oxygen gas partial pressure) when the inorganic oxide semiconductor material layer 23B is formed on the basis of the sputtering method, the energy level of the inorganic oxide semiconductor material layer 23B can be controlled.

$$b/(a + b) = 0.33$$

$$e/(d + e) = 0.35$$

<Table 1-A>

| Oxygen gas partial pressure | Energy level |
|---|---|
| 0.5% | 4.58 eV |
| 10.0% | 4.72 eV |

<Table 1-B>

| Oxygen gas partial pressure | Energy level |
|---|---|
| 0.5% | 4.63 eV |
| 10.0% | 4.74 eV |

Next, regarding the photoelectric conversion layer 23A and the inorganic oxide semiconductor material layer 23B, the energy level of the inorganic oxide semiconductor material layer 23B, a difference in energy level ($E_2 - E_1$) between the photoelectric conversion layer 23A and the inorganic oxide semiconductor material layer 23B, and the carrier mobility of a material constituting the inorganic oxide semiconductor material layer 23B were examined. Conditions were classified into three conditions as illustrated in Tables 2-A and 2-B. That is, under a first condition, IGZO was used as a material constituting the inorganic oxide semiconductor material layer 23B. Under second and third conditions, $Ga_aSn_bO_c$ or $Ga_dIn_eO_f$ indicated below was used as a material constituting the inorganic oxide semiconductor material layer 23B. Furthermore, the inorganic oxide semiconductor material layer 23B had a thickness of 50 nm. Moreover, the photoelectric conversion layer 23A contained quinacridone and had a thickness of 0.1 $\mu$m. Here, a LUMO value $E_1$ of a material constituting a portion of the photoelectric conversion layer 23A located near the inorganic oxide semiconductor material layer 23B was set to 4.5 eV. Note that when the inorganic oxide semiconductor material layer 23B is formed on the basis of the sputtering method, by using targets having different compositions, imaging elements and the like based on the second and third conditions can be obtained.

Second condition

$$a + b + c = 1.00$$

$$d + e + f = 1.00$$

$$b/(a + b) = 0.33$$

$$e/(d + e) = 0.35$$

Third condition

$$a + b + c = 1.00$$

$$d + e + f = 1.00$$

$$b/(a + b) = 0.28$$

$$e/(d + e) = 0.38$$

Under the first condition, the difference in energy level ($E_2 - E_1$) is 0 eV. Under the second condition, the difference in energy level ($E_2 - E_1$) is improved as compared with that under the first condition. In addition, as illustrated in Table 2-A (the imaging element and the like according to the first aspect of the present disclosure) or Table 2-B (the imaging element and the like according to the second aspect of the present disclosure), under the third condition, the carrier mobility is further improved as compared with that under the second condition.

<Table 2-A>

| | First condition | Second condition | Third condition |
|---|---|---|---|
| Inorganic oxide semiconductor material layer | 4.50 eV | 4.58 eV | 4.72 eV |
| Difference in energy level (E2-E1) | 0.0 eV | 0.08 eV | 0.22 eV |
| Mobility (unit: cm$^2$/V·s) | 9 | 12 | 17 |

<Table 2-B>

| | First condition | Second condition | Third condition |
|---|---|---|---|
| Inorganic oxide semiconductor material layer | 4.50 eV | 4.64 eV | 4.73 eV |

(continued)

| | First condition | Second condition | Third condition |
|---|---|---|---|
| Difference in energy level (E2-E1) | 0.0 eV | 0.14 eV | 0.23 eV |
| Mobility (unit: cm$^2$/V·s) | 9 | 14 | 19 |

Transfer characteristics under these three conditions were evaluated by device simulation on the basis of an imaging element having a structure illustrated in Fig. 1. Note that the LUMO value $E_1$ of the photoelectric conversion layer 23A was set to 4.5 eV. The relative amount of electrons in a state where electrons were attracted above the charge accumulation electrode 24 was set to $1 \times 10^0$. Furthermore, the relative amount of electrons in a state where all the electrons that had been attracted above the charge accumulation electrode 24 were transferred to the first electrode 21 was set to $1 \times 10^{-4}$. In addition, time until all the electrons had been attracted above the charge accumulation electrode 24 were transferred to the first electrode 21 (referred to as "transfer time") was used as an index for judging the characteristics of the transfer. A result of determining the transfer time is as illustrated in Table 3-A (the imaging element and the like according to the first aspect of the present disclosure) below or Table 3-B (the imaging element and the like according to the second aspect of the present disclosure) below. The transfer time under the second condition is shorter than that under the first condition, and the transfer time under the third condition is shorter than that under the second condition. That is, as the value of ($E_2$ - $E_1$) increases, better transfer characteristic results are indicated. This indicates that such a formation that the LUMO value $E_2$ of the inorganic oxide semiconductor material layer 23B is larger than the LUMO value $E_1$ of the photoelectric conversion layer 23A is a more preferable factor for further improving the transfer characteristics.

<Table 3-A>
| | Transfer time |
|---|---|
| First condition | $5.3 \times 10^{-6}$ seconds |
| Second condition | $1.4 \times 10^{-7}$ seconds |
| Third condition | $3.8 \times 10^{-8}$ seconds |

<Table 3-B>
| | Transfer time |
|---|---|
| First condition | $5.1 \times 10^{-6}$ seconds |
| Second condition | $1.3 \times 10^{-7}$ seconds |
| Third condition | $3.6 \times 10^{-7}$ seconds |

In order to satisfy a characteristic that there is no remaining transfer charge, required for the imaging element, transfer time of $1 \times 10^{-7}$ seconds is appropriate as transfer time when the relative amount of electrons is $1 \times 10^{-4}$. In order to satisfy this transfer time, the second condition is excellent and the third condition is better. That is, the inorganic oxide semiconductor material layer 23B is constituted by $Ga_aSn_bO_c$ or $Ga_dIn_eO_f$, satisfies a > b and d > e, and satisfies

$$a + b + c = 1.00$$

and

$$0.20 < b/(a + b) < 0.40,$$

preferably,

$$0.20 < b/(a + b) < 0.35,$$

or
satisfies

$$d + e + f = 1.00$$

and

$0.20 < e/(d + e) < 0.40$. Note that in a case where the values are outside these ranges, depletion is difficult. For example, if the content of In is too high, the carrier concentration rises. If the content of Sn is too high, oxygen deficiency control is difficult, and depletion cannot be achieved. Furthermore, if the content of Ga is too low, it is difficult to control the carrier concentration, it is necessary to set the values within these ranges, and by setting the atomic ratio of Ga in these ranges, high heat resistance can be imparted to the inorganic oxide semiconductor material layer 23B. Furthermore, as described above, the LUMO value $E_1$ of a material constituting a portion of the photoelectric conversion layer 23A located near the inorganic oxide semiconductor material layer 23B and the LUMO value $E_2$ of a material constituting the inorganic oxide semiconductor material layer 23B satisfy

$$E_2 - E_1 \geq 0.1 \text{ eV,}$$

more preferably,

$$E_2 - E_1 > 0.1 \text{ eV.}$$

Moreover, the material constituting the inorganic oxide semiconductor material layer 23B has a carrier mobility of 10 cm$^2$/V·s or more.

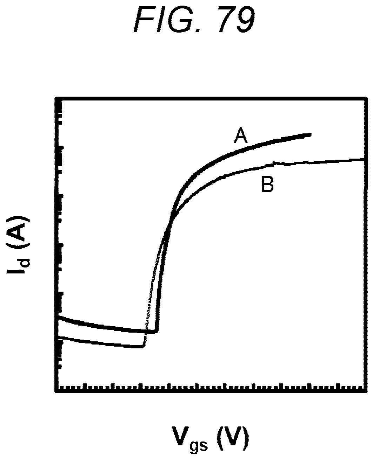

Furthermore, a result of evaluating TFT characteristics by forming a channel formation region of TFT on the basis of the inorganic oxide semiconductor material layer 23B constituted by $Ga_aSn_bO_c$ (in which b/(a + b) = 0.31) is indicated by "A" in Fig. 79 as Example 1A. In addition, a result of evaluating TFT characteristics by forming a channel formation region of TFT on the basis of the inorganic oxide semiconductor material layer 23B constituted by $Ga_aSn_bO_c$ (in which b/(a + b) = 0.75) is indicated by "B" in Fig. 79 as Comparative Example 1A. The characteristic evaluation results of Example 1A and Comparative Example 1A are illustrated in Table 4 below. From the results illustrated in Fig. 79 and Table 4, it is found that Example 1A has better TFT characteristics, and thus has better characteristics as an inorganic oxide semiconductor material than Comparative Example 1A.

<Table 4>

| | Carrier mobility | SS value |
|---|---|---|
| Example 1A | 20 cm$^2$/V·s | 0.2 V/decade |
| Comparative Example 1A | 10 cm$^2$/V·s | 0.4 V/decade |

Furthermore, from results of X-ray diffraction analysis of the inorganic oxide semiconductor material layer 23B, it has been found that the inorganic oxide semiconductor material layer 23B is amorphous (for example, amorphous without a local crystal structure). Moreover, surface roughness Ra of the inorganic oxide semiconductor material layer 23B at an interface between the photoelectric conversion layer 23A and the inorganic oxide semiconductor material layer 23B is 1.5 nm or less, and a value of root mean square roughness Rq of the inorganic oxide semiconductor material layer is 2.5 nm or less. Specifically, when the inorganic oxide semiconductor material layer 23B was constituted by $Ga_aSn_bO_c$ (in which b/(a + b) = 0.31),

$$Ra = 0.6 \text{ nm}$$

and

$$Rq = 2.5 \text{ nm}$$

were obtained. Furthermore, when the inorganic oxide semiconductor material layer 23B was constituted by $Ga_dIn_eO_f$ (in which e/(d + e) = 0.28),

$$Ra = 0.6 \text{ nm}$$

and

$$Rq = 2.5 \text{ nm}$$

were obtained. Note that surface roughness Ra of the charge accumulation electrode 24 is 1.5 nm or less, and a value of root mean square roughness Rq of the charge accumulation electrode 24 is 2.5 nm or less. Specifically,

$$Ra = 0.7 \text{ nm}$$

and

$$Rq = 2.3 \text{ nm}$$

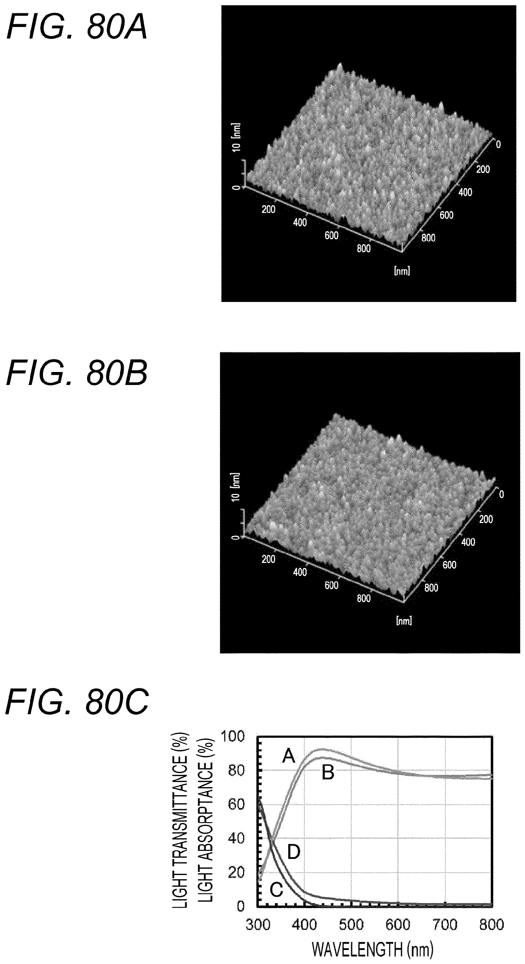

were obtained. Furthermore, Figs. 80A and 80B illustrate electron micrographs illustrating evaluation results of surface roughness in an evaluation sample in which the inorganic oxide semiconductor material layer 23B is constituted by $Ga_aSn_bO_c$ (in which $b/(a + b) = 0.31$) in Example 1. The electron micrograph in Fig. 80A was taken immediately after film formation, and the electron micrograph in Fig. 80B was taken after annealing at 350°C for 120 minutes. A value of Ra is 0.4 nm before annealing and 0.5 nm after annealing. A value of $R_{max}$ is 6 nm before annealing and 6 nm after annealing. The surface roughness of the inorganic oxide semiconductor material layer does not change after annealing as compared with that before annealing. The inorganic oxide semiconductor material layer 23B has high heat resistance. Moreover, results of measuring light absorption/transmission characteristics are illustrated in the graph of Fig. 80C. In Fig. 80C, "A" indicates the light transmittance of the inorganic oxide semiconductor material layer 23B after annealing, "B" indicates the light transmittance of the inorganic oxide semiconductor material layer 23B before annealing, "C" indicates the light absorptance of the inorganic oxide semiconductor material layer 23B after annealing, and "D" indicates the light absorptance of the inorganic oxide semiconductor material layer 23B before annealing. The light transmittance of the inorganic oxide semiconductor material layer 23B with respect to light having a wavelength of 400 nm was 5% or less. Furthermore, the light transmittance of the inorganic oxide semiconductor material layer 23B with respect to light having a wavelength of 400 nm to 660 nm is 65% or more (specifically, 81%), and the light transmittance of the charge accumulation electrode 24 with respect to light having a wavelength of 400 nm to 660 nm is also 65% or more (specifically, 73%). The charge accumulation electrode 24 has a sheet resistance value of $3 \times 10 \ \Omega/\square$ to $1 \times 10^3 \ \Omega/\square$ (specifically, 128 $\Omega/\square$).

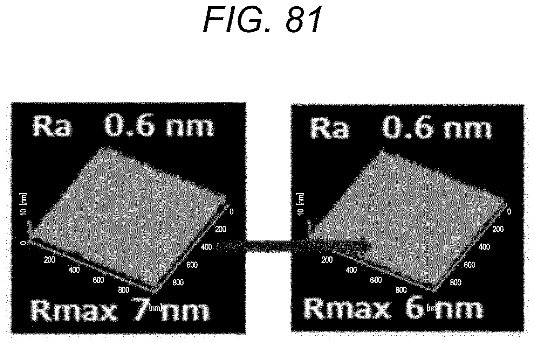

Moreover, Fig. 81 illustrates electron micrographs illustrating evaluation results of surface roughness in an evaluation sample under the second condition of [a + b + c = 1.00, b/(a + b) = 0.33]. The electron micrograph on the left of Fig. 81 was taken immediately after film formation, and the electron micrograph on the right of Fig. 81 was taken after annealing at 350°C for 120 minutes. A value of Ra is 0.6 nm before annealing and 0.6 nm after annealing. A value of $R_{max}$ is 7 nm before annealing and 6 nm after annealing. The surface roughness of the inorganic oxide semiconductor material layer hardly changes after annealing as compared with that before annealing. The inorganic oxide semiconductor material layer 23B has high heat resistance.

In the imaging element of Example 1, the inorganic oxide semiconductor material layer contains a gallium (Ga) atom and a tin (Sn) atom, or contains a gallium (Ga) atom and an indium (In) atom. Therefore, the carrier concentration of the inorganic oxide semiconductor material layer (the degree of depletion of the inorganic oxide semiconductor material layer), the carrier mobility of a material constituting the inorganic oxide semiconductor material layer, and the LUMO value $E_2$ of the material constituting the inorganic oxide semiconductor material layer can be controlled in a well-balanced manner. As a result, it is possible to provide an imaging element, a laminated imaging element, and a solid-state imaging device having excellent transfer characteristics of charges accumulated in the photoelectric conversion layer in spite of having a simple configuration and structure. That is, it is estimated that the carrier concentration of the inorganic oxide semiconductor material layer (the degree of depletion of the inorganic oxide semiconductor material layer) can be controlled by controlling the ratio of gallium atoms among atoms constituting the inorganic oxide semiconductor material layer, the carrier mobility and conductivity of the inorganic oxide semiconductor material layer can be controlled by controlling the ratio of indium atoms, and furthermore, the amorphous state, the surface smoothness, and the LUMO value $E_2$ of the inorganic oxide semiconductor material layer can be controlled by controlling the ratio of tin atoms. Moreover, high heat resistance can be imparted to the inorganic oxide semiconductor material layer. Furthermore, since the inorganic oxide semiconductor material layer contains only two types of metals, it is relatively easy to control etching when the inorganic oxide semiconductor material layer is patterned, and etching residues can be reduced. In addition, the photoelectric conversion unit has a two-layer structure of the inorganic oxide semiconductor material layer and the photoelectric conversion layer. Therefore, recombination during charge accumulation can be prevented, and transfer efficiency of charges accumulated in the photoelectric conversion layer to the first electrode can be further increased. Moreover, charges generated in the photoelectric conversion layer can be temporarily retained, the transfer timing and the like can be controlled, and generation of dark current can be suppressed.

Hereinafter, general description on the imaging elements according to the first and second aspects of the present disclosure, the laminated imaging element of the present disclosure, and the solid-state imaging device according to the second aspect of the present disclosure will be made, and then the imaging element of Example 1 and the solid-state imaging device will be described in detail.

The imaging element and the like of the present disclosure including the preferable forms described above, the imaging element and the like including a charge accumulation electrode, may be hereinafter referred to as "imaging element and the like of the present disclosure including a charge accumulation electrode" for convenience.

In the imaging element and the like of the present disclosure including a charge accumulation electrode, the inorganic oxide semiconductor material layer preferably has light transmittance of 65% or more with respect to light having a wavelength of 400 nm to 660 nm. Furthermore, the charge accumulation electrode also preferably has light transmittance of 65% or more with respect to light having a wavelength of 400 nm to 660 nm. The charge accumulation electrode preferably has a sheet resistance value of $3 \times 10 \ \Omega/\square$ to $1 \times 10^3 \ \Omega/\square$.

The imaging element and the like of the present disclosure including a charge accumulation electrode can adopt a form in which a semiconductor substrate is further included, and the photoelectric conversion unit is disposed above the semiconductor substrate. Note that the first electrode, the charge accumulation electrode, the second electrode, and the like are connected to a drive circuit described later.

The second electrode located on a light incident side may be common to a plurality of imaging elements. That is, the second electrode can be a so-called solid electrode. The photoelectric conversion layer may be common to a plurality of imaging elements. That is, one photoelectric conversion layer may be formed in the plurality of imaging elements, or may be disposed for each of the imaging elements. The inorganic oxide semiconductor material layer is preferably disposed for each of the imaging elements, but may be common to a plurality of imaging elements in some cases. That is, for example, by disposing a charge transfer control electrode described later between the imaging elements, a single inorganic oxide semiconductor material layer common to a plurality of imaging elements may be formed. In a case where a single inorganic oxide semiconductor material layer common to a plurality of imaging elements is formed, an end of the inorganic oxide semiconductor material layer is desirably covered with at least the photoelectric conversion layer from a viewpoint of protecting the end of the inorganic oxide semiconductor material layer.

Moreover, the imaging element and the like of the present disclosure including a charge accumulation electrode, including the various preferable forms described above, can adopt a form in which the first electrode extends in an opening formed in the insulating layer to be connected to the inorganic oxide semiconductor material layer. Alternatively, a form can be adopted in which the inorganic oxide semiconductor material layer extends in an opening formed in the insulating layer to be connected to the first electrode. In this case,

a form can be adopted in which an edge of a top surface of the first electrode is covered with the insulating layer, the first electrode is exposed on a bottom surface of the opening, and
when a surface of the insulating layer in contact with the top surface of the first electrode is referred to as a first surface, and a surface of the insulating layer in contact with a portion of the inorganic oxide semiconductor material layer facing the charge accumulation electrode is referred to as a second surface, a side surface of the opening has an inclination widening from the first surface toward the second surface. Moreover, a form can be adopted in which the side surface of the opening having an inclination widening from the first surface toward the second surface is located on the charge accumulation electrode side.

Moreover, the imaging element and the like of the present disclosure including a charge accumulation electrode, including the various preferable forms described above, can adopt a form in which

a control unit disposed on a semiconductor substrate and having a drive circuit is further included,
the first electrode and the charge accumulation electrode are connected to the drive circuit,
in a charge accumulation period, the drive circuit applies a potential $V_{11}$ to the first electrode and applies a potential $V_{12}$ to the charge accumulation electrode, and charges are accumulated in the inorganic oxide semiconductor material layer (or the inorganic oxide semiconductor material layer and the photoelectric conversion layer), and
in a charge transfer period, the drive circuit applies a potential $V_{21}$ to the first electrode and applies a potential $V_{22}$ to the charge accumulation electrode, and the charges accumulated in the inorganic oxide semiconductor material layer (or the inorganic oxide semiconductor material layer and the photoelectric conversion layer) are read out by the control unit via the first electrode. However, the potential of the first electrode is higher than the potential of the second electrode, and

$V_{12} \geq V_{11}$ and $V_{22} < V_{21}$ are satisfied

Moreover, the imaging element and the like of the present disclosure including a charge accumulation electrode, including the various preferable forms described above, can further include a transfer control electrode (charge transfer electrode) disposed apart from the first electrode and the charge accumulation electrode so as to face the inorganic oxide semiconductor material layer via an insulating layer between the first electrode and the charge accumulation electrode. The imaging element and the like of the present disclosure including a charge accumulation electrode, having such a form, are referred to as "imaging element and the like of the present disclosure including a transfer control electrode" for convenience.

In addition, the imaging element and the like of the present disclosure including a transfer control electrode can adopt a configuration in which

a control unit disposed on a semiconductor substrate and having a drive circuit is further included,
the first electrode, the charge accumulation electrode, and the transfer control electrode are connected to the drive circuit,
in a charge accumulation period, the drive circuit applies a potential $V_{11}$ to the first electrode, applies a potential $V_{12}$ to the charge accumulation electrode, and applies a potential $V_{13}$ to the transfer control electrode, and charges are accumulated in the inorganic oxide semiconductor material layer (or the inorganic oxide semiconductor material layer and the photoelectric conversion layer), and
in a charge transfer period, the drive circuit applies a potential $V_{21}$ to the first electrode, applies a potential $V_{22}$ to the charge accumulation electrode, and applies a potential $V_{23}$ to the transfer control electrode, and the charges accumulated in the inorganic oxide semiconductor material layer (or the inorganic oxide semiconductor material layer and the photoelectric conversion layer) are read out by the control unit via the first electrode. However, the potential of the first electrode is higher than the potential of the second electrode, and
$V_{12} > V_{13}$ and $V_{22} \leq V_{23} \leq V_{21}$ are satisfied

Moreover, the imaging element and the like of the present disclosure including a charge accumulation electrode, including the various preferable forms described above, can further include a charge discharge electrode connected to the inorganic oxide semiconductor material layer and disposed apart from the first electrode and the charge accumulation electrode. The image imaging element and the like of the present disclosure including a charge accumulation electrode, having such a form, are referred to as "imaging element and the like including the charge discharge electrode of the present disclosure" for convenience. In addition, the imaging element and the like of the present disclosure including a charge discharge electrode can adopt a form in which the charge discharge electrode is disposed so as to surround the first electrode and the charge accumulation electrode (that is, in a frame shape). The charge discharge electrode can be shared by (common to) a plurality of imaging elements. In addition, in this case,

a form can be adopted in which the inorganic oxide semiconductor material layer extends in a second opening formed in the insulating layer to be connected to the charge discharge electrode,
an edge of a top surface of the charge discharge electrode is covered with the insulating layer,
the charge discharge electrode is exposed on a bottom surface of the second opening, and
when a surface of the insulating layer in contact with the top surface of the charge discharge electrode is referred to as a third surface, and a surface of the insulating layer in contact with a portion of the inorganic oxide semiconductor material layer facing the charge accumulation electrode is referred to as a second surface, a side surface of the second opening has an inclination widening from the third surface toward the second surface.

Moreover, the imaging element and the like of the present disclosure including a charge discharge electrode can adopt a configuration in which

a control unit disposed on a semiconductor substrate and having a drive circuit is further included,
the first electrode, the charge accumulation electrode, and the charge discharge electrode are connected to the drive circuit,
in a charge accumulation period, the drive circuit applies a potential $V_{11}$ to the first electrode, applies a potential $V_{12}$ to the charge accumulation electrode, and applies a potential $V_{14}$ to the charge discharge electrode, and charges are accumulated in the inorganic oxide semiconductor material layer (or the inorganic oxide semiconductor material layer and the photoelectric conversion layer), and

in a charge transfer period, the drive circuit applies a potential $V_{21}$ to the first electrode, applies a potential $V_{22}$ to the charge accumulation electrode, and applies a potential $V_{24}$ to the charge discharge electrode, and the charges accumulated in the inorganic oxide semiconductor material layer (or the inorganic oxide semiconductor material layer and the photoelectric conversion layer) are read out by the control unit via the first electrode. However, the potential of the first electrode is higher than the potential of the second electrode, and

$V_{14} > V_{11}$ and $V_{24} < V_{21}$ are satisfied

Moreover, in the various preferable forms described above in the imaging element and the like of the present disclosure including a charge accumulation electrode, the charge accumulation electrode can include a plurality of charge accumulation electrode segments. The imaging element and the like of the present disclosure including a charge accumulation electrode, having such a form, are referred to as "imaging element and the like of the present disclosure including a plurality of charge accumulation electrode segments" for convenience. The number of charge accumulation electrode segments only needs to be two or more. In addition, the imaging element and the like of the present disclosure including a plurality of charge accumulation electrode segments can adopt a form in which,

in a case where different potentials are applied to N charge accumulation electrode segments,
in a case where the potential of the first electrode is higher than that of the second electrode, in a charge transfer period, a potential applied to a charge accumulation electrode segment located closest to the first electrode (first photoelectric conversion unit segment) is higher than a potential applied to a charge accumulation electrode segment located farthest from the first electrode (N-th photoelectric conversion unit segment), and
in a case where the potential of the first electrode is lower than that of the second electrode, in the charge transfer period, the potential applied to the charge accumulation electrode segment located closest to the first electrode (first photoelectric conversion unit segment) is lower than the potential applied to the charge accumulation electrode segment located farthest from the first electrode (N-th photoelectric conversion unit segment).

The imaging element and the like of the present disclosure including a charge accumulation electrode, including the various preferable forms described above, can adopt a configuration in which

on the semiconductor substrate, at least a floating diffusion layer and an amplification transistor constituting a control unit are disposed, and
the first electrode is connected to the floating diffusion layer and a gate portion of the amplification transistor. In addition, in this case, moreover,
a configuration can be adopted in which
on the semiconductor substrate, a reset transistor and a selection transistor constituting the control unit are further disposed,
the floating diffusion layer is connected to one source/drain region of the reset transistor, and
one source/drain region of the amplification transistor is connected to one source/drain region of the selection transistor, and the other source/drain region of the selection transistor is connected to a signal line.

Moreover, the imaging element and the like of the present disclosure including a charge accumulation electrode, including the various preferable forms described above, can adopt a form in which the charge accumulation electrode is larger than the first electrode. When the area of the charge accumulation electrode is represented by $S_1'$, and the area of the first electrode is represented by $S_1$,

$$4 \leq S_1'/S_1$$

is preferably satisfied although not limited.

Alternatively, examples of a modification of the imaging element and the like of the present disclosure including the various preferable forms described above include imaging elements of first to sixth configurations described below. That is, in each of the imaging elements of the first to sixth configurations in the imaging element and the like of the present disclosure including the various preferable forms described above,

the photoelectric conversion unit includes N (where $N \geq 2$) photoelectric conversion unit segments,
the inorganic oxide semiconductor material layer and the photoelectric conversion layer include N photoelectric conversion layer segments,
the insulating layer includes N insulating layer segments,

in each of the imaging elements of the first to third configurations, the charge accumulation electrode includes N charge accumulation electrode segments,

in each of the imaging elements of the fourth and fifth configurations, the charge accumulation electrode includes N charge accumulation electrode segments disposed apart from one another,

the n-th (where n = 1, 2, 3... N) photoelectric conversion unit segment includes the n-th charge accumulation electrode segment, the n-th insulating layer segment, and the n-th photoelectric conversion layer segment, and a photoelectric conversion unit segment with a larger value of n is located farther from the first electrode. Here, the "photoelectric conversion layer segment" refers to a segment formed by laminating the photoelectric conversion layer and the inorganic oxide semiconductor material layer.

In addition, in the imaging element of the first configuration, the thickness of an insulating layer segment gradually changes from the first photoelectric conversion unit segment to the N-th photoelectric conversion unit segment. Furthermore, in the imaging element of the second configuration, the thickness of a photoelectric conversion layer segment gradually changes from the first photoelectric conversion unit segment to the N-th photoelectric conversion unit segment. Note that in a photoelectric conversion layer segment, the thickness of the photoelectric conversion layer segment may be changed by changing the thickness of the photoelectric conversion layer portion and keeping the thickness of the inorganic oxide semiconductor material layer portion constant. Furthermore, the thickness of the photoelectric conversion layer segment may be changed by keeping the thickness of the photoelectric conversion layer portion constant and changing the thickness of the inorganic oxide semiconductor material layer portion. Furthermore, the thickness of the photoelectric conversion layer segment may be changed by changing the thickness of the photoelectric conversion layer portion and changing the thickness of the inorganic oxide semiconductor material layer portion. Moreover, in the imaging element of the third configuration, materials constituting an insulating layer segment are different between adjacent photoelectric conversion unit segments. Furthermore, in the imaging element of the fourth configuration, materials constituting a charge accumulation electrode segment are different between adjacent photoelectric conversion unit segments. Moreover, in the imaging element of the fifth configuration, the area of a charge accumulation electrode segment is gradually reduced from the first photoelectric conversion unit segment to the N-th photoelectric conversion unit segment. The area may be reduced continuously or stepwise.

Alternatively, in the imaging element of the sixth configuration in the imaging element and the like of the present disclosure including the various preferable forms described above, if a lamination direction of the charge accumulation electrode, the insulating layer, the inorganic oxide semiconductor material layer, and the photoelectric conversion layer is defined as a Z direction, and a direction of separating from the first electrode is defined as an X direction, when a laminated portion where the charge accumulation electrode, the insulating layer, the inorganic oxide semiconductor material layer, and the photoelectric conversion layer are laminated is cut with a YZ virtual plane, the cross-sectional area of the laminated portion changes depending on a distance from the first electrode. The change in the cross-sectional area may be a continuous change or a step-like change.

In each of the imaging elements of the first and second configurations, the N photoelectric conversion layer segments are disposed continuously, the N insulating layer segments are also disposed continuously, and the N charge accumulation electrode segments are also disposed continuously. In each of the imaging elements of the third and fifth configurations, the N photoelectric conversion layer segments are disposed continuously. Furthermore, in each of the imaging elements of the fourth and fifth configurations, the N insulating layer segments are disposed continuously. Meanwhile, in the imaging element of the third configuration, the N insulating layer segments are disposed so as to correspond to the respective photoelectric conversion unit segments. Moreover, in each of the imaging elements of the fourth and fifth configurations, and in some cases, in the imaging element of the third configuration, the N charge accumulation electrode segments are disposed so as to correspond to the respective photoelectric conversion unit segments. In addition, in each of the imaging elements of the first to sixth configurations, the same potential is applied to all the charge accumulation electrode segments. Alternatively, in each of the imaging elements of the fourth and fifth configurations, and in some cases, in the imaging element of the third configuration, different potentials may be applied to the N charge accumulation electrode segments.

In the imaging element and the like of the present disclosure including the imaging elements of the first to sixth configurations, the thickness of an insulating layer segment is defined, or the thickness of a photoelectric conversion layer segment is defined, or the materials constituting the insulating layer segments are different, or the materials constituting the charge accumulation electrode segments are different, or the area of the charge accumulation electrode segment is defined, or the cross-sectional area of the laminated portion is defined. Therefore, a kind of charge transfer gradient is formed, and charges generated by photoelectric conversion can be transferred to the first electrode more easily and reliably. In addition, as a result, it is possible to prevent generation of afterimages and charge transfer residuals.

In each of the imaging elements of the first to fifth configurations, a photoelectric conversion unit segment with a larger value of n is located farther from the first electrode, but it is determined on the basis of the X direction whether or not a photoelectric conversion unit segment is located apart from the first electrode. Furthermore, in the imaging element of the sixth configuration, the direction of separating from the first electrode is defined as the X direction, and the "X direction" is defined as follows. That is, a pixel region in which a plurality of imaging elements or laminated imaging elements is arrayed includes a plurality of pixels regularly arrayed two-dimensionally, that is, in the X and Y directions. In a case where the planar shape of the pixel is rectangular, a direction in which a side closest to the first electrode extends is defined as the Y direction, and a direction orthogonal to the Y direction is defined as the X direction. Alternatively, in a case where the planar shape of the pixel is an arbitrary shape, the overall direction including a line segment or a curve closest to the first electrode is defined as the Y direction, and a direction orthogonal to the Y direction is defined as the X direction.

Hereinafter, regarding the imaging elements of the first to sixth configurations, a case where the potential of the first electrode is higher than that of the second electrode will be described.

In the imaging element of the first configuration, the thickness of an insulating layer segment gradually changes from the first photoelectric conversion unit segment to the N-th photoelectric conversion unit segment. However, the thickness of an insulating layer segment preferably increases gradually, thereby forming a kind of charge transfer gradient. Then, when a state of $|V_{12}| \geq |V_{11}|$ is reached in a charge accumulation period, the n-th photoelectric conversion unit segment can accumulate more charges than the (n + 1)-th photoelectric conversion unit segment, a stronger electric field is applied to the n-th photoelectric conversion unit segment than to the (n + 1)-th photoelectric conversion unit segment, and a flow of charges from the first photoelectric conversion unit segment to the first electrode can be reliably prevented. Furthermore, when a state of $|V_{22}| < |V_{21}|$ is reached in a charge transfer period, a flow of charges from the first photoelectric conversion unit segment to the first electrode, and a flow of charges from the (n + 1)-th photoelectric conversion unit segment to the n-th photoelectric conversion unit segment can be reliably ensured.

In the imaging element of the second configuration, the thickness of a photoelectric conversion layer segment gradually changes from the first photoelectric conversion unit segment to the N-th photoelectric conversion unit segment. However, the thickness of a photoelectric conversion layer segment preferably increases gradually, thereby forming a kind of charge transfer gradient. Then, when a state of $V_{12} \geq V_{11}$ is reached in a charge accumulation period, a stronger electric field is applied to the n-th photoelectric conversion unit segment than to the (n + 1)-th photoelectric conversion unit segment, and a flow of charges from the first photoelectric conversion unit segment to the first electrode can be reliably prevented. Furthermore, when a state of $V_{22} < V_{21}$ is reached in a charge transfer period, a flow of charges from the first photoelectric conversion unit segment to the first electrode, and a flow of charges from the (n + 1)-th photoelectric conversion unit segment to the n-th photoelectric conversion unit segment can be reliably ensured.

In the imaging element of the third configuration, materials constituting an insulating layer segment are different between adjacent photoelectric conversion unit segments, and this forms a kind of charge transfer gradient. A value of the relative dielectric constant of a material constituting an insulating layer segment preferably decreases gradually from the first photoelectric conversion unit segment to the N-th photoelectric conversion unit segment. Then, by adopting such a configuration, in a charge accumulation period, when a state of $V_{12} \geq V_{11}$ is reached, the n-th photoelectric conversion unit segment can accumulate more charges than the (n + 1)-th photoelectric conversion unit segment. Furthermore, when a state of $V_{22} < V_{21}$ is reached in a charge transfer period, a flow of charges from the first photoelectric conversion unit segment to the first electrode, and a flow of charges from the (n + 1)-th photoelectric conversion unit segment to the n-th photoelectric conversion unit segment can be reliably ensured.

In the imaging element of the fourth configuration, materials constituting a charge accumulation electrode segment are different between adjacent photoelectric conversion unit segments, and this forms a kind of charge transfer gradient. A value of the work function of a material constituting an insulating layer segment preferably increases gradually from the first photoelectric conversion unit segment to the N-th photoelectric conversion unit segment. In addition, by adopting such a configuration, a potential gradient which is advantageous for signal charge transfer can be formed without depending on whether the voltage (potential) is positive or negative.

In the imaging element of the fifth configuration, the area of a charge accumulation electrode segment is gradually reduced from the first photoelectric conversion unit segment to the N-th photoelectric conversion unit segment, and this forms a kind of charge transfer gradient. Therefore, when a state of $V_{12} \geq V_{11}$ is reached in a charge accumulation period, the n-th photoelectric conversion unit segment can accumulate more charges than the (n + 1)-th photoelectric conversion unit segment. Furthermore, when a state of $V_{22} < V_{21}$ is reached in a charge transfer period, a flow of charges from the first photoelectric conversion unit segment to the first electrode, and a flow of charges from the (n + 1)-th photoelectric conversion unit segment to the n-th photoelectric conversion unit segment can be reliably ensured.

In the imaging element of the sixth configuration, the cross-sectional area of the laminated portion changes depending on a distance from the first electrode, and this forms a kind of charge transfer gradient. Specifically, by adopting a configuration in which the thickness of the cross section of the laminated portion is constant and the width of the cross section of the laminated portion becomes narrower as the laminated portion goes away from the first electrode, as described in the imaging element of the fifth configuration, when a state of $V_{12} \geq V_{11}$ is reached in a charge accumulation period, a region close to the first electrode can accumulate more charges than a region far from the first electrode. Therefore, when a state of $V_{22} < V_{21}$ is reached in a charge transfer period, a flow of charges from a region close to the first electrode to the first electrode and a flow of charges from a region far from the first electrode to a region close to the first electrode can be reliably ensured. Meanwhile, by adopting a configuration in which the width of the cross section of the laminated portion is constant, and the thickness of the cross section of the laminated portion, specifically, the thickness of an insulating layer segment gradually increases, as described in the imaging element of the first configuration, when a state of $V_{12} \geq V_{11}$ is reached in a charge accumulation period, a region close to the first electrode can accumulate more charges than a region far from the first electrode, a stronger electric field is applied to the region close to the first electrode than to the region far from the first electrode, and a flow of charges from the region close to the first electrode to the first electrode can be reliably prevented. Then, when a state of $V_{22} < V_{21}$ is reached in a charge transfer period, a flow of charges from a region close to the first electrode to the first electrode and a flow of charges from a region far from the first electrode to a region close to the first electrode can be reliably ensured. Furthermore, by adopting a configuration in which the thickness of the photoelectric conversion layer segment gradually increases, as described in the imaging element of the second configuration, when a state of $V_{12} \geq V_{11}$ is reached in a charge accumulation period, a stronger electric field is applied to the region close to the first electrode than to the region far from the first electrode, and a flow of charges from the region close to the first electrode to the first electrode can be reliably prevented. Then, when a state of $V_{22} < V_{21}$ is reached in a charge transfer period, a flow of charges from a region close to the first electrode to the first electrode and a flow of charges from a region far from the first electrode to a region close to the first electrode can be reliably ensured.

A modification of the solid-state imaging devices according to the first and second aspects of the present disclosure can be

a solid-state imaging device including a plurality of the imaging elements of the first to sixth configurations, in which the plurality of imaging elements constitutes an imaging element block, and
the first electrode is shared by the plurality of imaging elements constituting the imaging element block. A solid-state imaging device having such a configuration is referred to as "solid-state imaging device of first configuration" for convenience. Alternatively, a modification of the solid-state imaging devices according to the first and second aspects of the present disclosure can be,
a solid-state imaging device including a plurality of the imaging elements of the first to sixth configurations or a plurality of laminated imaging elements each including at least one of the imaging elements of the first to sixth configurations,
the plurality of imaging elements or laminated imaging elements constitutes an imaging element block, and
the first electrode is shared by the plurality of imaging elements or laminated imaging elements constituting the imaging element block. A solid-state imaging device having such a configuration is referred to as "solid-state imaging device of second configuration" for convenience. In addition, if the first electrode is shared by the plurality of imaging elements constituting the imaging element block in this way, the configuration and structure in a pixel region in which a plurality of imaging elements is arrayed can be simplified and miniaturized.

In each of the solid-state imaging devices of the first and second configurations, one floating diffusion layer is disposed for a plurality of imaging elements (one imaging element block). Here, the plurality of imaging elements disposed for one floating diffusion layer may be constituted by a plurality of first type imaging elements described later, or may be constituted by at least one first type imaging element and one or more second type imaging elements described later. In addition, by appropriately controlling the timing of a charge transfer period, the plurality of imaging elements can share one floating diffusion layer. The plurality of imaging elements is operated in cooperation and connected as an imaging element block to a drive circuit described later. That is, the plurality of imaging elements constituting the imaging element block is connected to one drive circuit. However, the charge accumulation electrode is controlled for each of the imaging elements. Furthermore, the plurality of imaging elements can share one contact hole portion. As for an arrangement relationship between the first electrode shared by the plurality of imaging elements and the charge accumulation electrodes of the imaging elements, there is also a case where the first electrode is disposed adjacent to the charge accumulation electrodes of the imaging elements. Alternatively, there is also a case where the first electrode is disposed adjacent to some of the charge accumulation electrodes of the plurality of imaging elements, and is not disposed adjacent to the remaining charge accumulation electrodes of the plurality of imaging elements. In this case, transfer of charges from the rest of the plurality of imaging elements to the first electrode is transfer via some of the plurality of imaging elements. A distance between a charge accumulation electrode constituting an imaging element and a charge accumulation electrode constituting an imaging element (referred to as "distance A" for convenience) is preferably longer than a distance between a first electrode and a charge accumulation electrode in an imaging element adjacent to the first electrode (referred to as "distance B" for convenience) in order to ensure transfer of charges from each of the imaging elements to the first electrode. Furthermore, a value of the distance A is preferably longer as an imaging element is located farther from the first electrode. Note that the above description can be applied not only to the solid-state imaging devices of the first and second configurations but also to the solid-state imaging devices according to the first and second aspects of the present disclosure.

Moreover, the imaging element and the like of the present disclosure including the various preferable forms described above can adopt a form in which light is incident from the second electrode side, and a light shielding layer is formed on the light incident side of the second electrode. Alternatively, a form can be adopted in which light is incident from the second electrode side, and light is not incident on the first electrode (in some cases, the first electrode and the transfer control electrode). In addition, in this case, a configuration can be adopted in which a light shielding layer is formed above the first electrode (in some cases, the first electrode and the transfer control electrode) on the light incident side of the second electrode. Alternatively, a configuration can be adopted in which an on-chip micro lens is disposed above the charge accumulation electrode and the second electrode, and light incident on the on-chip micro lens is collected by the charge accumulation electrode. Here, the light shielding layer may be disposed above the light incident side surface of the second electrode, or may be disposed on the light incident side surface of the second electrode. In some cases, a light shielding layer may be formed in the second electrode. Examples of a material constituting the light shielding layer include chromium (Cr), copper (Cu), aluminum (Al), tungsten (W), and a resin that does not transmit light (for example, polyimide resin).

Specific examples of the imaging element and the like of the present disclosure include: an imaging element including a photoelectric conversion layer or a photoelectric conversion unit that absorbs blue light (light of 425 nm to 495 nm) (referred to as "first type blue light photoelectric conversion layer" or "first type blue light photoelectric conversion unit" for convenience) and sensitive to blue light (referred to as "first type blue light imaging element" for convenience); an imaging element including a photoelectric conversion layer or a photoelectric conversion unit that absorbs green light (light of 495 nm to 570 nm) (referred to as "first type green light photoelectric conversion layer" or "first type green light photoelectric conversion unit" for convenience) and sensitive to green light (referred to as "first type green light imaging element" for convenience); and an imaging element including a photoelectric conversion layer or a photoelectric conversion unit that absorbs red light (light of 620 nm to 750 nm) (referred to as "first type red light photoelectric conversion layer" or "first type red light photoelectric conversion unit" for convenience) and sensitive to red light (referred to as "first type red light imaging element" for convenience). Furthermore, a conventional imaging element not including a charge accumulation electrode and sensitive to blue light is referred to as "second type blue light imaging element" for convenience, a conventional imaging element not including a charge accumulation electrode and sensitive to green light is referred to as "second type green light imaging element" for convenience, a conventional imaging element not including a charge accumulation electrode and sensitive to red light is referred to as "second type red light imaging element" for convenience, a photoelectric conversion layer or a photoelectric conversion unit constituting the second type blue light imaging element is referred to as "second type blue light photoelectric conversion layer" or "second type blue light photoelectric conversion unit" for convenience, a photoelectric conversion layer or a photoelectric conversion unit constituting the second type green light imaging element is referred to as "second type green light photoelectric conversion layer" or "second type green light photoelectric conversion unit" for convenience, and a photoelectric conversion layer or a photoelectric conversion unit constituting the second type red light imaging element is referred to as "second type red light photoelectric conversion layer" or "second type red light photoelectric conversion unit" for convenience.

Specific examples of the laminated imaging element including a charge accumulation electrode include:

[A] a configuration and a structure in which the first type blue light photoelectric conversion unit, the first type green light photoelectric conversion unit, and the first type red light photoelectric conversion unit are laminated in the vertical direction, and
the control units of the first type blue light imaging element, the first type green light imaging element, and the first type red light imaging element are disposed on a semiconductor substrate;
[B] a configuration and a structure in which the first type blue light photoelectric conversion unit and the first type green light photoelectric conversion unit are laminated in the vertical direction,

the second type red light photoelectric conversion unit is disposed below the two first type photoelectric conversion units, and
the control units of the first type blue light imaging element, the first type green light imaging element, and the second type red light imaging element are disposed on a semiconductor substrate;

[C] a configuration and a structure in which the second type blue light photoelectric conversion unit and the second type red light photoelectric conversion unit are disposed below the first type green light photoelectric conversion unit, and
the control units of the first type green light imaging element, the second type blue light imaging element, and the second type red light imaging element are disposed on a semiconductor substrate; and
[D] a configuration and a structure in which the second type green light photoelectric conversion unit and the second type red light photoelectric conversion unit are disposed below the first type blue light photoelectric conversion unit, and

the control units of the first type blue light imaging element, the second type green light imaging element, and the second type red light imaging element are disposed on a semiconductor substrate. The photoelectric conversion units of these imaging elements are preferably disposed in the vertical direction in order of the blue light photoelectric conversion unit, the green light photoelectric conversion unit, and the red light photoelectric conversion unit from the light incident direction, or in order of the green light photoelectric conversion unit, the blue light photoelectric conversion unit, and the red light photoelectric conversion unit from the light incident direction. This is because light having a shorter wavelength is more efficiently absorbed on an incident surface side. Since red has the longest wavelength among the three colors, the red light photoelectric conversion unit is preferably located in the lowermost layer as viewed from the light incident surface. A laminated structure of these imaging elements constitutes one pixel. Furthermore, a first type near-infrared photoelectric conversion unit (or an infrared photoelectric conversion unit) may be included. Here, preferably, the photoelectric conversion layer of the first type infrared photoelectric conversion unit includes, for example, an organic material, and is disposed as the lowermost layer of the laminated structure of the first type imaging elements above the second type imaging element. Alternatively, a second type near-infrared photoelectric conversion unit (or an infrared photoelectric conversion unit) may be disposed below the first type photoelectric conversion unit.

In the first type imaging element, for example, the first electrode is formed on an interlayer insulating layer disposed on a semiconductor substrate. An imaging element formed on a semiconductor substrate can be a backside irradiation type or a frontside irradiation type.

In a case where the photoelectric conversion layer includes an organic material, the photoelectric conversion layer can have any one of the following four forms.

(1) The photoelectric conversion layer is constituted by a p-type organic semiconductor. (2) The photoelectric conversion layer is constituted by an n-type organic semiconductor. (3) The photoelectric conversion layer is constituted by a laminated structure of p-type organic semiconductor layer/n-type organic semiconductor layer. The photoelectric conversion layer is constituted by a laminated structure of p-type organic semiconductor layer/mixed layer (bulk heterostructure) of p-type organic semiconductor and n-type organic semiconductor/n-type organic semiconductor layer. The photoelectric conversion layer is constituted by a laminated structure of a mixed layer (bulk heterostructure) of a p-type organic semiconductor layer/p-type organic semiconductor and an n-type organic semiconductor. The photoelectric conversion layer is constituted by a laminated structure of a mixed layer (bulk heterostructure) of an n-type organic semiconductor layer/p-type organic semiconductor and an n-type organic semiconductor.

(4) The photoelectric conversion layer is constituted by a mixture (bulk heterostructure) of a p-type organic semiconductor and an n-type organic semiconductor.

However, the laminating order can be arbitrarily exchanged.

Examples of the p-type organic semiconductor include a naphthalene derivative, an anthracene derivative, a phenanthrene derivative, a pyrene derivative, a perylene derivative, a tetracene derivative, a pentacene derivative, a quinacridone derivative, a thiophene derivative, a thienothiophene derivative, a benzothiophene derivative, a benzothienobenzothiophene derivative, a triallylamine derivative, a carbazole derivative, a perylene derivative, a picene derivative, a chrysene derivative, a fluoranthene derivative, a phthalocyanine derivative, a subphthalocyanine derivative, a subporphyrazine derivative, a metal complex having a heterocyclic compound as a ligand, a polythiophene derivative, a polybenzothiadiazole derivative, a polyfluorene derivative, and the like. Examples of the n-type organic semiconductor include a fullerene and a fullerene derivative <for example, C60, a fullerene such as C70 or C74 (higher fullerene), an endohedral fullerene, or the like), or a fullerene derivative (for example, a fullerene fluoride, a PCBM fullerene compound, a fullerene multimer, or the like)>, an organic semiconductor with larger (deeper) HOMO and LUMO than a p-type organic semiconductor, and a transparent inorganic metal oxide. Specific examples of the n-type organic semiconductor include a heterocyclic compound containing a nitrogen atom, an oxygen atom, or a sulfur atom. Examples thereof include an organic molecule and an organic metal complex containing a pyridine derivative, a pyrazine derivative, a pyrimidine derivative, a triazine derivative, a quinoline derivative, a quinoxaline derivative, an isoquinoline derivative, an acridine derivative, a phenazine derivative, a phenanthroline derivative, a tetrazole derivative, a pyrazole derivative, an imidazole derivative, a thiazole derivative, an oxazole derivative, an imidazole derivative, a benzimidazole derivative, a benzotriazole derivative, a benzoxazole derivative, a benzoxazole derivative, a carbazole derivative, a benzofuran derivative, a dibenzofuran derivative, a subporphyrazine derivative, a polyphenylenevinylene derivative, a polybenzothiadiazole derivative, a polyfluorene derivative, and the like in a part of a molecular skeleton thereof, and a subphthalocyanine derivative. Examples of a group and the like contained in the fullerene derivative include: a halogen atom; a linear, branched, or cyclic alkyl group or phenyl group; a group having a linear or condensed aromatic compound; a group having a halide; a partial fluoroalkyl group; a perfluoroalkyl group; a silylalkyl group; a silylalkoxy group; an arylsilyl group; an arylsulfanyl group; an alkylsulfanyl group; an arylsulfonyl group; an alkylsulfonyl group; an arylsulfide group; an alkylsulfide group; an amino group; an alkylamino group; an arylamino group; a hydroxy group; an alkoxy group; an acylamino group; an acyloxy group; a carbonyl group; a carboxy group; a carboxamide group; a carboalkoxy group; an acyl group; a sulfonyl group; a cyano group; a nitro group; a group having a chalcogenide; a phosphine group; a phosphone group, and derivatives thereof. The thickness of the photoelectric conversion layer including an organic material (also referred as "organic photoelectric conversion layer") is not limited, but is for example, $1 \times 10^{-8}$ m to $5 \times 10^{-7}$ m, preferably $2.5 \times 10^{-8}$ m to $3 \times 10^{-7}$ m, more preferably $2.5 \times 10^{-8}$ m to $2 \times 10^{-7}$ m, and still more preferably $1 \times 10^{-7}$ m to $1.8 \times 10^{-7}$ m. Note that the organic semiconductor is often classified into a p-type and an n-type. The p-type means that holes are easily transported, and the n-type means that electrons are easily transported without being limited to interpretation that the organic semiconductor has holes or electrons as many thermally-excited carriers like an inorganic semiconductor.

Alternatively, examples of a material constituting the organic photoelectric conversion layer that photoelectrically converts green light include a rhodamine-based dye, a melacyanine-based dye, a quinacridone derivative, a subphthalocyanine dye (subphthalocyanine derivative), and the like. Examples of a material constituting the organic photoelectric conversion layer that photoelectrically converts blue light include a coumarinic acid dye, tris-8-hydryxyquinolialuminium (Alq3), a melacyanine-based dye, and the like. Examples of a material constituting the organic photoelectric conversion layer that photoelectrically converts red light include a phthalocyanine-based dye and a subphthalocyanine-based dye (subphthalocyanine derivative).

Alternatively, examples of the inorganic material constituting the photoelectric conversion layer include crystalline silicon, amorphous silicon, microcrystalline silicon, crystalline selenium, amorphous selenium, a chalcopyrite compound such as CIGS(CuInGaSe), CIS(CuInSe$_2$), CuInS$_2$, CuAlS$_2$, CuAlSe$_2$, CuGaS$_2$, CuGaSe$_2$, AgAlS$_2$, AgAlSe$_2$, AgInS$_2$, or AgInSe$_2$, and a group III-V compound such as GaAs, InP, AlGaAs, InGaP, AlGaInP, or InGaAsP, and further include a compound semiconductor such as CdSe, CdS, In$_2$Se$_3$, In$_2$S$_3$, Bi$_2$Se$_3$, Bi$_2$S$_3$, ZnSe, ZnS, PbSe, or PbS. In addition, quantum dots including these materials can also be used for the photoelectric conversion layer.

A single-plate color solid-state imaging device can be constituted by each of the solid-state imaging devices according to the first and second aspects of the present disclosure and the solid-state imaging devices of the first and second configurations.

In the solid-state imaging device including a laminated imaging element according to the second aspect of the present disclosure, unlike a solid-state imaging device including Bayer-array imaging elements (that is, spectroscopy of blue, green, and red light is not performed using a color filter layer), one pixel is constituted by laminating imaging elements sensitive to light having a plurality of wavelengths in a light incident direction within the same pixel, and therefore it is possible to improve sensitivity and a pixel density per unit volume. Furthermore, an organic material has a high absorption coefficient. Therefore, the film thickness of the organic photoelectric conversion layer can be thinner than that of a conventional Si-based photoelectric conversion layer, and restriction on leakage of light from an adjacent pixel and an incident angle of light is alleviated. Moreover, in the conventional Si-based imaging element, a false color is generated because interpolation processing is performed among pixels of three colors to generate a color signal. However, the solid-state imaging device including a laminated imaging element according to the second aspect of the present disclosure can suppress generation of a false color. The organic photoelectric conversion layer itself also acts as a color filter layer. Therefore, color separation can be performed even without disposing the color filter layer.

Meanwhile, in the solid-state imaging device according to the first aspect of the present disclosure, use of a color filter layer can alleviate demands on the spectral characteristics of blue, green, and red light, and a mass production property is high. Examples of an array of imaging elements in the solid-state imaging device according to the first aspect of the present disclosure include a Bayer array, an interline array, a G stripe RB checkered array, a G stripe RB complete checkered array, a checkered complementary color array, a stripe array, a diagonal stripe array, a primary color chrominance array, a field chrominance sequential array, a frame chrominance sequential array, a MOS-type array, an improved MOS-type array, a frame interleaved array, and a field interleaved array. Here, one imaging element constitutes one pixel (or sub-pixel).

Examples of the color filter layer (wavelength selection means) include a filter layer that transmits not only red, green, and blue light but also light having a specific wavelength, such as cyan, magenta, or yellow light in some cases. The color filter layer can be constituted not only by an organic material-based color filter layer using an organic compound such as a pigment or a dye but also by a thin film containing an inorganic material such as a photonic crystal, a wavelength selection element that applies a plasmon (color filter layer having a conductor lattice structure with a lattice-like hole structure in a conductive thin film, for example, see Japanese Patent Application Laid-Open No. 2008-177191), or amorphous silicon.

A pixel region in which a plurality of imaging elements and the like of the present disclosure is arrayed includes a plurality of pixels regularly arrayed two-dimensionally. The pixel region usually includes an effective pixel region that actually receives light, amplifies signal charges generated by photoelectric conversion, and reads out the signal charges to a drive circuit, and a black reference pixel region that outputs optical black serving as a black level reference (also referred to as an optical black pixel region (OPB)). The black reference pixel region is usually disposed on an outer periphery of an effective pixel region.

The imaging element and the like of the present disclosure including the various preferable forms described above are irradiated with light, photoelectric conversion occurs in the photoelectric conversion layer, and holes and electrons are carrier-separated. In addition, an electrode from which holes are extracted is referred to as a positive electrode, and an electrode from which electrons are extracted is referred to as a negative electrode. The first electrode constitutes the negative electrode, and the second electrode constitutes the positive electrode.

The first electrode, the charge accumulation electrode, the transfer control electrode, the charge discharge electrode, and the second electrode can each contain a transparent conductive material. The first electrode, the charge accumulation electrode, the transfer control electrode, and the charge discharge electrode may be collectively referred to as "first electrode and the like". Alternatively, in a case where the imaging elements and the like of the present disclosure are disposed in a plane like a Bayer array, for example, the second electrode can contain a transparent conductive material, and the first electrode and the like can contain a metal material. In this case, specifically, the second electrode located on the light incident side can contain a transparent conductive material, and the first electrode and the like can contain, for example, Al-Nd (alloy of aluminum and neodymium) or ASC (alloy of aluminum, samarium, and copper). An electrode containing a transparent conductive material may be referred to as "transparent electrode". Here, the band gap energy of the transparent conductive material is 2.5 eV or more, and preferably 3.1 eV or more. Examples of the transparent conductive material constituting the transparent electrode include a conductive metal oxide. Specific examples thereof include indium oxide, indium-tin oxide (ITO, including Sn-doped $In_2O_3$, crystalline ITO, and amorphous ITO), indium-zinc oxide (IZO) obtained by adding indium as a dopant to zinc oxide, indium-gallium-zinc oxide (IGZO, In-GaZnO$_4$) obtained by adding indium and gallium as a dopant to zinc oxide, indium-tin-zinc oxide (ITZO) obtained by adding indium and tin as a dopant to zinc oxide, IFO (F-doped $In_2O_3$), tin oxide ($SnO_2$), ATO (Sb-doped $SnO_2$), FTO (F-doped $SnO_2$), zinc oxide (including ZnO doped with another element), aluminum-zinc oxide (AZO) to which aluminum is added to zinc oxide as a dopant, gallium-zinc oxide (GZO) to which gallium is added to zinc oxide as a dopant, titanium oxide ($TiO_2$), niobium-titanium oxide (TNO) to which niobium is added to titanium oxide as a dopant, antimony oxide, CuI, $InSbO_4$, ZnMgO, $CuInO_2$, $MgIn_2O_4$, CdO, $ZnSnO_3$, a spinel type oxide, and an oxide having a $YbFe_2O_4$ structure. Alternatively, examples of the transparent electrode include a transparent electrode containing gallium oxide, titanium oxide, niobium oxide, nickel oxide, and the like as a base layer. The thickness of the transparent electrode may be $2 \times 10^{-8}$ m to $2 \times 10^{-7}$ m, and preferably $3 \times 10^{-8}$ m to $1 \times 10^{-7}$ m. In a case where the first electrode needs to be transparent, the charge discharge electrode also preferably contains a transparent conductive material from a viewpoint of simplifying a manufacturing process.

Alternatively, in a case where transparency is not required, as a conductive material constituting a negative electrode functioning as an electrode for extracting electrons, the negative electrode is preferably constituted by a conductive material having a low work function (for example, $\varphi$ = 3.5 eV to 4.5 eV). Specific examples thereof include an alkali metal (for example, Li, Na, K, or the like), a fluoride thereof, an oxide thereof, an alkaline earth metal (for example, Mg, Ca, or the like), a fluoride thereof, an oxide thereof, aluminum (Al), zinc (Zn), tin (Sn), thallium (Tl), a sodium-potassium alloy, an aluminum-lithium alloy, a magnesium-silver alloy, a rare earth metal such as indium or ytterbium, and an alloy thereof. Alternatively, examples of a material constituting the negative electrode include a metal such as platinum (Pt), gold (Au), palladium (Pd), chromium (Cr), nickel (Ni), aluminum (Al), silver (Ag), tantalum (Ta), tungsten (W), copper (Cu), titanium (Ti), indium (In), tin (Sn), iron (Fe), cobalt (Co), or molybdenum (Mo), an alloy containing these metal elements, a conductive particle containing these metals, a conductive particle of an alloy containing these metals, a polysilicon containing impurities, a carbon material, an oxide semiconductor material, and a conductive material such as a carbon nanotube or graphene. A laminated structure of layers containing these elements can be also used. Furthermore, examples of the material constituting the negative electrode include an organic material (conductive polymer) such as poly(3,4-ethylenedioxythiophene)/polystyrene sulfonic acid [PEDOT/PSS]. Furthermore, these conductive materials may be mixed with a binder (polymer) to form a paste or an ink, and the paste or the ink may be cured to be used as an electrode.

As a method for forming a film of the first electrode and the like or the second electrode (negative electrode or positive electrode), a dry method or a wet method can be used. Examples of the dry method include a physical vapor deposition method (PVD method) and a chemical vapor deposition method (CVD method). Examples of a film formation using the principle of the PVD method include a vacuum vapor deposition method using resistance heating or high frequency heating, an electron beam (EB) vapor deposition method, various sputtering methods (magnetron sputtering method, RF-DC coupled bias sputtering method, ECR sputtering method, opposing target sputtering method, or high frequency sputtering method), an ion plating method, a laser ablation method, a molecular beam epitaxy method, and a laser transfer method. Furthermore, examples of the CVD method include a plasma CVD method, a thermal CVD method, an organic metal (MO) CVD method, and an optical CVD method. Meanwhile, examples of the wet method include an electrolytic plating method, an electroless plating method, a spin coating method, an ink jet method, a spray coating method, a stamping method, a micro contact printing method, a flexographic printing method, an offset printing method, a gravure printing method, a dipping method, and the like. Examples of a patterning method include chemical etching such as shadow masking, laser transfer, or photolithography and physical etching using an ultraviolet ray, a laser, and the like. Examples of a technique for planarizing the first electrode and the like or the second electrode include a laser planarization method, a reflow method, and a chemical mechanical polishing (CMP) method.

Examples of a material constituting the insulating layer include not only an inorganic insulating material exemplified by a metal oxide high dielectric insulating material such as a silicon oxide material; silicon nitride ($SiN_Y$); or aluminum oxide ($Al_2O_3$), but also include an organic insulating material (organic polymer) exemplified by a straight chain hydrocarbon having a functional group capable of bonding to a control electrode at one end, such as polymethyl methacrylate (PMMA); polyvinyl phenol (PVP); polyvinyl alcohol (PVA); polyimide; polycarbonate (PC); polyethylene terephthalate (PET); polystyrene; a silanol derivative (silane coupling agent) such as N-2 (aminoethyl) 3-aminopropyltrimethoxysilane (AEAPTMS), 3-mercaptopropyltrimethoxysilane (MPTMS), or octadecyl trichlorosilane (OTS); a novolac type phenol resin; a fluorine-based resin; octadecanethiol, or dodecyl isocyanate. A combination thereof can be also used. Examples of the silicon oxide material include silicon oxide ($SiO_X$), BPSG, PSG, BSG, AsSG, PbSG, silicon oxynitride (SiON), spin on glass (SOG), low dielectric constant insulating material (for example, polyaryl ether, cyclo perfluorocarbon polymer and benzocyclobutene, a cyclic fluorocarbon resin, polytetrafluoroethylene, fluorinated aryl ether, fluorinated polyimide, amorphous carbon, and organic SOG). The insulating layer can have a single-layer configuration or a configuration in which a plurality of layers (for example, two layers) is laminated. In the latter case, by forming an insulating layer/lower layer at least on the charge accumulation electrode and in a region between the charge accumulation electrode and the first electrode, and planarizing the insulating layer/lower layer, the insulating layer/lower layer only needs to be left at least in the region between the charge accumulation electrode and the first electrode, and an insulating layer/upper layer only needs to be formed on the remaining insulating layer/lower layer and the charge accumulation electrode. As a result, planarization of the insulating layer can be achieved reliably. Materials constituting the various interlayer insulating layers and insulating material films only need to be appropriately selected from these materials.

The configuration and structure of the floating diffusion layer, amplification transistor, reset transistor, and selection transistor constituting the control unit can be similar to the configuration and structure of the conventional floating diffusion layer, amplification transistor, reset transistor, and selection transistor, respectively. The drive circuit can also have a well-known configuration and structure.

The first electrode is connected to the floating diffusion layer and a gate portion of the amplification transistor, and a contact hole portion only needs to be formed in order to connect the first electrode to the floating diffusion layer and the gate portion of the amplification transistor. Examples of a material constituting the contact hole portion include polysilicon doped with impurities, a high melting point metal such as tungsten, Ti, Pt, Pd, Cu, TiW, TiN, TiNW, $WSi_2$, or $MoSi_2$, a metal silicide, and a laminated structure of layers containing these materials (for example, Ti/TiN/W).

A first carrier blocking layer may be disposed between the inorganic oxide semiconductor material layer and the first electrode, and a second carrier blocking layer may be disposed between the organic photoelectric conversion layer and the second electrode. Furthermore, a first charge injection layer may be disposed between the first carrier blocking layer and the first electrode, and a second charge injection layer may be disposed between the second carrier blocking layer and the second electrode. Examples of a material constituting an electron injection layer include an alkali metal such as lithium (Li), sodium (Na), or potassium (K), a fluoride thereof, an oxide thereof, an alkaline earth metal such as magnesium (Mg) or calcium (Ca), a fluoride thereof, and an oxide thereof.

Examples of a method for forming films of various organic layers include a dry film formation method and a wet film formation method. Examples of the dry film formation method include a vacuum vapor deposition method using resistance heating, high frequency heating, or electron beam heating, a flash vapor deposition method, a plasma vapor deposition method, an EB vapor deposition method, various sputtering methods (a bipolar sputtering method, a direct current sputtering method, a direct current magnetron sputtering method, a high frequency sputtering method, a magnetron sputtering method, an RF-DC coupled bias sputtering method, an ECR sputtering method, a counter target sputtering method, a high frequency sputtering method, and an ion beam sputtering method), a direct current (DC) method, an RF method, a multi-negative electrode method, an activation reaction method, an electric field vapor deposition method, various ion plating methods such as a high frequency ion plating method and a reactive ion plating method, a laser ablation method, a molecular beam epitaxy method, a laser transfer method, and a molecular beam epitaxy method (MBE method). Furthermore, examples of the CVD method include a plasma CVD method, a thermal CVD method, an MOCVD method, and an optical CVD method. Meanwhile, specific examples of the wet method include a spin coating method; an immersion method; a casting method; a micro-contact printing method; a drop casting method; various printing methods such as a screen printing method, an inkjet printing method, an offset printing method, a gravure printing method, and a flexographic printing method; a stamping method; a spraying method; and various coating methods such as an air doctor coater method, a blade coater method, a rod coater method, a knife coater method, a squeeze coater method, a reverse roll coater method, a transfer roll coater method, a gravure coater method, a kiss coater method, a cast coater method, a spray coater method, a slit orifice coater method, and a calendar coater method. In the coating method, examples of a solvent include an organic solvent having a no polarity or low polarity, such as toluene, chloroform, hexane, or ethanol. Examples of a patterning method include chemical etching such as shadow masking, laser transfer, or photolithography and physical etching using an ultraviolet ray, a laser, and the like. Examples of a technique for planarizing various organic layers include a laser planarization method, a reflow method, and the like.

Two or more of the imaging elements of the first to sixth configurations described above can be appropriately combined as desired.

As described above, the imaging element or the solid-state imaging device may include an on-chip micro lens or a light shielding layer, if necessary, and includes a drive circuit for driving the imaging element or wiring lines. If necessary, a shutter for controlling incidence of light on the imaging element may be disposed, or an optical cut filter may be disposed according to a purpose of the solid-state imaging device.

Furthermore, each of the solid-state imaging devices of the first and second configurations can have a form in which one on-chip micro lens is disposed above one of the imaging elements and the like of the present disclosure, or can have a form in which an imaging element block is constituted by two of the imaging elements and the like of the present disclosure, and one on-chip micro lens is disposed above the imaging element block.

For example, in a case where the solid-state imaging device is laminated with a readout integrated circuit (ROIC), by superposing a drive substrate on which a readout integrated circuit and a connection portion containing copper (Cu) are formed, and an imaging element in which a connection portion is formed such that the connection portions come into contact with each other, and bonding the connection portions to each other, lamination can be performed, and the connection portions can be bonded to each other using solder bumps and the like.

Furthermore, the driving method for driving the solid-state imaging devices according to the first and second aspects of the present disclosure can be a solid-state imaging device driving method for repeating,

discharging charges in the first electrode out of the system while charges are accumulated in the inorganic oxide semiconductor material layer (or the inorganic oxide semiconductor material layer and the photoelectric conversion layer) all at once in all the imaging elements, and thereafter

transferring the charges accumulated in the inorganic oxide semiconductor material layer (or the inorganic oxide semiconductor material layer and the photoelectric conversion layer) to the first electrode all at once in all the imaging elements, and sequentially reading out the charges transferred to the first electrode in each of the imaging elements after completion of the transfer.

In such a method for driving a solid-state imaging device, each of the imaging elements has a structure in which light incident from the second electrode side is not incident on the first electrode, and the charges in the first electrode are discharged out of the system while the charges are accumulated in the inorganic oxide semiconductor material layer and the like all at once in all the imaging elements. Therefore, the first electrode can be reliably reset simultaneously in all the imaging elements. Then, thereafter, the charges accumulated in the inorganic oxide semiconductor material layer and the like are transferred to the first electrode all at once in all the imaging elements, and after completion of the transfer, the charges transferred to the first electrode are sequentially read out in each of the imaging elements. Therefore, a so-called global shutter function can be easily implemented.

Hereinafter, the imaging element and the solid-state imaging device of Example 1 will be described in detail.

The imaging element of Example 1 further includes a semiconductor substrate (more specifically, a silicon semiconductor layer) 70, and the photoelectric conversion unit is disposed above the semiconductor substrate 70. Furthermore, the imaging element and the like of Example 1 further include a control unit disposed on the semiconductor substrate 70 and having a drive circuit to which the first electrode 21 and the second electrode 22 are connected. Here, a light incident surface in the semiconductor substrate 70 is defined as an upper side, and the opposite side of the semiconductor substrate 70 is defined as a lower side. A wiring layer 62 including a plurality of wiring lines is disposed below the semiconductor substrate 70.

The semiconductor substrate 70 includes at least a floating diffusion layer $FD_1$ and an amplification transistor $TR1_{amp}$ constituting a control unit, and the first electrode 21 is connected to the floating diffusion layer $FD_1$ and a gate portion of the amplification transistor $TR1_{amp}$. The semiconductor substrate 70 further includes a reset transistor $TR1_{rst}$ and a selection transistor $TR1_{sel}$ constituting the control unit. The floating diffusion layer $FD_1$ is connected to one source/drain region of the reset transistor $TR1_{rst}$. The other source/drain region of the amplification transistor $TR1_{amp}$ is connected to one source/drain region of the selection transistor $TR1_{sel}$. The other source/drain region of the selection transistor $TR1_{sel}$ is connected to a signal line $VSL_1$. These amplification transistor $TR1_{amp}$, reset transistor $TR1_{rst}$, and selection transistor $TR1_{sel}$ constitute a drive circuit.

Specifically, the imaging element of Example 1 is a backside irradiation type imaging element, and have a structure formed by laminating three imaging elements of a first type green light imaging element of Example 1, including a first type green light photoelectric conversion layer that absorbs green light and sensitive to green light (hereinafter referred to as "first imaging element"), a second type conventional blue light imaging element including a second type blue light photoelectric conversion layer that absorbs blue light and sensitive to blue light (hereinafter referred to as "second imaging element"), and a second type conventional red light imaging element including a second type red light photoelectric conversion layer that absorbs red light and sensitive to red light (hereinafter referred to as "third imaging element"). Here, the red light imaging element (third imaging element) and the blue light imaging element (second imaging element) are disposed in the semiconductor substrate 70, and the second imaging element is located closer to the light incident side than the third imaging element. Furthermore, the green light imaging element (first imaging element) is disposed above the blue light imaging element (second imaging element). One pixel is constituted by the laminated structure of the first imaging element, the second imaging element, and the third imaging element. No color filter layer is disposed.

In the first imaging element, the first electrode 21 and the charge accumulation electrode 24 are formed on an interlayer insulating layer 81 so as to be separated from each other. The interlayer insulating layer 81 and the charge accumulation electrode 24 are covered with the insulating layer 82. The inorganic oxide semiconductor material layer 23B and the photoelectric conversion layer 23A are formed on the insulating layer 82, and the second electrode 22 is formed on the photoelectric conversion layer 23A. An insulating layer 83 is formed on the entire surface including the second electrode 22, and an on-chip micro lens 14 is disposed on the insulating layer 83. No color filter layer is disposed. The first electrode 21, the charge accumulation electrode 24, and the second electrode 22 are each constituted by a transparent electrode containing, for example, ITO (work function: about 4.4 eV). The inorganic oxide semiconductor material layer 23B is constituted by $Ga_aSn_bO_c$ or $Ga_dIn_eO_f$. The photoelectric conversion layer 23A is constituted by a layer containing a known organic photoelectric conversion material sensitive to at least green light (for example, an organic material such as a rhodamine-based dye, a meracyanine-based dye, or quinacridone). The interlayer insulating layer 81 and the insulating layers 82 and 83 each contain a known insulating material (for example, $SiO_2$ or SiN). The inorganic oxide semiconductor material layer 23B and the first electrode 21 are connected to each other by a connection portion 67 disposed in the insulating layer 82. In the connection portion 67, the inorganic oxide semiconductor material layer 23B extends. That is, the inorganic oxide semiconductor material layer 23B extends in an opening 85 formed in the insulating layer 82 to be connected to the first electrode 21.

The charge accumulation electrode 24 is connected to a drive circuit. Specifically, the charge accumulation electrode 24 is connected to a vertical drive circuit 112 constituting the drive circuit via a connection hole 66, a pad portion 64, and wiring $V_{OA}$ formed in the interlayer insulating layer 81.

The charge accumulation electrode 24 is larger than the first electrode 21. When the area of the charge accumulation electrode 24 is represented by $S_1'$, and the area of the first electrode 21 is represented by $S_1$,

$$4 \leq S_1'/S_1$$

is preferably satisfied although not limited.

In Example 1, for example,
$S_1'/S_1$ was set to 8 although not limited. Note that in Examples 7 to 10 described later, the sizes of three photoelectric conversion unit segments $10'_1$, $10'_2$, and $10'_3$) are the same, and the planar shapes thereof are also the same.

An element isolation region 71 is formed on a first surface (front surface) 70A side of the semiconductor substrate 70. Furthermore, an oxide film 72 is formed on the first surface 70A of the semiconductor substrate 70. Moreover, on the first surface side of the semiconductor substrate 70, the reset transistor $TR1_{rst}$, the amplification transistor $TR1_{amp}$, and the selection transistor $TR1_{sel}$ constituting the control unit of the first imaging element are disposed, and the first floating diffusion layer $FD_1$ is further disposed.

The reset transistor $TR1_{rst}$ includes a gate portion 51, a channel formation region 51A, and source/drain regions 51B and 51C. The gate portion 51 of the reset transistor $TR1_{rst}$ is connected to a reset line $RST_1$. One source/drain region 51C of the reset transistor $TR1_{rst}$ also serves as the first floating diffusion layer $FD_1$, and the other source/drain region 51B is connected to a power source $V_{DD}$.

The first electrode 21 is connected to one source/drain region 51C (first floating diffusion layer $FD_1$) of the reset transistor $TR1_{rst}$ via a connection hole 65 and a pad portion 63 formed in the interlayer insulating layer 81, a contact hole portion 61 formed in the semiconductor substrate 70 and the interlayer insulating layer 76, and the wiring layer 62 formed in the interlayer insulating layer 76.

The amplification transistor $TR1_{amp}$ includes a gate portion 52, a channel formation region 52A, and source/drain regions 52B and 52C. The gate portion 52 is connected to the first electrode 21 and one source/drain region 51C (first floating diffusion layer $FD_1$) of the reset transistor $TR1_{rst}$ via the wiring layer 62. Furthermore, one source/drain region 52B is connected to the power source $V_{DD}$.

The selection transistor $TR1_{sel}$ includes a gate portion 53, a channel formation region 53A, and source/drain regions 53B and 53C. The gate portion 53 is connected to a selection line $SEL_1$. Furthermore, one source/drain region 53B shares a region with the other source/drain region 52C constituting the amplification transistor $TR1_{amp}$, and the other source/drain region 53C is connected to a signal line (data output line) $VSL_1$ (117).

The second imaging element includes an n-type semiconductor region 41 disposed on the semiconductor substrate 70 as a photoelectric conversion layer. A gate portion 45 of a transfer transistor $TR2_{trs}$ constituted by a vertical transistor extends to the n-type semiconductor region 41 and is connected to a transfer gate line $TG_2$. Furthermore, the

second floating diffusion layer $FD_2$ is disposed in a region 45C of the semiconductor substrate 70 near the gate portion 45 of the transfer transistor $TR2_{trs}$. Charges accumulated in the n-type semiconductor region 41 are read out to the second floating diffusion layer $FD_2$ via a transfer channel formed along the gate portion 45.

In the second imaging element, on the first surface side of the semiconductor substrate 70, the reset transistor $TR2_{rst}$, the amplification transistor $TR2_{amp}$, and the selection transistor $TR2_{sel}$ constituting the control unit of the second imaging element are further disposed.

The reset transistor $TR2_{rst}$ includes a gate portion, a channel formation region, and a source/drain region. The gate portion of the reset transistor $TR2_{rst}$ is connected to a reset line $RST_2$. One source/drain region of the reset transistor $TR2_{rst}$ is connected to the power source $V_{DD}$, and the other source/drain region also serves as the second floating diffusion layer $FD_2$.

The amplification transistor $TR2_{amp}$ includes a gate portion, a channel formation region, and a source/drain region. The gate portion is connected to the other source/drain region (second floating diffusion layer $FD_2$) of the reset transistor $TR2_{rst}$. Furthermore, one source/drain region is connected to the power source $V_{DD}$.

The selection transistor $TR2_{sel}$ includes a gate portion, a channel formation region, and a source/drain region. The gate portion is connected to a selection line $SEL_2$. Furthermore, one source/drain region shares a region with the other source/drain region constituting the amplification transistor $TR2_{amp}$, and the other source/drain region is connected to a signal line (data output line) $VSL_2$.

The third imaging element includes an n-type semiconductor region 43 disposed on the semiconductor substrate 70 as a photoelectric conversion layer. A gate portion 46 of the transfer transistor $TR3_{trs}$ is connected to a transfer gate line $TG_3$. Furthermore, the third floating diffusion layer $FD_3$ is disposed in a region 46C of the semiconductor substrate 70 near the gate portion 46 of the transfer transistor $TR3_{trs}$. Charges accumulated in the n-type semiconductor region 43 are read out to the third floating diffusion layer $FD_3$ via a transfer channel 46A formed along the gate portion 46.

In the third imaging element, on the first surface side of the semiconductor substrate 70, the reset transistor $TR3_{rst}$, the amplification transistor $TR3_{amp}$, and the selection transistor $TR3_{sel}$ constituting the control unit of the third imaging element are further disposed.

The reset transistor $TR3_{rst}$ includes a gate portion, a channel formation region, and a source/drain region. The gate portion of the reset transistor $TR3_{rst}$ is connected to a reset line $RST_3$. One source/drain region of the reset transistor $TR3_{rst}$ is connected to the power source $V_{DD}$, and the other source/drain region also serves as the third floating diffusion layer $FD_3$.

The amplification transistor $TR3_{amp}$ includes a gate portion, a channel formation region, and a source/drain region. The gate portion is connected to the other source/drain region (third floating diffusion layer $FD_3$) of the reset transistor $TR3_{rst}$. Furthermore, one source/drain region is connected to the power source $V_{DD}$.

The selection transistor $TR3_{sel}$ includes a gate portion, a channel formation region, and a source/drain region. The gate portion is connected to the selection line $SEL_3$. Furthermore, one source/drain region shares a region with the other source/drain region constituting the amplification transistor $TR3_{amp}$, and the other source/drain region is connected to a signal line (data output line) $VSL_3$.

The reset lines $RST_1$, $RST_2$, and $RST_3$, the selection lines $SEL_1$, $SEL_2$, and $SEL_3$, and the transfer gate lines $TG_2$ and $TG_3$ are connected to the vertical drive circuit 112 constituting a drive circuit, and the signal lines (data output lines) $VSL_1$, $VSL_2$, and $VSL_3$ are connected to a column signal processing circuit 113 constituting the drive circuit.

A $p^+$ layer 44 is disposed between the n-type semiconductor region 43 and the front surface 70A of the semiconductor substrate 70 to suppress generation of a dark current. A $p^+$ layer 42 is formed between the n-type semiconductor region 41 and the n-type semiconductor region 43, and moreover, a part of a side surface of the n-type semiconductor region 43 is surrounded by the $p^+$ layer 42. A $p^+$ layer 73 is formed on a back surface 70B side of the semiconductor substrate 70. An $HfO_2$ film 74 and an insulating material film 75 are formed from the $p^+$ layer 73 to a portion where the contact hole portion 61 is to be formed inside the semiconductor substrate 70. In the interlayer insulating layer 76, wiring lines are formed in a plurality of layers, but is not illustrated.

The $HfO_2$ film 74 has negative fixed charges. By forming such a film, generation of a dark current can be suppressed. Instead of the $HfO_2$ film, an aluminum oxide ($Al_2O_3$) film, a zirconium oxide ($ZrO_2$) film, a tantalum oxide ($Ta_2O_5$) film, a titanium oxide ($TiO_2$) film, a lanthanum oxide ($La_2O_3$) film, a praseodymium oxide ($Pr_2O_3$) film, a cerium oxide ($CeO_2$) film, a neodymium oxide ($Nd_2O_3$) film, a promethium oxide ($Pm_2O_3$) film, a samarium oxide ($Sm_2O_3$) film, an europium oxide ($Eu_2O_3$) film, a gadolinium oxide (($Gd_2O_3$) film, a terbium oxide ($Tb_2O_3$) film, a dysprosium oxide ($Dy_2O_3$) film, a holmium oxide ($Ho_2O_3$) film, a thulium oxide ($Tm_2O_3$) film, a ytterbium oxide ($Yb_2O_3$) film, a lutetium oxide ($Lu_2O_3$) film, a yttrium oxide ($Y_2O_3$) film, a hafnium nitride film, an aluminum nitride film, a hafnium oxynitride film, or an aluminum oxynitride film can be used. Examples of a method for forming these films include a CVD method, a PVD method, and an ALD method.

Hereinafter, with reference to Figs. 5 and 6A, operation of the laminated imaging element (first imaging element) including the charge accumulation electrode of Example 1 will be described. The imaging element of Example 1 further includes a control unit disposed on the semiconductor substrate 70 and having a drive circuit. The first electrode 21, the second electrode 22, and the charge accumulation electrode 24 are connected to the drive circuit. Here, the potential of the first electrode 21 was set to be higher than the potential of the second electrode 22. That is, for example, the first electrode 21 is set to a positive potential, and the second electrode 22 is set to a negative potential. Electrons generated by photoelectric conversion in the photoelectric conversion layer 23A are read out to the floating diffusion layer. This applies to the other Examples similarly.

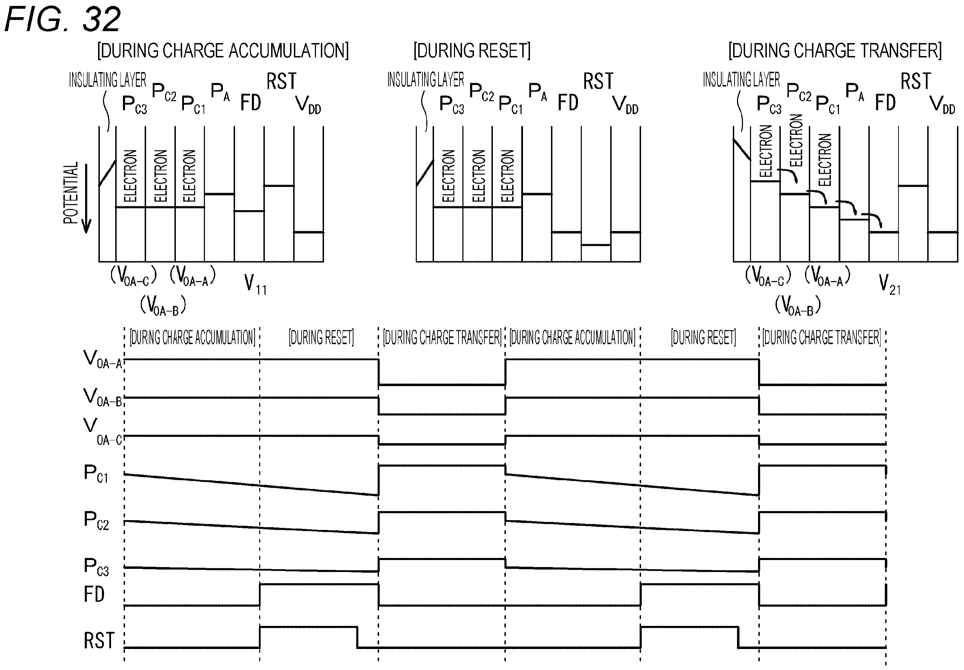

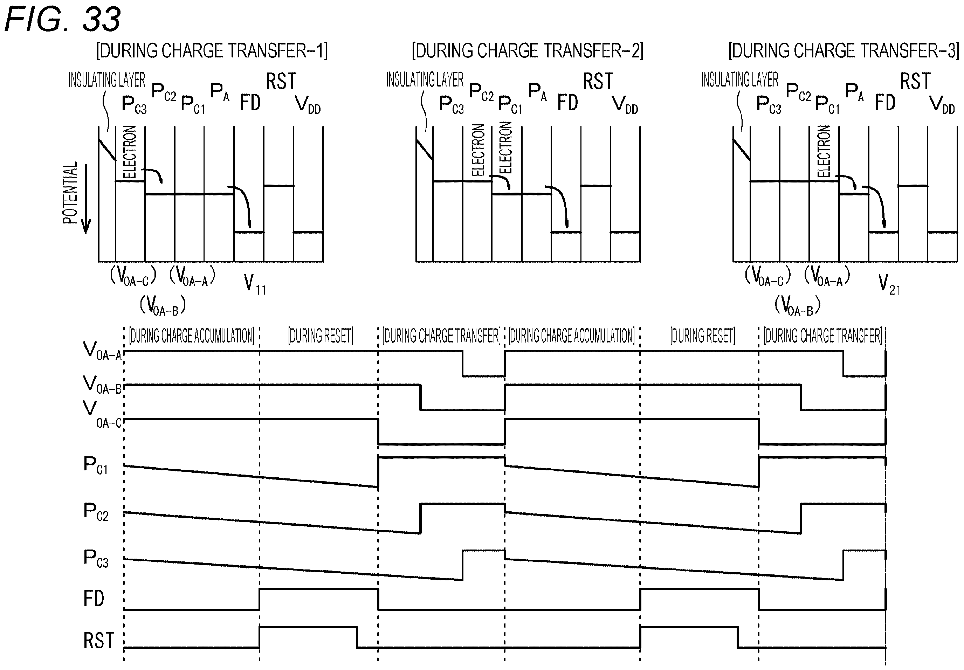

Reference numerals used in Fig. 5, Figs. 20 and 21 in Example 4 described later, and Figs. 32 and 33 in Example 6 are as follows.

$P_A$ Potential at point $P_A$ of a region of the inorganic oxide semiconductor material layer 23B facing a region located between the charge accumulation electrode 24 or the transfer control electrode (charge transfer electrode) 25 and the first electrode 21

$P_B$ Potential at point $P_B$ in a region of the inorganic oxide semiconductor material layer 23B facing the charge accumulation electrode 24

$P_{C1}$ Potential at point $P_{C1}$ in a region of the inorganic oxide semiconductor material layer 23B facing the charge accumulation electrode segment 24A

$P_{C2}$ Potential at point $P_{C2}$ in a region of the inorganic oxide semiconductor material layer 23B facing the charge accumulation electrode segment 24B

$P_{C3}$ Potential at point $P_{C3}$ in a region of the inorganic oxide semiconductor material layer 23B facing the charge accumulation electrode segment 24C

$P_D$ Potential at point $P_D$ in a region of the inorganic oxide semiconductor material layer 23B facing the transfer control electrode (charge transfer electrode) 25

FD Potential in the first floating diffusion layer $FD_1$

$V_{OA}$ Potential in the charge accumulation electrode 24

$V_{OA-A}$ Potential in the charge accumulation electrode segment 24A

$V_{OA-B}$ Potential in the charge accumulation electrode segment 24B

$V_{OA-C}$ Potential in the charge accumulation electrode segment 24C

$V_{OT}$ Potential in the transfer control electrode (charge transfer electrode) 25

RST Potential in the gate portion 51 of the reset transistor $TR1_{rst}$

$V_{DD}$ Potential of power source

$VSL_1$ Signal line (data output line) $VSL_1$

$TR1_{rst}$ Reset transistor $TR1_{rst}$

$TR1_{amp}$ Amplification transistor $TR1_{amp}$

$TR1_{sel}$ Selection transistor $TR1_{sel}$

In a charge accumulation period, the potential $V_{11}$ is applied to the first electrode 21 and the potential $V_{12}$ is applied to the charge accumulation electrode 24 from a drive circuit. Photoelectric conversion occurs in the photoelectric conversion layer 23A by light incident on the photoelectric conversion layer 23A. Holes generated by the photoelectric conversion are sent from the second electrode 22 to a drive circuit via the wiring $V_{OU}$. Meanwhile, the potential of the first electrode 21 is set to be higher than the potential of the second electrode 22, that is, for example, a positive potential is applied to the first electrode 21, and a negative potential is applied to the second electrode 22. Therefore, $V_{12} \geq V_{11}$ is satisfied, preferably $V_{12} > V_{11}$ is satisfied. As a result, electrons generated by the photoelectric conversion are attracted to the charge accumulation electrode 24, and stop in a region of the inorganic oxide semiconductor material layer 23B or the inorganic oxide semiconductor material layer 23B and the photoelectric conversion layer 23A (hereinafter collectively referred to as "inorganic oxide semiconductor material layer 23B and the like") facing the charge accumulation electrode 24. That is, charges are accumulated in the inorganic oxide semiconductor material layer 23B and the like. Since $V_{12} > V_{11}$ is satisfied, electrons generated inside the photoelectric conversion layer 23A are not transferred toward the first electrode 21. As the time for the photoelectric conversion elapses, the potential in the region of the inorganic oxide semiconductor material layer 23B and the like facing the charge accumulation electrode 24 becomes a more negative value.

In a later stage of the charge accumulation period, a reset operation is performed. As a result, the potential of the first floating diffusion layer $FD_1$ is reset, and the potential of the first floating diffusion layer $FD_1$ becomes the potential $V_{DD}$ of the power source.

After the reset operation is completed, charges are read out. That is, in a charge transfer period, the potential $V_{21}$ is applied to the first electrode 21 and the potential $V_{22}$ is applied to the charge accumulation electrode 24 from a drive circuit. Here, $V_{22} < V_{21}$ is satisfied. As a result, electrons that have stopped in the region of the inorganic oxide semiconductor material layer 23B and the like facing the charge accumulation electrode 24 are read out to the first electrode 21 and further to the first floating diffusion layer $FD_1$. That is, the charges accumulated in the inorganic oxide semiconductor material layer 23B and the like are read out to the control unit.

In this way, a series of operations including charge accumulation, reset operation, and charge transfer are completed.

The operations of the amplification transistor $TR1_{amp}$ and the selection transistor $TR1_{sel}$ after electrons are read out to the first floating diffusion layer $FD_1$ are the same as the conventional operations of these transistors. Furthermore, a series of operations including charge accumulation, reset operation, and charge transfer of the second imaging element and the third imaging element are similar to a conventional series of operations including charge accumulation, reset operation, and charge transfer. Furthermore, a reset noise of the first floating diffusion layer $FD_1$ can be removed by a correlated double sampling (CDS) process as in prior art.

As described above, in Example 1, since the charge accumulation electrode is included which is disposed apart from the first electrode so as to face the photoelectric conversion layer via the insulating layer, when the photoelectric conversion layer is irradiated with light, and the light is photoelectrically converted in the photoelectric conversion layer, the inorganic oxide semiconductor material layer and the like, the insulating layer, and the charge accumulation electrode form a kind of capacitor, and charges can be stored in the inorganic oxide semiconductor material layer and the like. Therefore, at the time of start of exposure, a charge accumulation portion can be completely depleted and the charge can be erased. As a result, it is possible to suppress occurrence of a phenomenon that a kTC noise increases, a random noise deteriorates, and the quality of an imaged image deteriorates. Furthermore, since all the pixels can be reset all at once, a so-called global shutter function can be achieved.

Fig. 76 illustrates a conceptual diagram of the solid-state imaging device of Example 1. A solid-state imaging device 100 of Example 1 includes an imaging region 111 in which the laminated imaging elements 101 are arrayed two-dimensionally, and the vertical drive circuit 112, the column signal processing circuit 113, a horizontal drive circuit 114, an output circuit 115, a drive control circuit 116, and the like as drive circuits (peripheral circuits) of the laminated imaging elements 101. It goes without saying that these circuits can be constituted by well-known circuits, and also can be constituted using other circuit configurations (for example, various circuits used in a conventional CCD imaging device or CMOS imaging device). In Fig. 76, the reference number "101" of the laminated imaging element 101 is displayed only in one row.

The drive control circuit 116 generates a clock signal or a control signal as a reference of operations of the vertical drive circuit 112, the column signal processing circuit 113, and the horizontal drive circuit 114 on the basis of a vertical synchronizing signal, a horizontal synchronizing signal, and a master clock. Then, the generated clock signal or control signal is input to the vertical drive circuit 112, the column signal processing circuit 113, and the horizontal drive circuit 114.

For example, the vertical drive circuit 112 is constituted by a shift register, and sequentially selects and scans the laminated imaging elements 101 in the imaging region 111 in a row unit in the vertical direction. Then, a pixel signal (image signal) based on a current (signal) generated according to the amount of light received by each of the laminated imaging elements 101 is sent to the column signal processing circuit 113 via a signal line (data output line) 117, VSL.

For example, the column signal processing circuit 113 is disposed for each column of the laminated imaging elements 101. Image signals output from the laminated imaging elements 101 in one row are subjected to signal processing such as noise removal or signal amplification with a signal from a black reference pixel (not illustrated, but formed around an effective pixel region) for each of the imaging elements. In an output stage of the column signal processing circuit 113, a horizontal selection switch (not illustrated) is connected and disposed between the column signal processing circuit 113 and a horizontal signal line 118.

For example, the horizontal drive circuit 114 is constituted by a shift register. By sequentially outputting a horizontal scanning pulse, the horizontal drive circuit 114 sequentially selects each of the column signal processing circuits 113, and outputs a signal from each of the column signal processing circuits 113 to the horizontal signal line 118.

The output circuit 115 performs signal processing to a signal sequentially supplied from each of the column signal processing circuits 113 via the horizontal signal line 118, and outputs the signal.

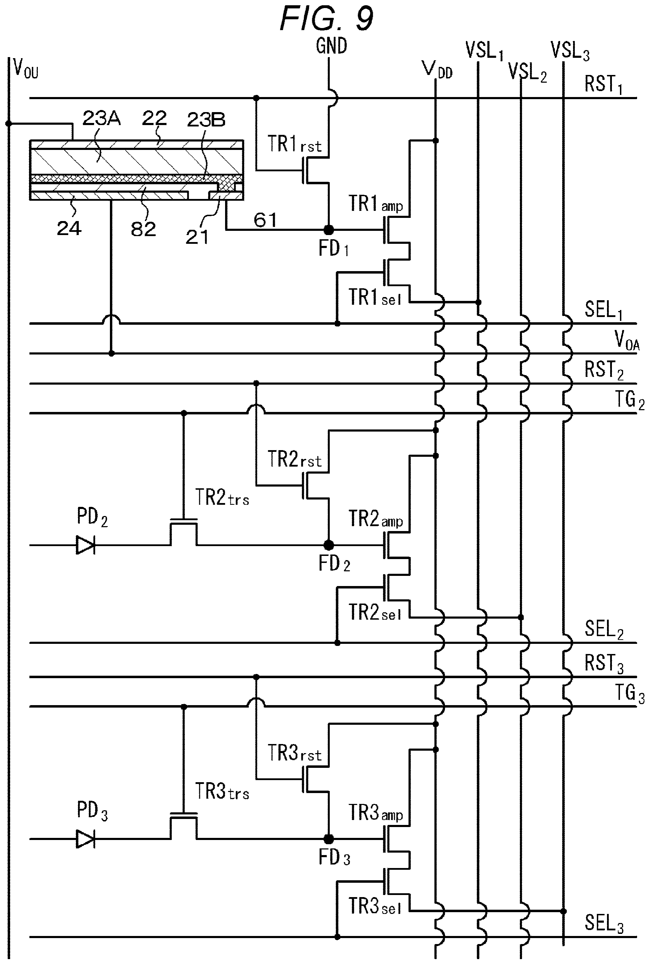

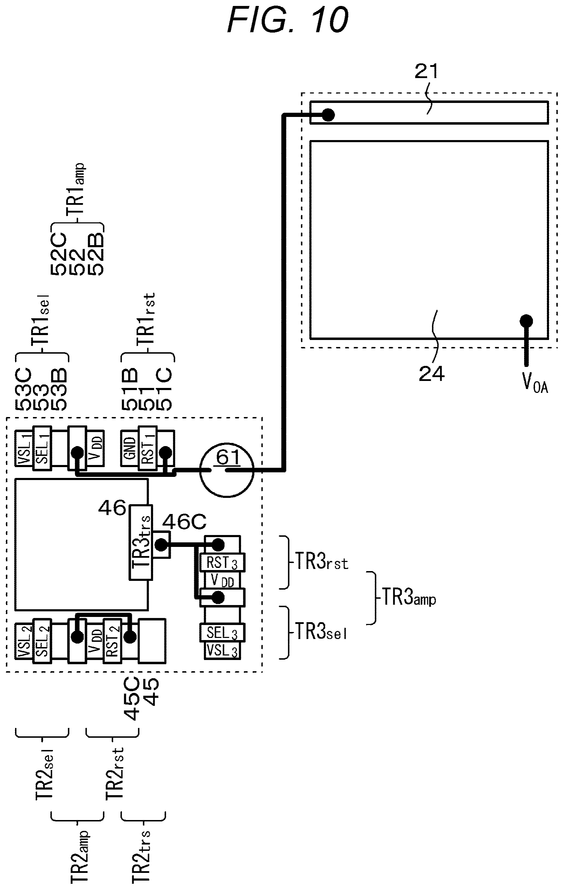

As Fig. 9 illustrates an equivalent circuit diagram of a modification of the imaging element of Example 1, and Fig. 10 illustrates a schematic arrangement diagram of the first electrode, the charge accumulation electrode, and a transistor constituting the control unit, the other source/drain region 51B of the reset transistor $TR1_{rst}$ may be grounded instead of being connected to the power source $V_{DD}$.

The imaging element of Example 1 can be manufactured, for example, by the following method. That is, first, an SOI substrate is prepared. Then, a first silicon layer is formed on a surface of the SOI substrate on the basis of an epitaxial growth method, and the $p^+$ layer 73 and the n-type semiconductor region 41 are formed on the first silicon layer. Subsequently, a second silicon layer is formed on the first silicon layer on the basis of an epitaxial growth method, and the element isolation region 71, the oxide film 72, $p^+$ layer 42, the n-type semiconductor region 43, and the $p^+$ layer 44 are formed on the second silicon layer. Furthermore, various transistors and the like constituting the control unit of the imaging element are formed on the second silicon layer. The wiring layer 62, the interlayer insulating layer 76, and various wiring lines are further formed thereon, and then the interlayer insulating layer 76 is bonded to a support substrate (not illustrated). Thereafter, the SOI substrate is removed to expose the first silicon layer. The surface of the second silicon layer corresponds to the front surface 70A of the semiconductor substrate 70, and the surface of the first silicon layer corresponds to the back surface 70B of the semiconductor substrate 70. Furthermore, the first silicon layer and the second silicon layer are collectively expressed as the semiconductor substrate 70. Subsequently, an opening for forming the contact hole portion 61 is formed on the back surface 70B side of the semiconductor substrate 70. The HfO$_2$ film 74, the insulating material film 75, and the contact hole portion 61 are formed. The pad portions 63 and 64, the interlayer insulating layer 81, the connection holes 65 and 66, the first electrode 21, the charge accumulation electrode 24, and the insulating layer 82 are further formed. Next, the connection portion 67 is opened, and the inorganic oxide semiconductor material layer 23B, the photoelectric conversion layer 23A, the second electrode 22, the insulating layer 83, and the on-chip micro lens 14 are formed. As a result, the imaging element of Example 1 can be obtained.

Furthermore, although not illustrated, the insulating layer 82 can have a two-layer configuration of an insulating layer/lower layer and an insulating layer/upper layer. That is, it is only required to form the insulating layer/lower layer at least on the charge accumulation electrode 24 and in a region between the charge accumulation electrode 24 and the first electrode 21 (more specifically, to form the insulating layer/lower layer on the interlayer insulating layer 81 including the charge accumulation electrode 24), to planarize the insulating layer/lower layer, and then to form an insulating layer/upper layer on the insulating layer/lower layer and the charge accumulation electrode 24. As a result, the insulating layer 82 can be reliably planarized. Then, it is only required to open the connection portion 67 in the insulating layer 82 thus obtained.

[Example 2]

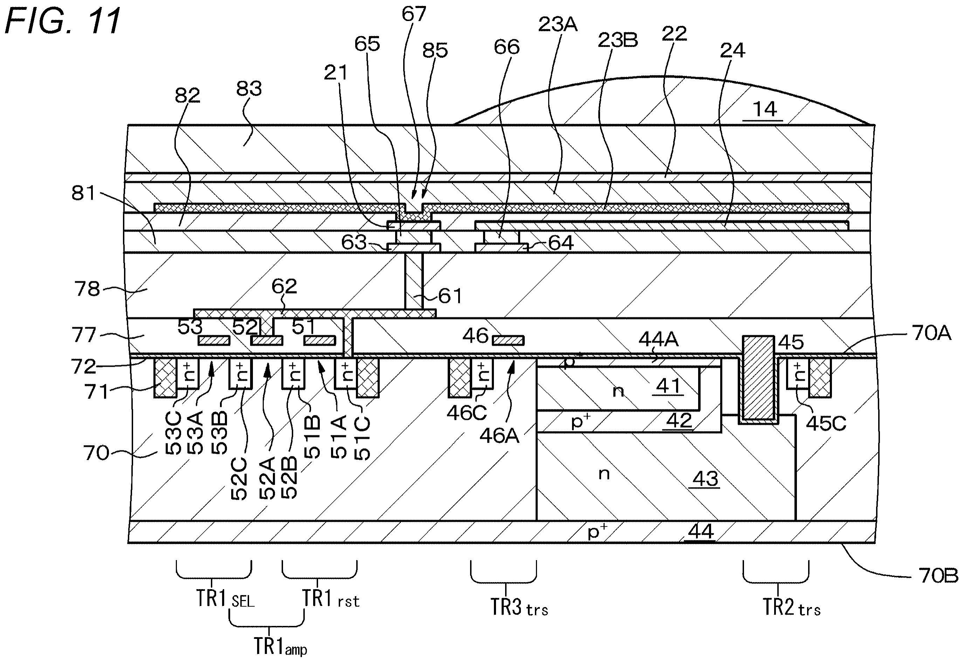

Example 2 is a modification of Example 1. An imaging element of Example 2, illustrated in the schematic partial cross-sectional view of Fig. 11, is a frontside irradiation type imaging element, and has a structure formed by laminating three imaging elements of a first type green light imaging element of Example 1, including a first type green light photoelectric conversion layer that absorbs green light and sensitive to green light (first imaging element), a second type conventional blue light imaging element including a second type blue light photoelectric conversion layer that absorbs blue light and sensitive to blue light (second imaging element), and a second type conventional red light imaging element including a second type red light photoelectric conversion layer that absorbs red light and sensitive to red light (third imaging element). Here, the red light imaging element (third imaging element) and the blue light imaging element (second imaging element) are disposed in the semiconductor substrate 70, and the second imaging element is located closer to the light incident side than the third imaging element. Furthermore, the green light imaging element (first imaging element) is disposed above the blue light imaging element (second imaging element).

On the front surface 70A side of the semiconductor substrate 70, various transistors constituting a control unit are disposed as in Example 1. These transistors can have substantially similar configurations and structures to the transistors described in Example 1. Furthermore, the semiconductor substrate 70 includes the second imaging element and the third imaging element, and these imaging elements can have substantially similar configurations and structures to the second imaging element and the third imaging element described in Example 1.

The interlayer insulating layer 81 is formed above the front surface 70A of the semiconductor substrate 70. Above the interlayer insulating layer 81, the photoelectric conversion unit (first electrode 21, inorganic oxide semiconductor material layer 23B, photoelectric conversion layer 23A, second electrode 22, charge accumulation electrode 24, and the like) including the charge accumulation electrode and constituting the imaging element of Example 1 is disposed.

In this way, the configuration and structure of the imaging element of Example 2 can be similar to the configuration and structure of the imaging element of Example 1 except for being the frontside irradiation type. Therefore, detailed description thereof is omitted.

[Example 3]

Example 3 is a modification of Examples 1 and 2.

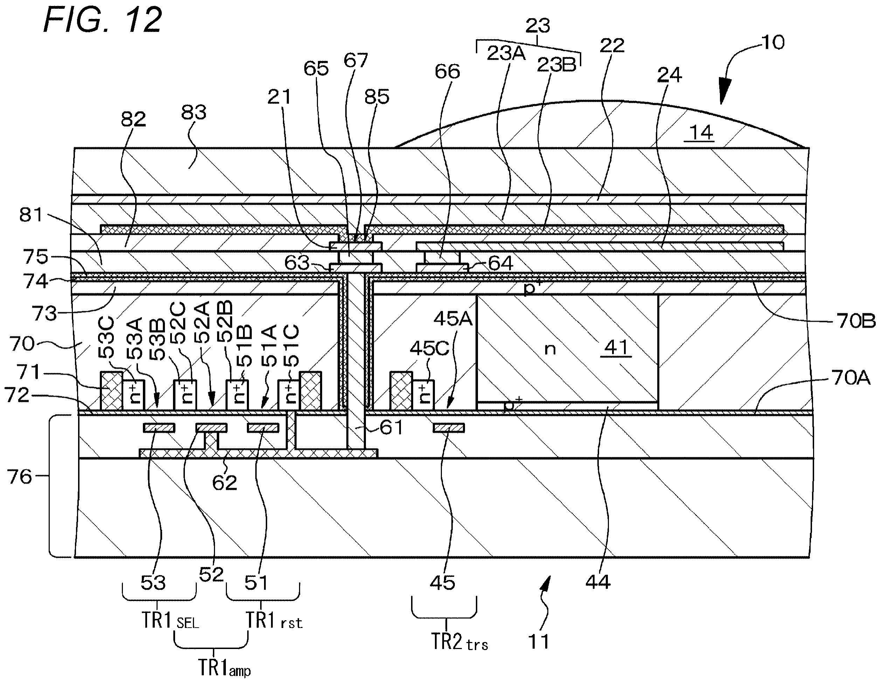

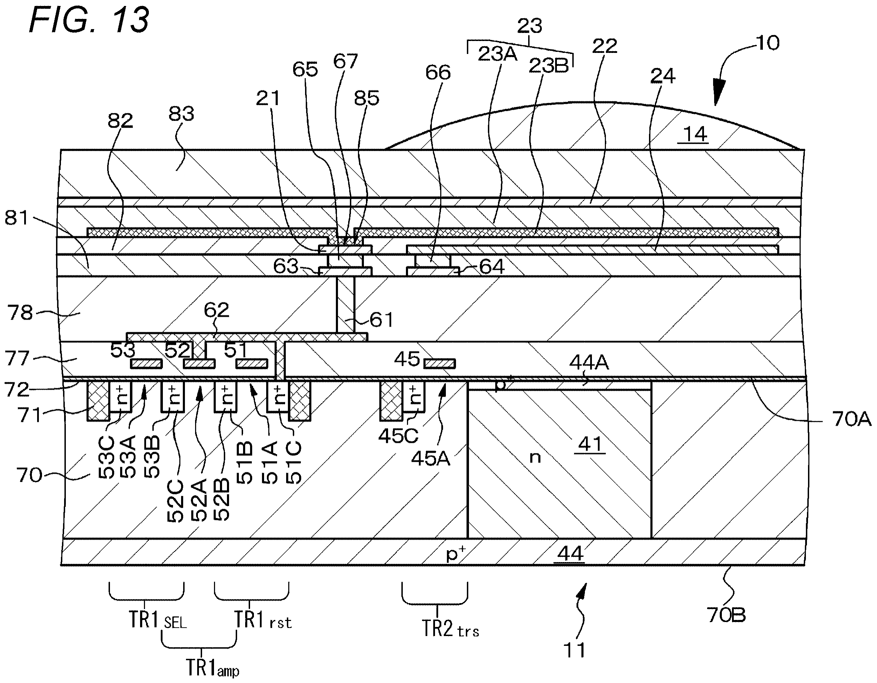

An imaging element of Example 3, illustrated in the schematic partial cross-sectional view of Fig. 12, is a backside irradiation type imaging element, and has a structure formed by laminating two imaging elements of the first type first imaging element of Example 1 and the second type second imaging element. Furthermore, a modification of the imaging element of Example 3, illustrated in the schematic partial cross-sectional view of Fig. 13, is a frontside irradiation type imaging element, and has a structure formed by laminating two imaging elements of the first type first imaging element of Example 1 and the second type second imaging element. Here, the first imaging element absorbs primary color light, and the second imaging element absorbs complementary color light. Alternatively, the first imaging element absorbs white light, and the second imaging element absorbs infrared rays. Charges accumulated in the n-type semiconductor region 41 are read out to the second floating diffusion layer FD$_2$ via a transfer channel 45A formed along the gate portion 45.

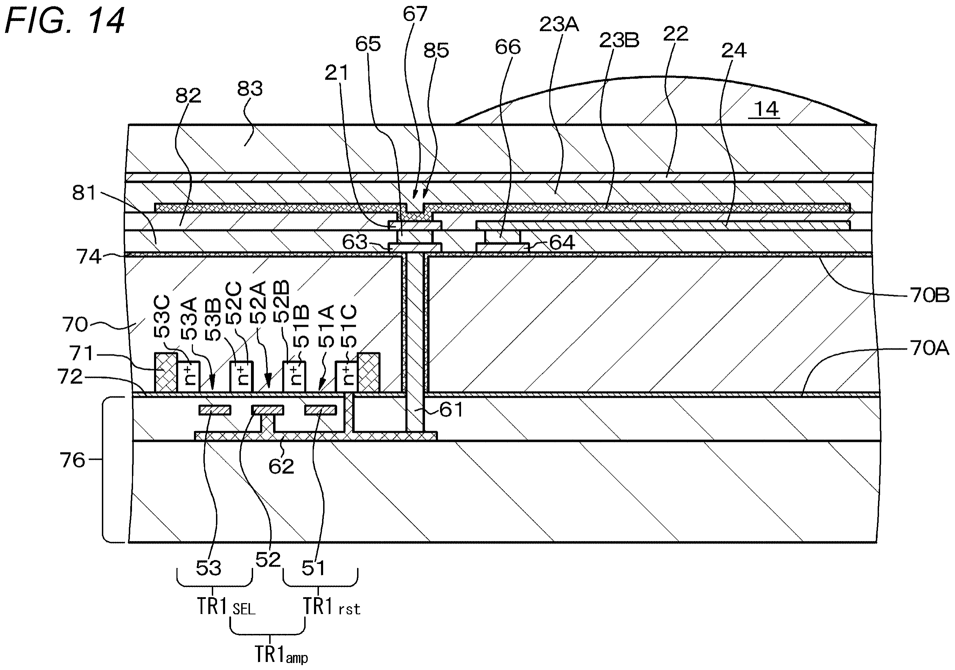

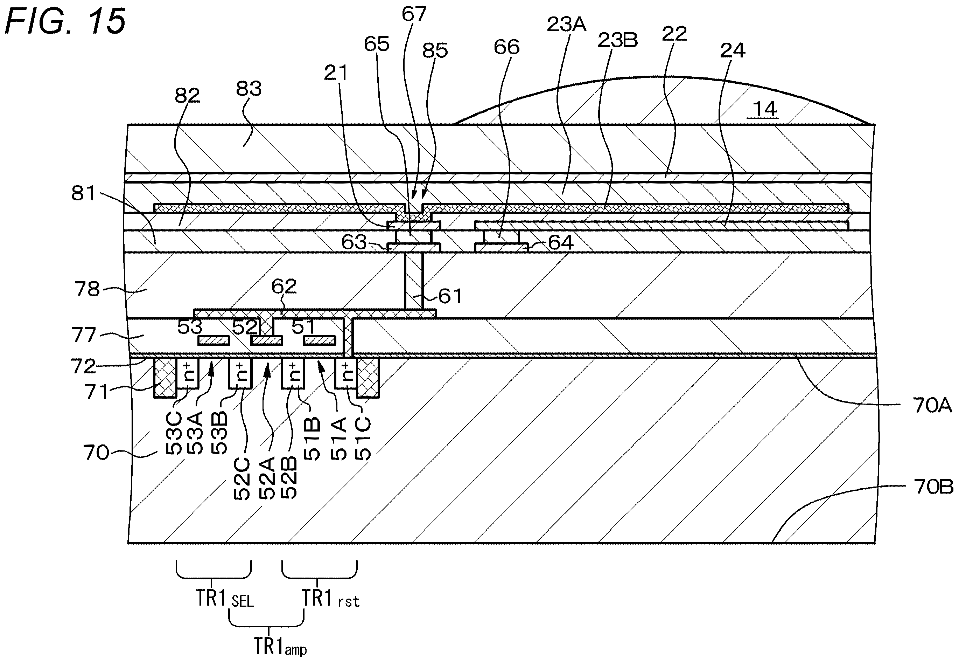

A modification of the imaging element of Example 3, illustrated in the schematic partial cross-sectional view of Fig. 14, is a backside irradiation type imaging element, and is constituted by the first type first imaging element of Example 1. Furthermore, a modification of the imaging element of Example 3, illustrated in the schematic partial cross-sectional view of Fig. 15, is a frontside irradiation type imaging element, and is constituted by the first type first imaging element of Example 1. Here, the first imaging element is constituted by three types of imaging elements of an imaging element that absorbs red light, an imaging element that absorbs green light, and an imaging element that absorbs blue light. Moreover, the solid-state imaging device according to the first aspect of the present disclosure is constituted by a plurality of these imaging elements. As an arrangement of the plurality of imaging elements, a Bayer array can be cited. On the light incident side of each imaging element, a color filter layer for performing blue, green, and red spectroscopy is disposed as necessary.

Instead of disposing one first type photoelectric conversion unit including the charge accumulation electrode of Example 1, a form can be adopted in which two first type photoelectric conversion units are laminated (that is, a form in which two photoelectric conversion units each including the charge accumulation electrode are laminated, and a control unit for the two photoelectric conversion units is disposed on a semiconductor substrate), or a form can be adopted in which three first type photoelectric conversion units are laminated (that is, a form in which three photoelectric conversion units each including the charge accumulation electrode are laminated, and a control unit for the three photoelectric conversion units is disposed on a semiconductor substrate). Examples of the laminated structure of the first type imaging element and the second type imaging element are illustrated in the following table.

| | First type | Second type |
|---|---|---|
| | 1 Green | 2 Blue + Red |
| | 1 Primary color | 1 Complementary color |
| | 1 White | 1 Infrared light |
| | 1 Blue, Green, or Red | 0 |
| Backside irradiation type and Frontside irradiation type | 2 Green + Infrared Light | 2 Blue + Red |
| | 2 Green + Blue | 1 Red |
| | 2 White + Infrared light | 0 |
| | 3 Green + Blue + Red | 2 Blue Green (Emerald color) + Infrared light |
| | 3 Green + Blue + Red | 1 Infrared light |
| | 3 Blue + Green + Red | 0 |

[Example 4]

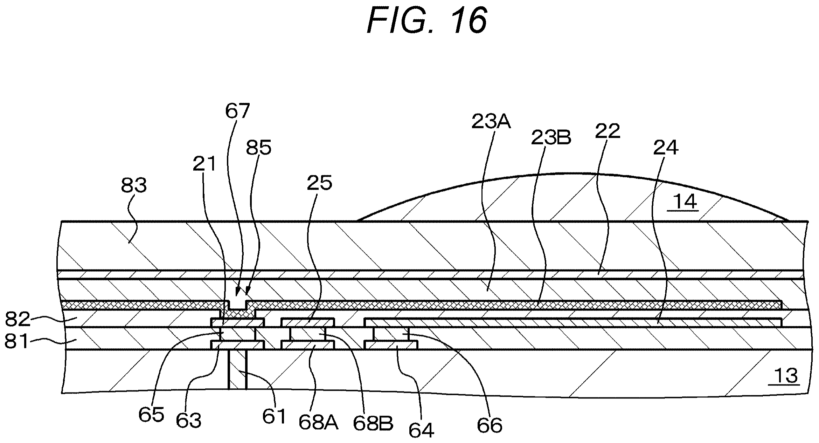

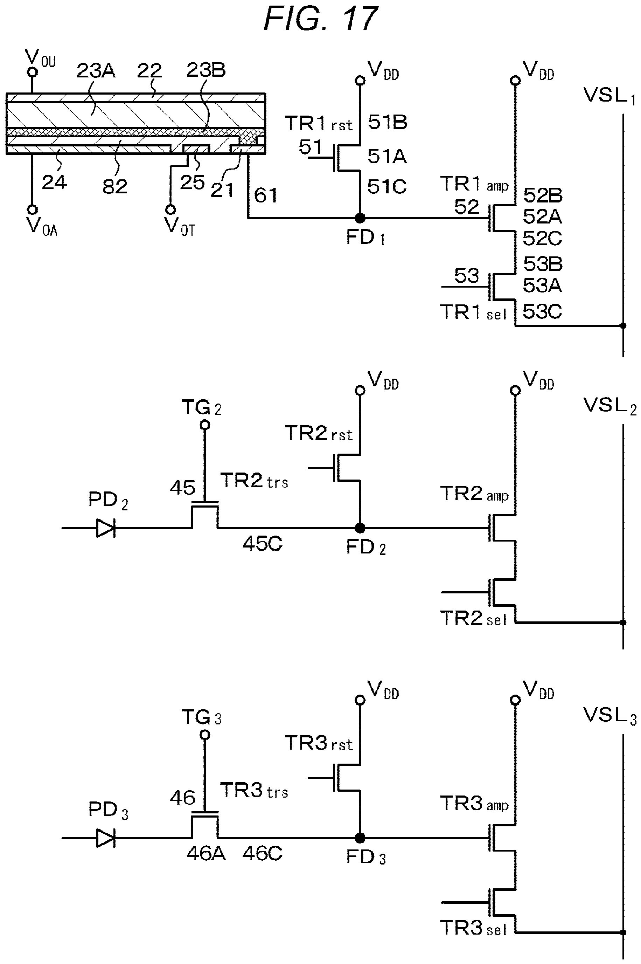

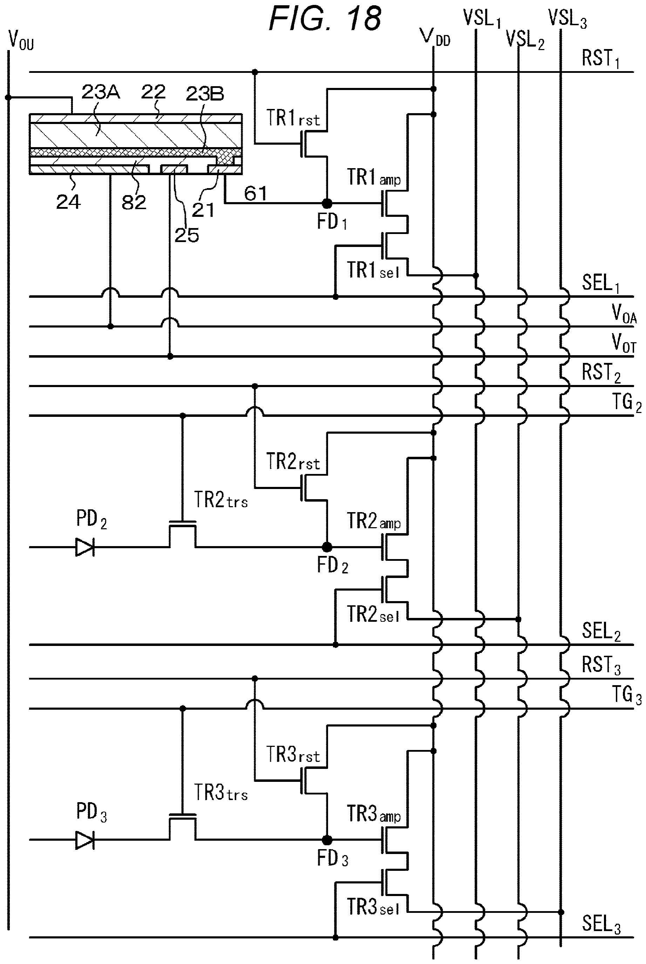

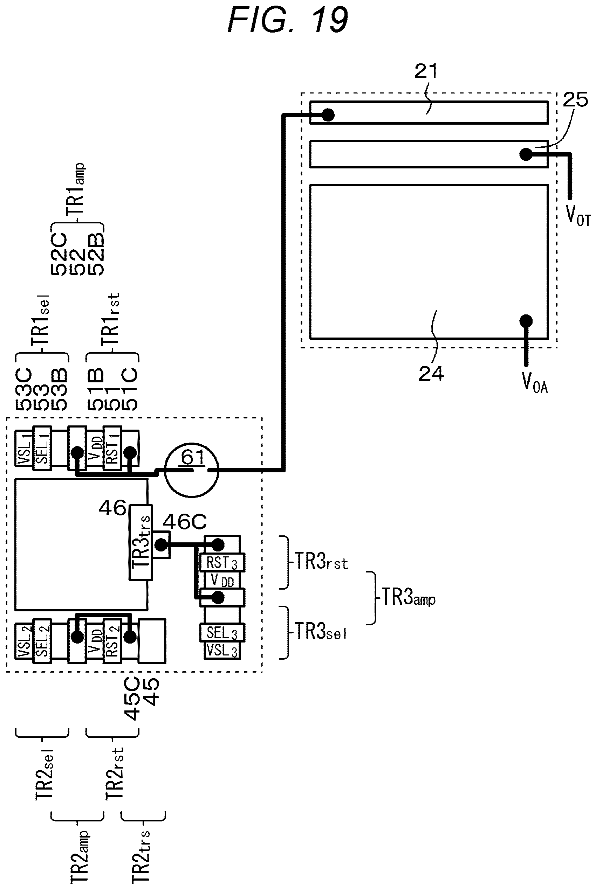

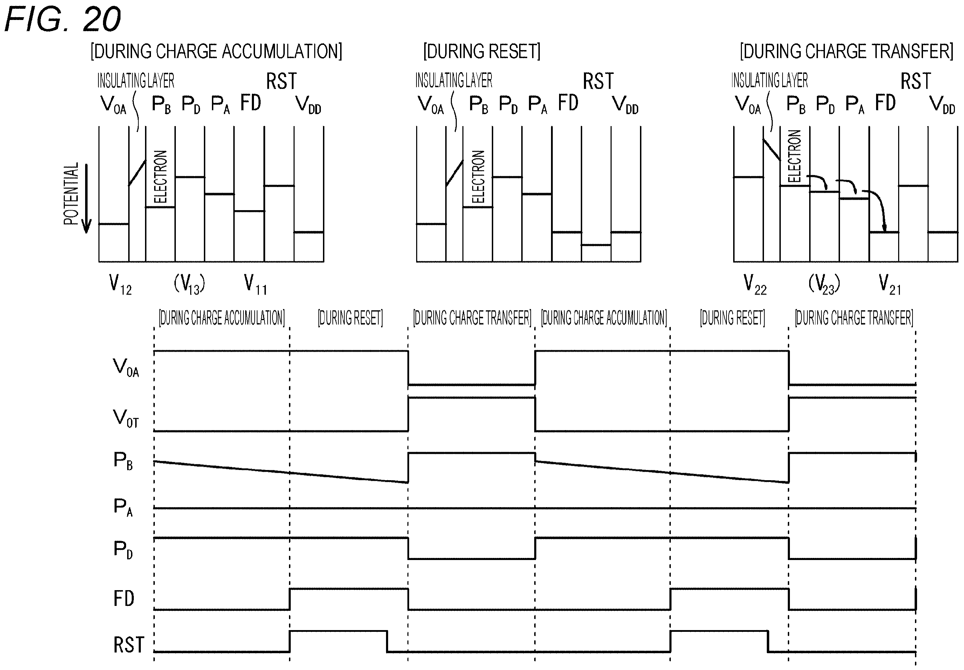

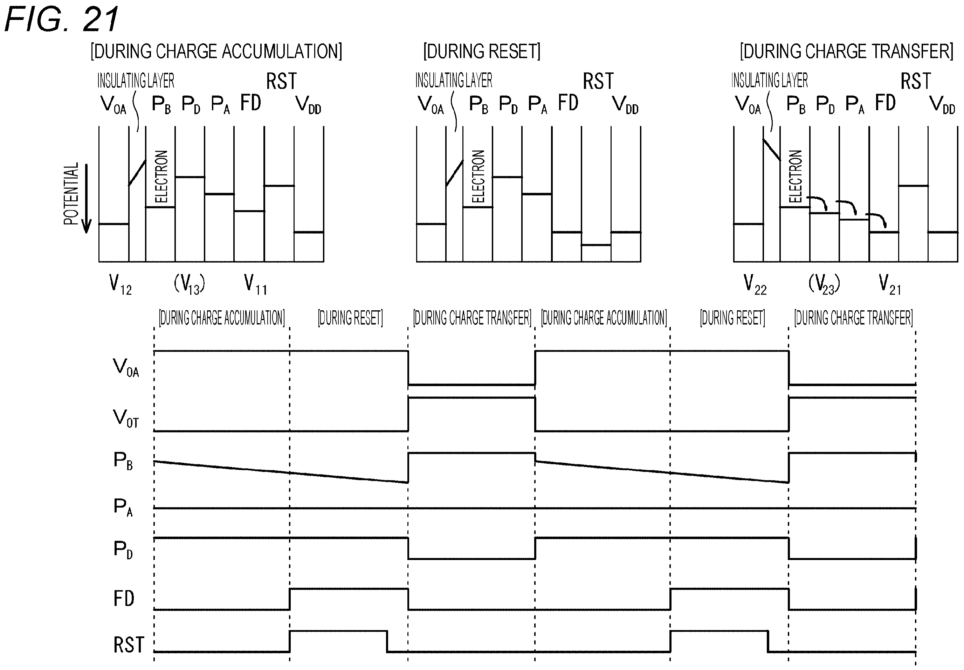

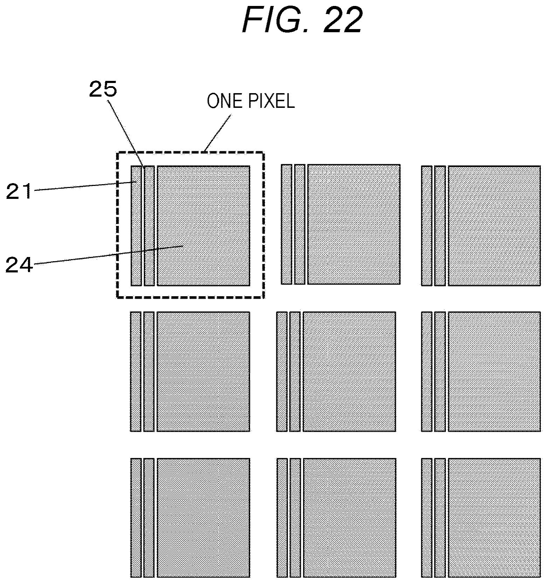

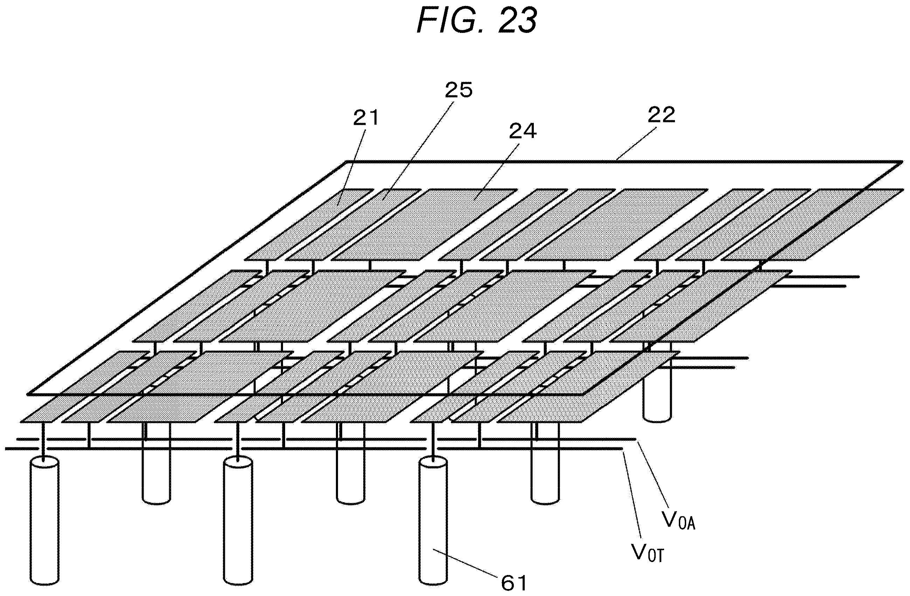

Example 4 is a modification of Examples 1 to 3, and relates to an imaging element and the like of the present disclosure including a transfer control electrode (charge transfer electrode). Fig. 16 illustrates a schematic partial cross-sectional view of a part of the imaging element of Example 4. Figs. 17 and 18 illustrate an equivalent circuit diagram of the imaging element of Example 4. Fig. 19 illustrates a schematic arrangement diagram of a first electrode, a transfer control electrode, and a charge accumulation electrode constituting a photoelectric conversion unit of the imaging element of Example 4, and a transistor constituting a control unit. Figs. 20 and 21 schematically illustrate a potential state in each part during operation of the imaging element of Example 4. Fig. 6B illustrates an equivalent circuit diagram for explaining each part of the imaging element of Example 4. Furthermore, Fig. 22 illustrates a schematic arrangement diagram of the first electrode, the transfer control electrode, and the charge accumulation electrode constituting the photoelectric conversion unit of the imaging element of Example 4. Fig. 23 illustrates a schematic perspective view of the first electrode, the transfer control electrode, the charge accumulation electrode, the second electrode, and the contact hole portion.

The imaging element of Example 4 further includes the transfer control electrode (charge transfer electrode) 25 disposed apart from the first electrode 21 and the charge accumulation electrode 24 so as to face the inorganic oxide semiconductor material layer 23B via the insulating layer 82 between the first electrode 21 and the charge accumulation electrode 24. The transfer control electrode 25 is connected to a pixel drive circuit constituting a drive circuit via a connection hole 68B, a pad portion 68A, and wiring $V_{OT}$ formed in the interlayer insulating layer 81. Note that in Figs. 16, 25, 28, 67, 71, and 73, various imaging element components located below the interlayer insulating layer 81 are collectively denoted by reference numeral 13 for convenience in order to simplify the drawings.

Hereinafter, with reference to Figs. 20 and 21, operation of the imaging element (first imaging element) of Example 4 will be described. Note that a value of the potential applied to the charge accumulation electrode 24 and a value of the potential at the point $P_D$ are particularly different between Figs. 20 and 21.

In a charge accumulation period, the potential $V_{11}$ is applied to the first electrode 21, the potential $V_{12}$ is applied to the charge accumulation electrode 24, and the potential $V_{13}$ is applied to the transfer control electrode 25 from a drive circuit. Photoelectric conversion occurs in the photoelectric conversion layer 23A by light incident on the photoelectric conversion layer 23A. Holes generated by the photoelectric conversion are sent from the second electrode 22 to a drive circuit via the wiring $V_{OU}$. Meanwhile, the potential of the first electrode 21 is set to be higher than the potential of the second electrode 22, that is, for example, a positive potential is applied to the first electrode 21, and a negative potential is applied to the second electrode 22. Therefore, $V_{12} > V_{13}$ (for example, $V_{12} > V_{11} > V_{13}$ or $V_{11} > V_{12} > V_{13}$) is satisfied. As a result, electrons generated by the photoelectric conversion are attracted to the charge accumulation electrode 24 and stop in a region of the inorganic oxide semiconductor material layer 23B and the like facing the charge accumulation electrode 24. That is, charges are accumulated in the inorganic oxide semiconductor material layer 23B and the like. Since $V_{12} > V_{13}$ is satisfied, transfer of electrons generated inside the photoelectric conversion layer 23A toward the first electrode 21 can be prevented reliably. As the time for the photoelectric conversion elapses, the potential in the region of the inorganic oxide semiconductor material layer 23B and the like facing the charge accumulation electrode 24 becomes a more negative value.

In a later stage of the charge accumulation period, a reset operation is performed. As a result, the potential of the first floating diffusion layer $FD_1$ is reset, and the potential of the first floating diffusion layer $FD_1$ becomes the potential $V_{DD}$ of the power source.

After the reset operation is completed, charges are read out. That is, in a charge transfer period, the potential $V_{21}$ is applied to the first electrode 21, the potential $V_{22}$ is applied to the charge accumulation electrode 24, and the potential $V_{23}$ is applied to the transfer control electrode 25 from a drive circuit. Here, $V_{22} \geq V_{23} \geq V_{21}$ (preferably $V_{22} < V_{23} < V_{21}$) is satisfied. In a case where the potential $V_{13}$ is applied to the transfer control electrode 25, it is only required to satisfy $V_{22} \geq V_{13} \leq V_{21}$ (preferably $V_{22} < V_{13} < V_{21}$). As a result, electrons that have stopped in the region of the inorganic oxide semiconductor material layer 23B and the like facing the charge accumulation electrode 24 are reliably read out to the first electrode 21 and further to the first floating diffusion layer $FD_1$. That is, the charges accumulated in the inorganic oxide semiconductor material layer 23B and the like are read out to the control unit.

In this way, a series of operations including charge accumulation, reset operation, and charge transfer are completed.

The operations of the amplification transistor $TR1_{amp}$ and the selection transistor $TR1_{sel}$ after electrons are read out to the first floating diffusion layer $FD_1$ are the same as the conventional operations of these transistors. Furthermore, for example, a series of operations including charge accumulation, reset operation, and charge transfer of the second imaging element and the third imaging element are similar to a conventional series of operations including charge accumulation, reset operation, and charge transfer.

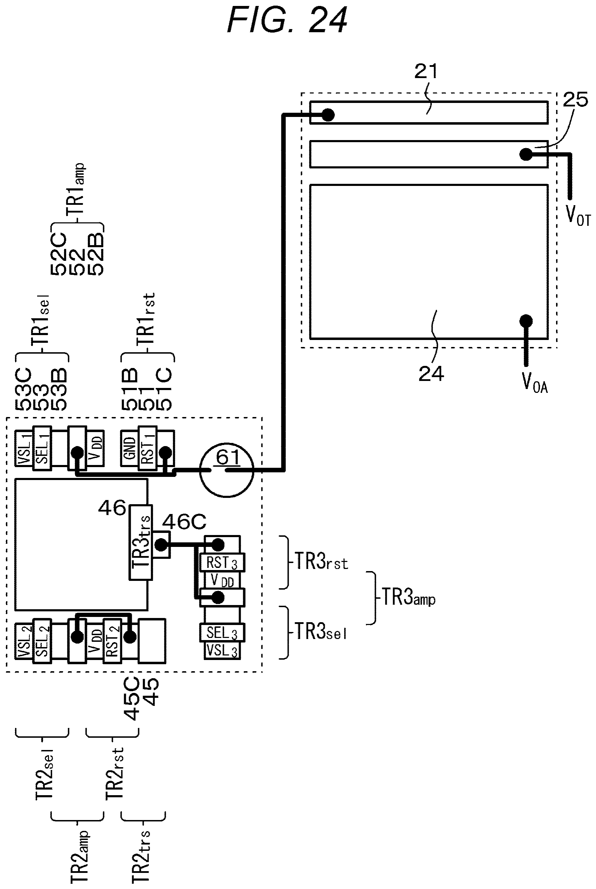

As Fig. 24 illustrates a schematic arrangement diagram of the first electrode and the charge accumulation electrode constituting a modification of the imaging element of Example 4, and a transistor constituting the control unit, the other source/drain region 51B of the reset transistor $TR1_{rst}$ may be grounded instead of being connected to the power source $V_{DD}$.

[Example 5]

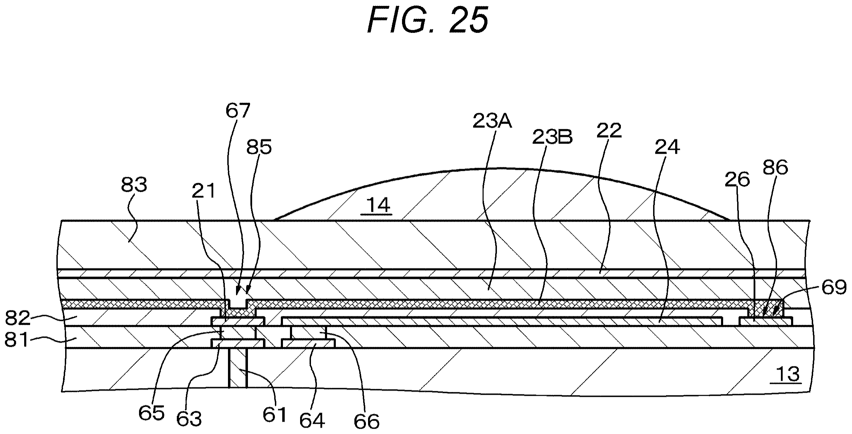

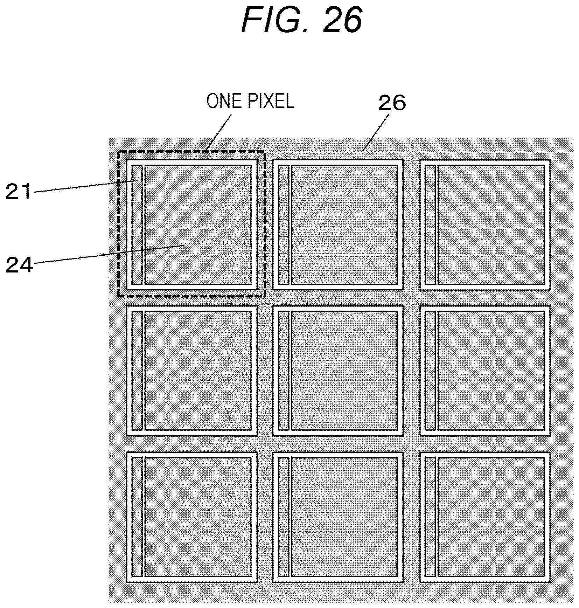

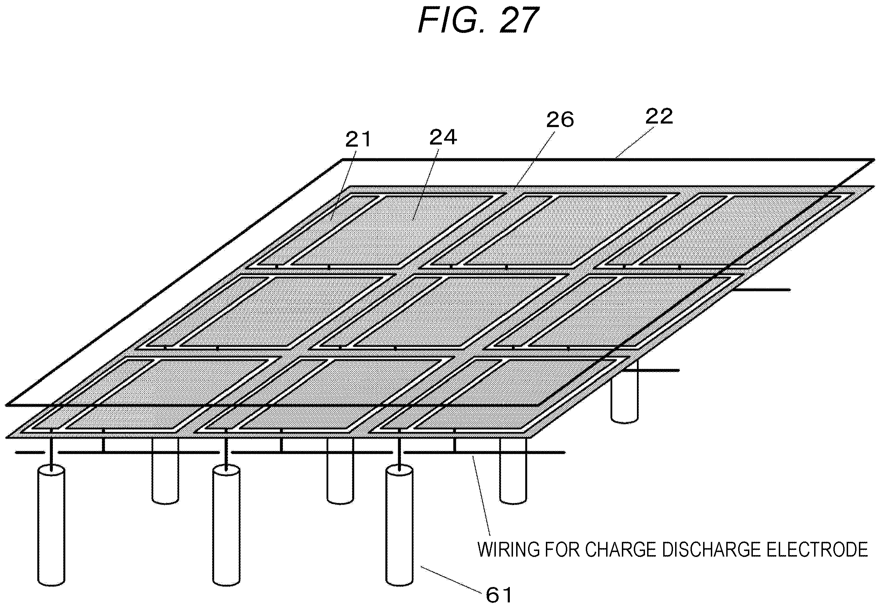

Example 5 is a modification of Examples 1 to 4, and relates to an imaging element and the like of the present disclosure including a charge discharge electrode. Fig. 25 illustrates a schematic partial cross-sectional view of a part of the imaging element of Example 5. Fig. 26 illustrates a schematic arrangement diagram of a first electrode, a charge accumulation electrode, and a charge discharge electrode constituting a photoelectric conversion unit including the charge accumulation electrode of the imaging element of Example 5. Fig. 27 illustrates a schematic perspective view of a first electrode, a charge accumulation electrode, a charge discharge electrode, a second electrode, and a contact hole portion.

The imaging element of Example 5 further include a charge discharge electrode 26 connected to the inorganic oxide semiconductor material layer 23B via the connection portion 69 and disposed apart from the first electrode 21 and the charge accumulation electrode 24. Here, the charge discharge electrode 26 is disposed so as to surround the first electrode 21 and the charge accumulation electrode 24 (that is, in a frame shape). The charge discharge electrode 26 is connected to a pixel drive circuit constituting a drive circuit. In the connection portion 69, the inorganic oxide semiconductor material layer 23B extends. That is, the inorganic oxide semiconductor material layer 23B extends in a second opening 86 formed in the insulating layer 82 to be connected to the charge discharge electrode 26. The charge discharge electrode 26 is shared by (common to) a plurality of imaging elements. The charge discharge electrode 26 can be used, for example, as a floating diffusion or an overflow drain of the photoelectric conversion unit.

In Example 5, in a charge accumulation period, the potential $V_{11}$ is applied to the first electrode 21, the potential $V_{12}$ is applied to the charge accumulation electrode 24, and the potential $V_{14}$ is applied to the charge discharge electrode 26 from a drive circuit, and charges are accumulated in the inorganic oxide semiconductor material layer 23B and the like. Photoelectric conversion occurs in the photoelectric conversion layer 23A by light incident on the photoelectric conversion layer 23A. Holes generated by the photoelectric conversion are sent from the second electrode 22 to a drive circuit via the wiring $V_{OU}$. Meanwhile, the potential of the first electrode 21 is set to be higher than the potential of the second electrode 22, that is, for example, a positive potential is applied to the first electrode 21, and a negative potential is applied to the second electrode 22. Therefore, $V_{14} > V_{11}$ (for example, $V_{12} > V_{14} > V_{11}$) is satisfied. As a result, electrons generated by the photoelectric conversion are attracted to the charge accumulation electrode 24 and stop in a region of the inorganic oxide semiconductor material layer 23B and the like facing the charge accumulation electrode 24. Transfer of the electrons toward the first electrode 21 can be prevented reliably. However, electrons that are not sufficiently attracted to the charge accumulation electrode 24 or cannot be accumulated in the inorganic oxide semiconductor material layer 23B and the like (so-called overflowed electrons) are sent to a drive circuit via the charge discharge electrode 26.

In a later stage of the charge accumulation period, a reset operation is performed. As a result, the potential of the first floating diffusion layer $FD_1$ is reset, and the potential of the first floating diffusion layer $FD_1$ becomes the potential $V_{DD}$ of the power source.

After the reset operation is completed, charges are read out. That is, in a charge transfer period, the potential $V_{21}$ is applied to the first electrode 21, the potential $V_{22}$ is applied to the charge accumulation electrode 24, and the potential $V_{24}$ is applied to the charge discharge electrode 26 from a drive circuit. Here, $V_{24} < V_{21}$ (for example, $V_{24} < V_{22} < V_{21}$) is satisfied. As a result, electrons that have stopped in the region of the inorganic oxide semiconductor material layer 23B and the like facing the charge accumulation electrode 24 are reliably read out to the first electrode 21 and further to the first floating diffusion layer $FD_1$. That is, the charges accumulated in the inorganic oxide semiconductor material layer 23B and the like are read out to the control unit.

In this way, a series of operations including charge accumulation, reset operation, and charge transfer are completed.

The operations of the amplification transistor $TR1_{amp}$ and the selection transistor $TR1_{sel}$ after electrons are read out to the first floating diffusion layer $FD_1$ are the same as the conventional operations of these transistors. Furthermore, for example, a series of operations including charge accumulation, reset operation, and charge transfer of the second imaging element and the third imaging element are similar to a conventional series of operations including charge accumulation, reset operation, and charge transfer.

In Example 5, so-called overflowed electrons are sent to a drive circuit via the charge discharge electrode 26. Therefore, leakage to a charge accumulation portion of an adjacent pixel can be suppressed, and occurrence of blooming can be suppressed. In addition, this can improve imaging performance of the imaging element.

[Example 6]

Example 6 is a modification of Examples 1 to 5, and relates to an imaging element and the like of the present disclosure including a plurality of charge accumulation electrode segments.

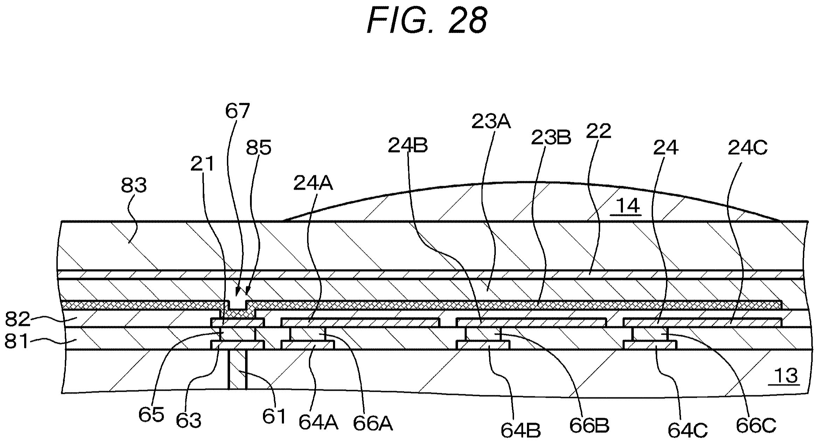

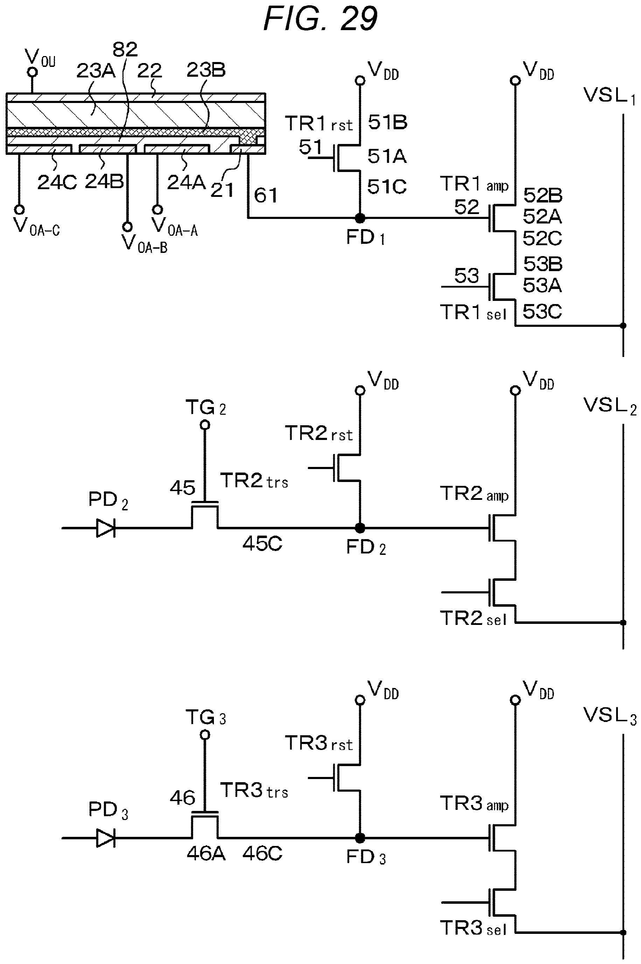

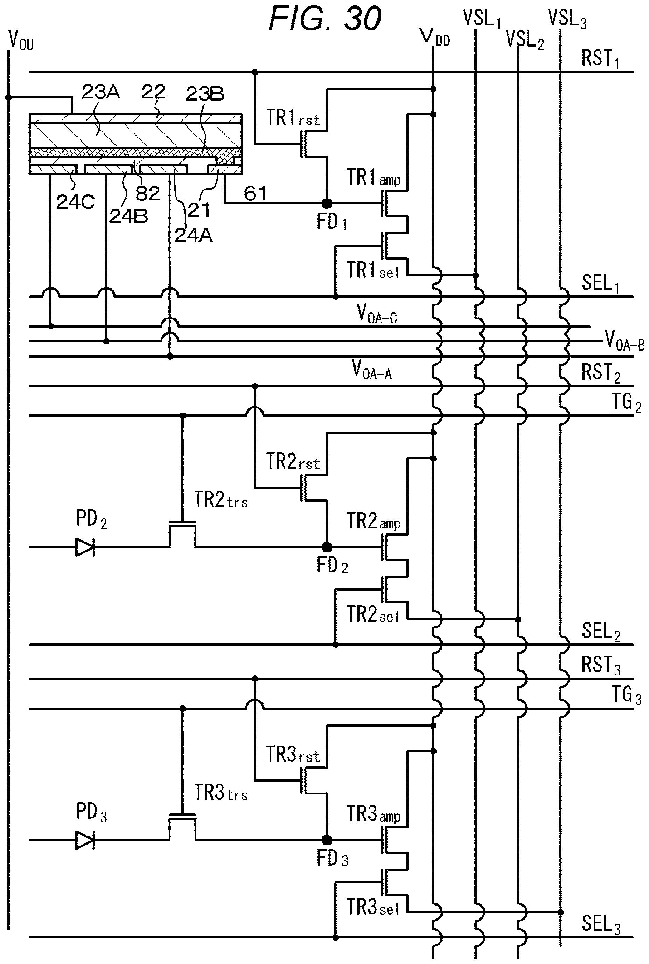

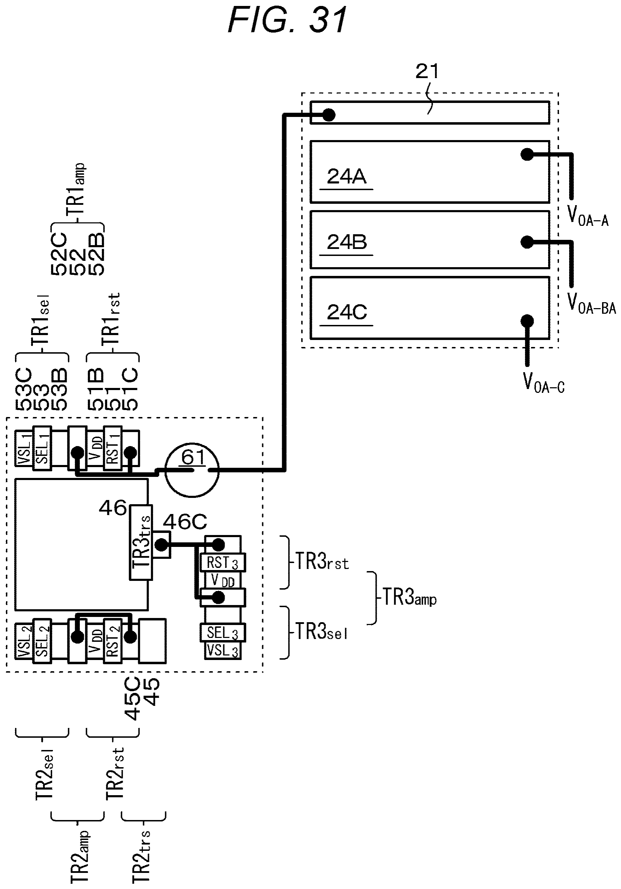

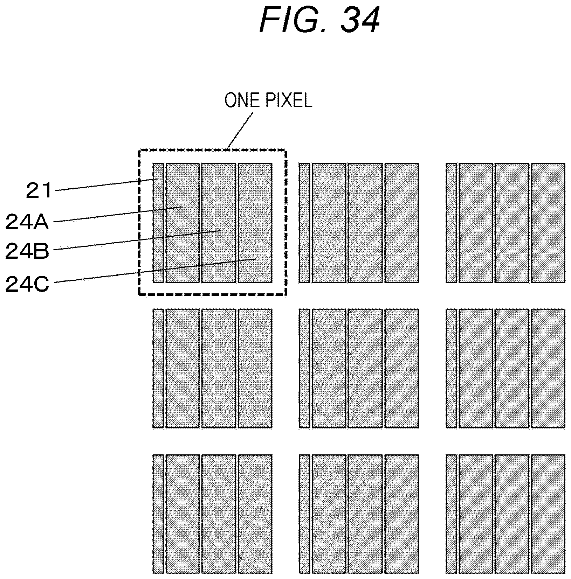

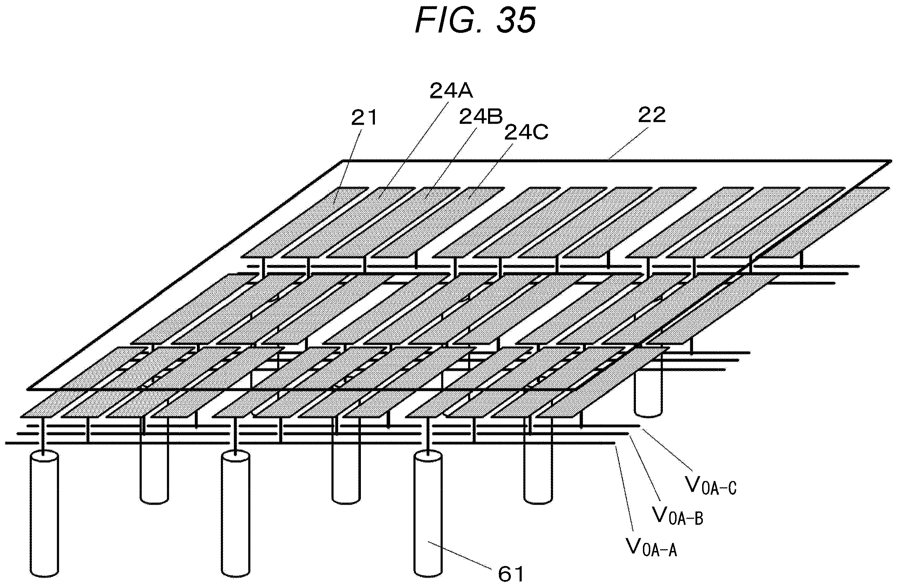

Fig. 28 illustrates a schematic partial cross-sectional view of a part of the imaging element of Example 6. Figs. 29 and 30 illustrate an equivalent circuit diagram of the imaging element of Example 6. Fig. 31 illustrates a schematic arrangement diagram of a first electrode and a charge accumulation electrode constituting a photoelectric conversion unit including a charge accumulation electrode of the imaging element of Example 6, and a transistor constituting a control unit. Figs. 32 and 33 schematically illustrate a potential state in each part during operation of the imaging element of Example 6. Fig. 6C illustrates an equivalent circuit diagram for explaining each part of the imaging element of Example 6. Furthermore, Fig. 34 illustrates a schematic arrangement diagram of the first electrode and the charge accumulation electrode constituting the photoelectric conversion unit including the charge accumulation electrode of the imaging element of Example 6. Fig. 35 illustrates a schematic perspective view of the first electrode, the charge accumulation electrode, a second electrode, and a contact hole portion.

In Example 6, the charge accumulation electrode 24 includes a plurality of charge accumulation electrode segments 24A, 24B, and 24C. The number of charge accumulation electrode segments only needs to be two or more, and is set to "three" in Example 6. In addition, in the imaging element of Example 6, the potential of the first electrode 21 is higher than the potential of the second electrode 22. Therefore, that is, for example, a positive potential is applied to the first electrode 21, and a negative potential is applied to the second electrode 22. In addition, in a charge transfer period, the potential applied to the charge accumulation electrode segment 24A located closest to the first electrode 21 is higher than the potential applied to the charge accumulation electrode segment 24C located farthest from the first electrode 21. In this way, by applying a potential gradient to the charge accumulation electrode 24, electrons that have stopped in the region of the inorganic oxide semiconductor material layer 23B and the like facing the charge accumulation electrode 24 are more reliably read out to the first electrode 21 and further to the first floating diffusion layer $FD_1$. That is, the charges accumulated in the inorganic oxide semiconductor material layer 23B and the like are read out to the control unit.

In the example illustrated in Fig. 32, in a charge transfer period, by satisfying the potential of the charge accumulation electrode segment 24C < the potential of the charge accumulation electrode segment 24B < the potential of the charge accumulation electrode segment 24A, electrons that have stopped in the region of the inorganic oxide semiconductor material layer 23B and the like are read out to the first floating diffusion layer $FD_1$ all at once. Meanwhile, in the example illustrated in Fig. 33, in a charge transfer period, by gradually changing the potential of the charge accumulation electrode segment 24C, the potential of the charge accumulation electrode segment 24B, and the potential of the charge accumulation electrode segment 24A (that is, by changing the potential of the charge accumulation electrode segment 24C, the potential of the charge accumulation electrode segment 24B, and the potential of the charge accumulation electrode segment 24A in a step shape or a slope shape), electrons that have stopped in the region of the inorganic oxide semiconductor material layer 23B and the like facing the charge accumulation electrode segment 24C are transferred to the region of the inorganic oxide semiconductor material layer 23B and the like facing the charge accumulation electrode segment 24B. Subsequently, electrons that have stopped in the region of the inorganic oxide semiconductor material layer 23B and the like facing the charge accumulation electrode segment 24B are transferred to the region of the inorganic oxide semiconductor material layer 23B and the like facing the charge accumulation electrode segment 24A. Subsequently, electrons that have stopped in the region of the inorganic oxide semiconductor material layer 23B and the like facing the charge accumulation electrode segment 24A are reliably read out to the first floating diffusion layer $FD_1$.

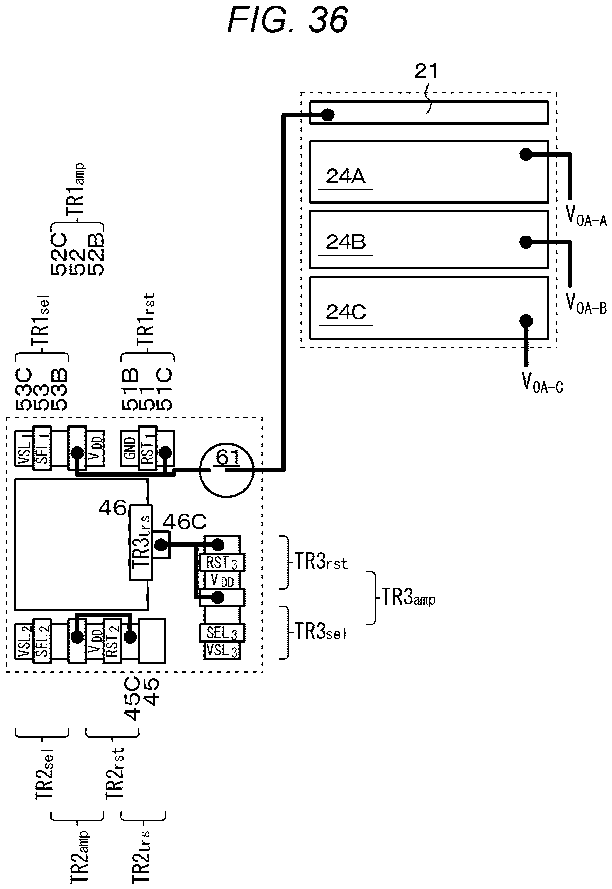

As Fig. 36 illustrates a schematic arrangement diagram of the first electrode and the charge accumulation electrode constituting a modification of the imaging element of Example 6, and a transistor constituting the control unit, the other source/drain region 51B of the reset transistor $TR1_{rst}$ may be grounded instead of being connected to the power source $V_{DD}$.

[Example 7]

Example 7 is a modification of Examples 1 to 6, and relates to the imaging elements of the first and sixth configurations.

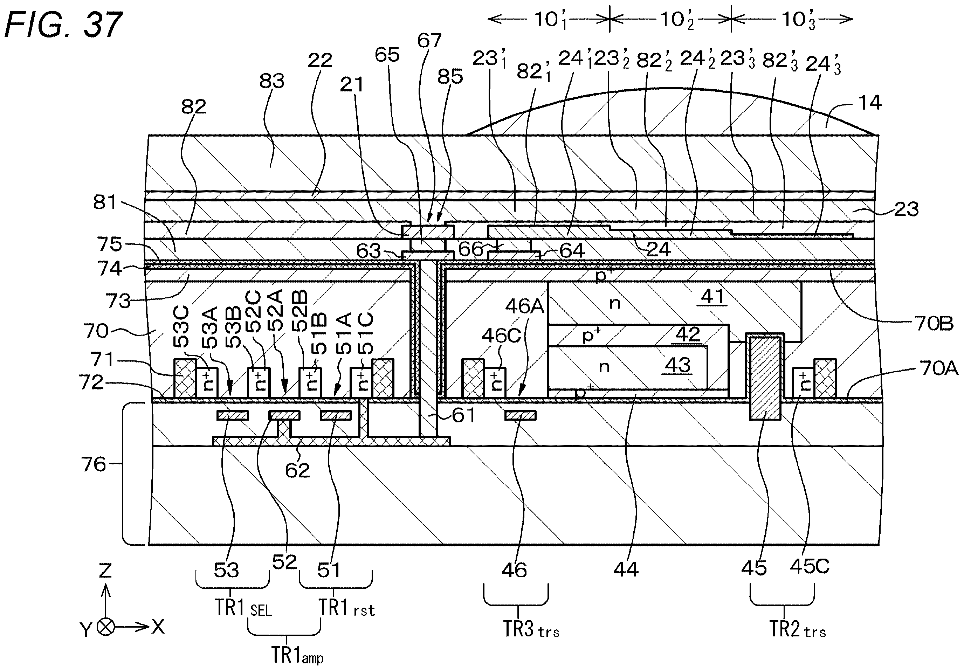

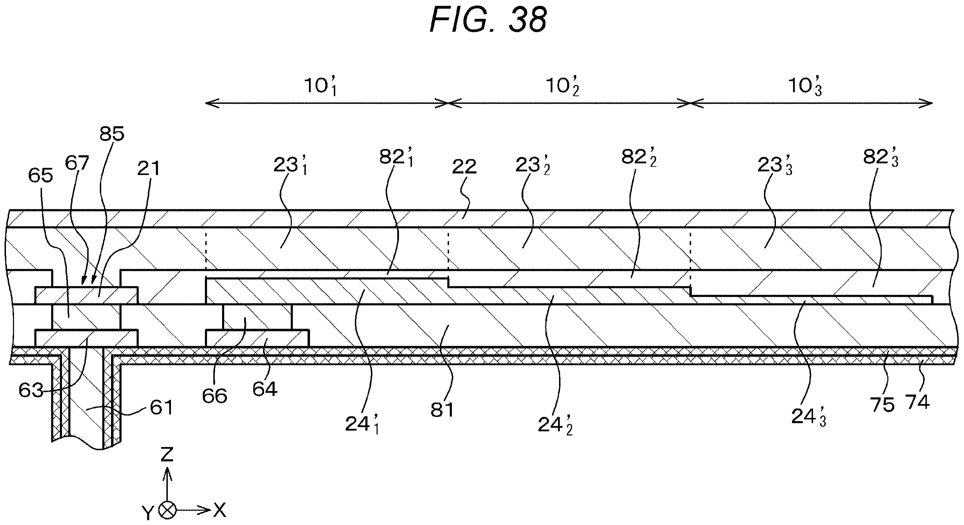

Fig. 37 illustrates a schematic partial cross-sectional view of the imaging element of Example 7. Fig. 38 illustrates a schematic partial cross-sectional view obtained by enlarging a portion where a charge accumulation electrode, an inorganic oxide semiconductor material layer, a photoelectric conversion layer, and a second electrode are laminated. The equivalent circuit diagram of the imaging element of Example 7 is similar to the equivalent circuit diagram of the imaging element of Example 1 described in Figs. 2 and 3. The schematic arrangement diagram of the first electrode and the charge accumulation electrode constituting the photoelectric conversion unit including the charge accumulation electrode of the imaging element of Example 7 and a transistor constituting a control unit is similar to that of the imaging element of Example 1 described in Fig. 4. Moreover, the operation of the imaging element (first imaging element) of Example 7 is substantially similar to the operation of the imaging element of Example 1.

Here, in the imaging element of Example 7 or the imaging elements of Examples 8 to 12 described later,

the photoelectric conversion unit includes N (where $N \geq 2$) photoelectric conversion unit segments (specifically, three photoelectric conversion unit segments $10'_1$, $10'_2$, and $10'_3$),
the inorganic oxide semiconductor material layer 23B and the photoelectric conversion layer 23A include N photoelectric conversion layer segments (specifically, three photoelectric conversion layer segments $23'_1$, $23'_2$, and $23'_3$),
the insulating layer 82 includes N insulating layer segments (specifically, three insulating layer segments $82'_1$, $82'_2$, and $82'_3$),
in Examples 7 to 9, the charge accumulation electrode 24 includes N charge accumulation electrode segments (specifically, three charge accumulation electrode segments $24'_1$, $24'_2$, and $24'_3$ in each of the Examples),
in Examples 10 and 11, in some cases, in Example 9, the charge accumulation electrode 24 includes N charge accumulation electrode segments (specifically, three charge accumulation electrode segments $24'_1$, $24'_2$, and $24'_3$) disposed apart from one another,
the n-th (where n = 1, 2, 3... N) photoelectric conversion unit segment $10'_n$ includes the n-th charge accumulation electrode segment $24'_n$, the n-th insulating layer segment $82'_n$, and the n-th photoelectric conversion layer segment $23'_n$, and
a photoelectric conversion unit segment with a larger value of n is located farther from the first electrode 21. Here, the photoelectric conversion layer segments $23'_1$, $23'_2$, and $23'_3$ indicate segments formed by laminating the inorganic oxide semiconductor material layer and the photoelectric conversion layer, and are expressed by one layer in the drawings for simplifying the drawings. This also applies to the following.

Note that in a photoelectric conversion layer segment, the thickness of the photoelectric conversion layer segment may be changed by changing the thickness of the photoelectric conversion layer portion and keeping the thickness of the inorganic oxide semiconductor material layer portion constant. Furthermore, the thickness of the photoelectric conversion layer segment may be changed by keeping the thickness of the photoelectric conversion layer portion constant and changing the thickness of the inorganic oxide semiconductor material layer portion. Furthermore, the thickness of the photoelectric conversion layer segment may be changed by changing the thickness of the photoelectric conversion layer portion and changing the thickness of the inorganic oxide semiconductor material layer portion.

Alternatively, the imaging element of Example 7 or the imaging elements of Examples 8 and 11 described later include,
a photoelectric conversion unit formed by laminating the first electrode 21, the inorganic oxide semiconductor material layer 23B, the photoelectric conversion layer 23A, and the second electrode 22.

The photoelectric conversion unit further includes the charge accumulation electrode 24 disposed apart from the first electrode 21 so as to face the inorganic oxide semiconductor material layer 23B via the insulating layer 82.

If a lamination direction of the charge accumulation electrode 24, the insulating layer 82, the inorganic oxide semiconductor material layer 23B, and the photoelectric conversion layer 23A is defined as a Z direction, and a direction of separating from the first electrode 21 is defined as an X direction, when a laminated portion where the charge accumulation electrode 24, the insulating layer 82, the inorganic oxide semiconductor material layer 23B, and the photoelectric conversion layer 23A are laminated is cut with a YZ virtual plane, the cross-sectional area of the laminated portion changes depending on a distance from the first electrode.

Moreover, in the imaging element of Example 7, the thickness of an insulating layer segment gradually changes from the first photoelectric conversion unit segment $10'_1$ to the N-th photoelectric conversion unit segment $10'N$. Specifically, the thickness of an insulating layer segment gradually increases. Alternatively, in the imaging element of Example 7, the width of the cross section of the laminated portion is constant, and the thickness of the cross section of the laminated portion, specifically, the thickness of an insulating layer segment gradually increases depending on a distance from the first electrode 21. Note that the thickness of an insulating layer segment increases stepwise. The thickness of the insulating layer segment $82'_n$ in the n-th photoelectric conversion unit segment $10'_n$ is constant. When the thickness of the insulating layer segment $82'_n$ in the n-th photoelectric conversion unit segment $10'_n$ is "1", examples of the thickness of the insulating layer segment $82'_{(n+1)}$ in the (n + 1)-th photoelectric conversion unit segment $10'_{(n+1)}$ include 2 to 10, but are not limited to such values. In Example 7, by gradually reducing the thicknesses of the charge accumulation electrode segments $24'_1$, $24'_2$, and $24'_3$, the thicknesses of the insulating layer segments $82'_1$, $82'_2$, and $82'_3$ are gradually increased. The thicknesses of the photoelectric conversion layer segments $23'_1$, $23'_2$, and $23'_3$ are constant.

Hereinafter, the operation of the imaging element of Example 7 will be described.

In a charge accumulation period, the potential $V_{11}$ is applied to the first electrode 21 and the potential $V_{12}$ is applied to the charge accumulation electrode 24 from a drive circuit. Photoelectric conversion occurs in the photoelectric conversion layer 23A by light incident on the photoelectric conversion layer 23A. Holes generated by the photoelectric conversion are sent from the second electrode 22 to a drive circuit via the wiring $V_{OU}$. Meanwhile, the potential of the first electrode 21 is set to be higher than the potential of the second electrode 22, that is, for example, a positive potential is applied to the first electrode 21, and a negative potential is applied to the second electrode 22. Therefore, $V_{12} \geq V_{11}$ is satisfied, preferably $V_{12} > V_{11}$ is satisfied. As a result, electrons generated by the photoelectric conversion are attracted to the charge accumulation electrode 24 and stop in a region of the inorganic oxide semiconductor material layer 23B and the like facing the charge accumulation electrode 24. That is, charges are accumulated in the inorganic oxide semiconductor material layer 23B and the like. Since $V_{12} > V_{11}$ is satisfied, electrons generated inside the photoelectric conversion layer 23A are not transferred toward the first electrode 21. As the time for the photoelectric conversion elapses, the potential in the region of the inorganic oxide semiconductor material layer 23B and the like facing the charge accumulation electrode 24 becomes a more negative value.

In the imaging element of Example 7, the configuration is adopted in which the thickness of an insulating layer segment gradually increases. Therefore, when a state of $V_{12} \geq V_{11}$ is reached in a charge accumulation period, the n-th photoelectric conversion unit segment $10'_n$ can accumulate more charges than the (n + 1)-th photoelectric conversion unit segment $10'_{(n+1)}$, a stronger electric field is applied to the n-th photoelectric conversion unit segment $10'_n$ than to the (n + 1)-th photoelectric conversion unit segment $10'_{(n+1)}$, and a flow of charges from the first photoelectric conversion unit segment $10'_1$ to the first electrode 21 can be reliably prevented.

In a later stage of the charge accumulation period, a reset operation is performed. As a result, the potential of the first floating diffusion layer $FD_1$ is reset, and the potential of the first floating diffusion layer $FD_1$ becomes the potential $V_{DD}$ of the power source.

After the reset operation is completed, charges are read out. That is, in a charge transfer period, the potential $V_{21}$ is applied to the first electrode 21 and the potential $V_{22}$ is applied to the charge accumulation electrode 24 from a

drive circuit. Here, $V_{21} > V_{22}$ is satisfied. As a result, electrons that have stopped in the region of the inorganic oxide semiconductor material layer 23B and the like facing the charge accumulation electrode 24 are read out to the first electrode 21 and further to the first floating diffusion layer $FD_1$. That is, the charges accumulated in the inorganic oxide semiconductor material layer 23B and the like are read out to the control unit.

More specifically, when a state of $V_{21} > V_{22}$ is reached in a charge transfer period, a flow of charges from the first photoelectric conversion unit segment $10'_1$ to the first electrode 21, and a flow of charges from the (n + 1)-th photoelectric conversion unit segment $10'_{(n+1)}$ to the n-th photoelectric conversion unit segment $10'_n$ can be reliably ensured.

In this way, a series of operations including charge accumulation, reset operation, and charge transfer are completed.

In the imaging element of Example 7, the thickness of an insulating layer segment gradually changes from the first photoelectric conversion unit segment to the N-th photoelectric conversion unit segment. Alternatively, when a laminated portion where the charge accumulation electrode, the insulating layer, the inorganic oxide semiconductor material layer, and the photoelectric conversion layer are laminated is cut with a YZ virtual plane, the cross-sectional area of the laminated portion changes depending on a distance from the first electrode. Therefore, a kind of charge transfer gradient is formed, and charges generated by photoelectric conversion can be transferred more easily and reliably.

Since the imaging element of Example 7 can be manufactured by a substantially similar method to the imaging element of Example 1, detailed description thereof is omitted.

Note that in the imaging element of Example 7, in formation of the first electrode 21, the charge accumulation electrode 24, and the insulating layer 82, first, a conductive material layer for forming the charge accumulation electrode $24'_3$ is formed on the interlayer insulating layer 81. The conductive material layer is patterned to leave the conductive material layer in a region where the photoelectric conversion unit segments $10'_1$, $10'_2$, and $10'_3$ and the first electrode 21 are to be formed. Thus, a part of the first electrode 21 and the charge accumulation electrode $24'_3$ can be obtained. Next, an insulating layer for forming the insulating layer segment $82'_3$ is formed on the entire surface. The insulating layer is patterned and planarized to obtain the insulating layer segment $82'_3$. Next, a conductive material layer for forming the charge accumulation electrode $24'_2$ is formed on the entire surface. The conductive material layer is patterned to leave the conductive material layer in a region where the photoelectric conversion unit segments $10'_1$ and $10'_2$ and the first electrode 21 are to be formed. Thus, a part of the first electrode 21 and the charge accumulation electrode $24'_2$ can be obtained. Next, an insulating layer for forming the insulating layer segment $82'_2$ is formed on the entire surface. The insulating layer is patterned and planarized to obtain the insulating layer segment $82'_2$. Next, a conductive material layer for forming the charge accumulation electrode $24'_1$ is formed on the entire surface. The conductive material layer is patterned to leave the conductive material layer in a region where the photoelectric conversion unit segment $10'_1$ and the first electrode 21 are to be formed. Thus, the first electrode 21 and the charge accumulation electrode $24'_1$ can be obtained. Next, an insulating layer is formed on the entire surface. The insulating layer is planarized to obtain the insulating layer segment $82'_1$ (insulating layer 82). Then, the inorganic oxide semiconductor material layer 23B and the photoelectric conversion layer 23A are formed on the insulating layer 82. In this way, the photoelectric conversion unit segments $10'_1$, $10'_2$, and $10'_3$ can be obtained.

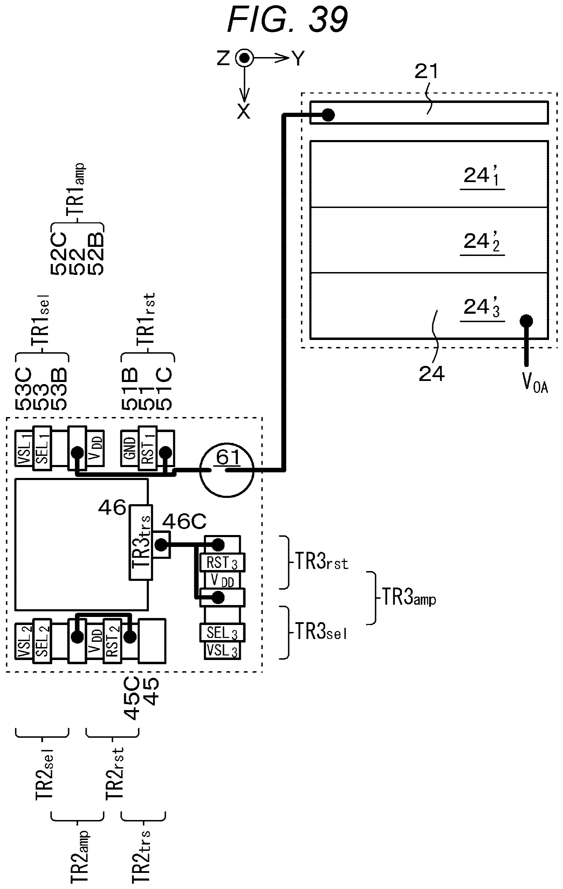

As Fig. 39 illustrates a schematic arrangement diagram of the first electrode and the charge accumulation electrode constituting a modification of the imaging element of Example 7, and a transistor constituting the control unit, the other source/drain region 51B of the reset transistor $TR1_{rst}$ may be grounded instead of being connected to the power source $V_{DD}$.

[Example 8]

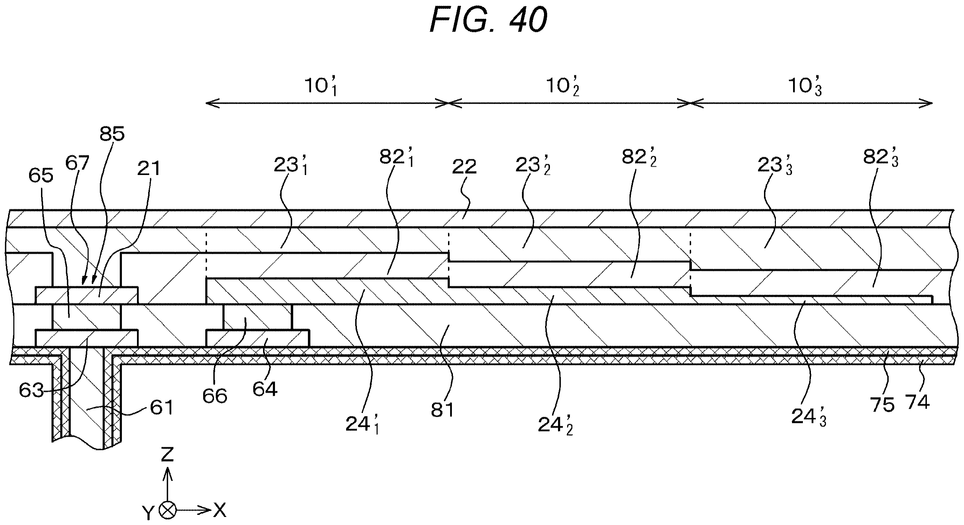

The imaging element of Example 8 relates to the imaging elements of the second and sixth configurations of the present disclosure. As Fig. 40 illustrates a schematic partial cross-sectional view in which a portion where the charge accumulation electrode, the inorganic oxide semiconductor material layer, the photoelectric conversion layer, and the second electrode are laminated is enlarged, in the imaging element of Example 8, the thickness of a photoelectric conversion layer segment gradually changes from the first photoelectric conversion unit segment $10'_1$ to the N-th photoelectric conversion unit segment 10'N. Alternatively, in the imaging element of Example 8, the width of the cross section of the laminated portion is constant, and the thickness of the cross section of the laminated portion, specifically, the thickness of a photoelectric conversion layer segment gradually increases depending on a distance from the first electrode 21. More specifically, the thickness of a photoelectric conversion layer segment gradually increases. Note that the thickness of a photoelectric conversion layer segment increases stepwise. The thickness of the photoelectric conversion layer segment $23'_n$ in the n-th photoelectric conversion unit segment $10'_n$ is constant. When the thickness of the photoelectric conversion layer segment $23'_n$ in the n-th photoelectric conversion unit segment $10'_n$ is "1", examples of the photoelectric conversion layer segment $23_{(n+1)}$ in the (n + 1)-th photoelectric conversion unit segment $10'_{(n+1)}$ include 2

to 10, but are not limited to such values. In Example 8, by gradually reducing the thicknesses of the charge accumulation electrode segments $24'_1$, $24'_2$, and $24'_3$, the thicknesses of the photoelectric conversion layer segments $23'_1$, $23'_2$, and $23'_3$ are gradually increased. The thicknesses of the insulating layer segments $82'_1$, $82'_2$, and $82'_3$ are constant. Furthermore, in a photoelectric conversion layer segment, it is only required to change the thickness of the photoelectric conversion layer segment, for example, by changing the thickness of the portion of the photoelectric conversion layer while the thickness of the portion of the inorganic oxide semiconductor material layer is constant.

In the imaging element of Example 8, the thickness of a photoelectric conversion layer segment gradually increases. Therefore, when a state of $V_{12} \geq V_{11}$ is reached in a charge accumulation period, a stronger electric field is applied to the n-th photoelectric conversion unit segment $10'_n$ than to the (n + 1)-th photoelectric conversion unit segment $10'_{(n+1)}$, and a flow of charges from the first photoelectric conversion unit segment $10'_1$ to the first electrode 21 can be reliably prevented. Then, when a state of $V_{22} < V_{21}$ is reached in a charge transfer period, a flow of charges from the first photoelectric conversion unit segment $10'_1$ to the first electrode 21, and a flow of charges from the (n + 1)-th photoelectric conversion unit segment $10'_{(n+1)}$ to the n-th photoelectric conversion unit segment $10'_n$ can be reliably ensured.

In this way, in the imaging element of Example 8, the thickness of a photoelectric conversion layer segment gradually changes from the first photoelectric conversion unit segment to the N-th photoelectric conversion unit segment. Alternatively, when a laminated portion where the charge accumulation electrode, the insulating layer, the inorganic oxide semiconductor material layer, and the photoelectric conversion layer are laminated is cut with a YZ virtual plane, the cross-sectional area of the laminated portion changes depending on a distance from the first electrode. Therefore, a kind of charge transfer gradient is formed, and charges generated by photoelectric conversion can be transferred more easily and reliably.

In the imaging element of Example 8, in formation of the first electrode 21, the charge accumulation electrode 24, the insulating layer 82, the inorganic oxide semiconductor material layer 23B, and the photoelectric conversion layer 23A, first, a conductive material layer for forming the charge accumulation electrode $24'_3$ is formed on the interlayer insulating layer 81. The conductive material layer is patterned to leave the conductive material layer in a region where the photoelectric conversion unit segments $10'_1$, $10'_2$, and $10'_3$ and the first electrode 21 are to be formed. Thus, a part of the first electrode 21 and the charge accumulation electrode $24'_3$ can be obtained. Subsequently, a conductive material layer for forming the charge accumulation electrode $24'_2$ is formed on the entire surface. The conductive material layer is patterned to leave the conductive material layer in a region where the photoelectric conversion unit segments $10'_1$ and $10'_2$ and the first electrode 21 are to be formed. Thus, a part of the first electrode 21 and the charge accumulation electrode $24'_2$ can be obtained. Subsequently, a conductive material layer for forming the charge accumulation electrode $24'_1$ is formed on the entire surface. The conductive material layer is patterned to leave the conductive material layer in a region where the photoelectric conversion unit segment $10'_1$ and the first electrode 21 are to be formed. Thus, the first electrode 21 and the charge accumulation electrode $24'_1$ can be obtained. Next, the insulating layer 82 is conformally formed on the entire surface. Then, the inorganic oxide semiconductor material layer 23B and the photoelectric conversion layer 23A are formed on the insulating layer 82, and the photoelectric conversion layer 23A is planarized. In this way, the photoelectric conversion unit segments $10'_1$, $10'_2$, and $10'_3$ can be obtained.

[Example 9]

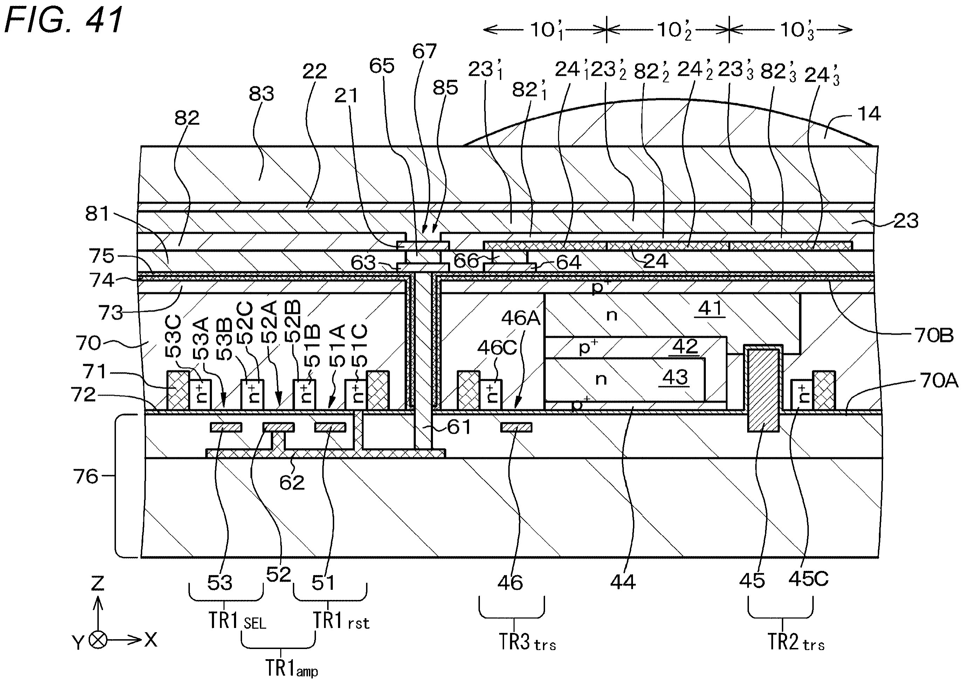

Example 9 relates to the imaging element of the third configuration. Fig. 41 illustrates a schematic partial cross-sectional view of the imaging element of Example 9. In the imaging element of Example 9, materials constituting an insulating layer segment are different between adjacent photoelectric conversion unit segments. Here, a value of the relative dielectric constant of a material constituting an insulating layer segment is gradually reduced from the first photoelectric conversion unit segment $10'_1$ to the N-th photoelectric conversion unit segment $10'_N$. In the imaging element of Example 9, the same potential may be applied to all the N charge accumulation electrode segments, or different potentials may be applied to the respective N charge accumulation electrode segments. In the latter case, as described in Example 10, the charge accumulation electrode segments $24'_1$, $24'_2$, and $24'_3$ disposed apart from one another only need to be connected to the vertical drive circuit 112 constituting a drive circuit via pad portions $64_1$, $64_2$, and $64_3$.

Then, by adopting such a configuration, a kind of charge transfer gradient is formed. In a charge accumulation period, when a state of $V_{12} \geq V_{11}$ is reached, the n-th photoelectric conversion unit segment can accumulate more charges than the (n + 1)-th photoelectric conversion unit segment. Then, when a state of $V_{22} < V_{21}$ is reached in a charge transfer period, a flow of charges from the first photoelectric conversion unit segment to the first electrode, and a flow of charges from the (n + 1)-th photoelectric conversion unit segment to the n-th photoelectric conversion unit segment can be reliably ensured.

[Example 10]

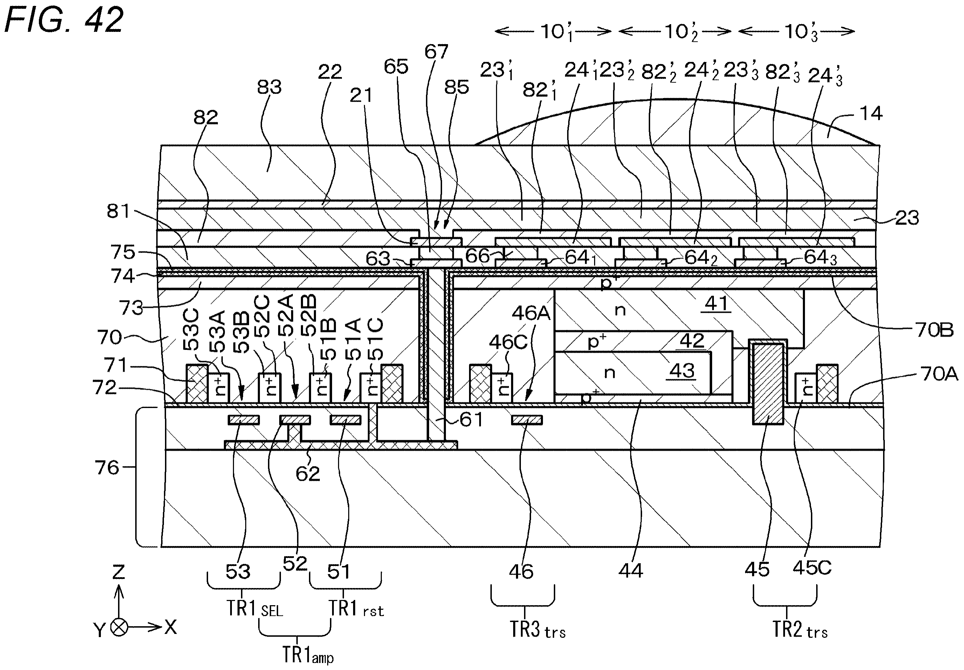

Example 10 relates to the imaging element of the fourth configuration. Fig. 42 illustrates a schematic partial cross-sectional view of the imaging element of Example 10. In the imaging element of Example 10, materials constituting a charge accumulation electrode segment are different between adjacent photoelectric conversion unit segments. Here, a value of work function of a material constituting an insulating layer segment is gradually increased from the first photoelectric conversion unit segment $10'_1$ to the N-th photoelectric conversion unit segment $10'_N$. In the imaging element of Example 10, the same potential may be applied to all the N charge accumulation electrode segments, or different potentials may be applied to the respective N charge accumulation electrode segments. In the latter case, the charge accumulation electrode segments $24'_1$, $24'_2$, and $24'_3$ are connected to the vertical drive circuit 112 constituting a drive circuit via pad portions $64_1$, $64_2$, and $64_3$.

[Example 11]

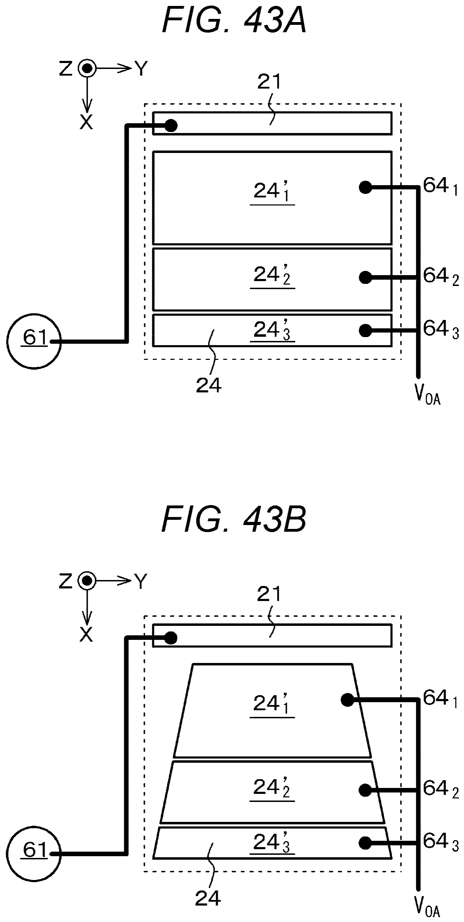

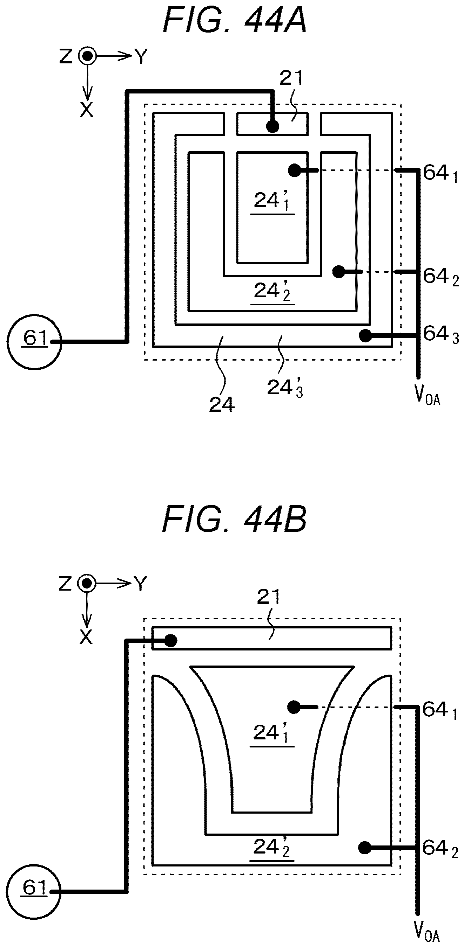

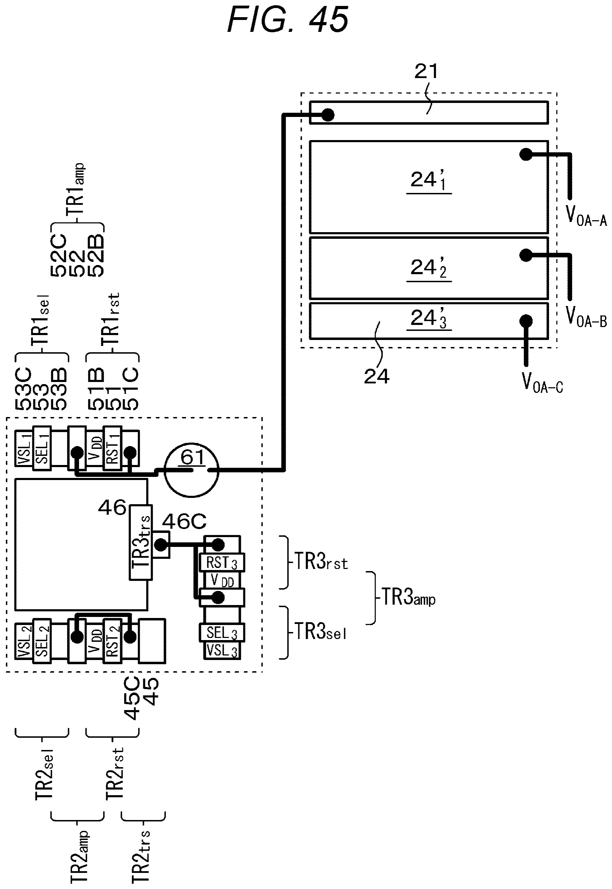

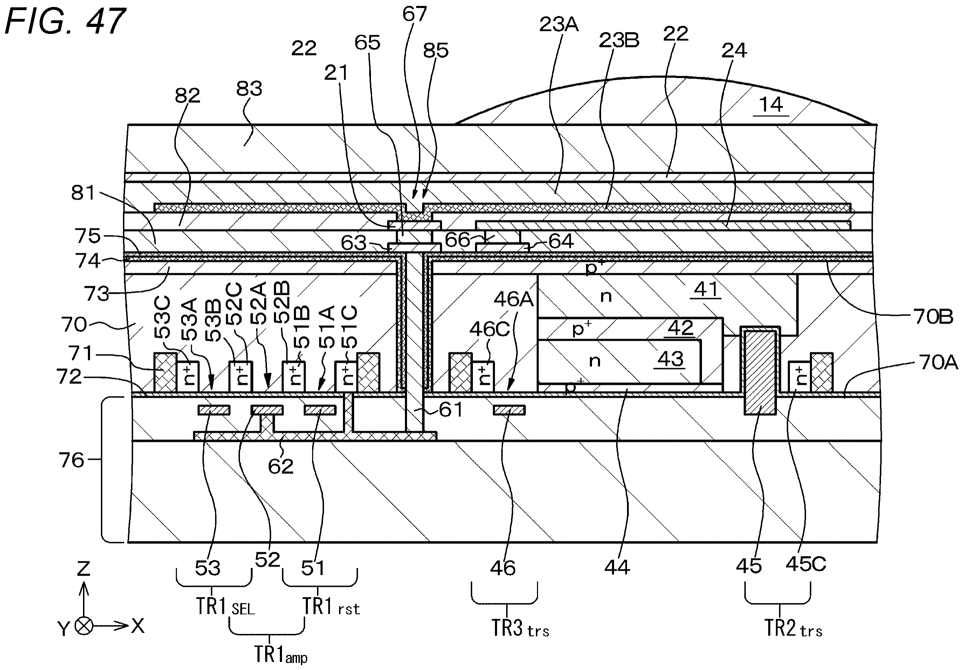

The imaging element of Example 11 relates to the imaging element of the fifth configuration. Figs. 43A, 43B, 44A, and 44B illustrate schematic plan views of a charge accumulation electrode segment in Example 11. Fig. 45 illustrates a schematic arrangement diagram of the first electrode and the charge accumulation electrode constituting the photoelectric conversion unit including the charge accumulation electrode of the imaging element of Example 11, and a transistor constituting the control unit. A schematic partial cross-sectional view of the imaging element of Example 11 is similar to that illustrated in Fig. 42 or 47. In the imaging element of Example 11, the area of the charge accumulation electrode segment is gradually reduced from the first photoelectric conversion unit segment $10'_1$ to the N-th photoelectric conversion unit segment $10'_N$. In the imaging element of Example 11, the same potential may be applied to all the N charge accumulation electrode segments, or different potentials may be applied to the respective N charge accumulation electrode segments. Specifically, as described in Example 10, the charge accumulation electrode segments $24'_1$, $24'_2$, and $24'_3$ disposed apart from one another only need to be connected to the vertical drive circuit 112 constituting a drive circuit via pad portions $64_1$, $64_2$, and $64_3$.

In Example 11, the charge accumulation electrode 24 includes a plurality of charge accumulation electrode segments $24'_1$, $24'_2$, and $24'_3$. The number of charge accumulation electrode segments only needs to be two or more, and is set to "three" in Example 11. In addition, in the imaging element of Example 11, the potential of the first electrode 21 is higher than the potential of the second electrode 22. Therefore, that is, for example, a positive potential is applied to the first electrode 21, and a negative potential is applied to the second electrode 22. Therefore, in a charge transfer period, the potential applied to the charge accumulation electrode segment $24'_1$ located closest to the first electrode 21 is higher than the potential applied to the charge accumulation electrode segment $24'_3$ located farthest from the first electrode 21. In this way, by applying a potential gradient to the charge accumulation electrode 24, electrons that have stopped in the region of the inorganic oxide semiconductor material layer 23B and the like facing the charge accumulation electrode 24 are more reliably read out to the first electrode 21 and further to the first floating diffusion layer $FD_1$. That is, the charges accumulated in the inorganic oxide semiconductor material layer 23B and the like are read out to the control unit.

Then, in a charge transfer period, by satisfying the potential of the charge accumulation electrode segment $24'_3$ < the potential of the charge accumulation electrode segment $24'_2$ < the potential of the charge accumulation electrode segment $24'_1$, electrons that have stopped in the region of the inorganic oxide semiconductor material layer 23B and the like can be read out to the first floating diffusion layer $FD_1$ all at once. Alternatively, in a charge transfer period, by gradually changing the potential of the charge accumulation electrode segment $24'_3$, the potential of the charge accumulation electrode segment $24'_2$, and the potential of the charge accumulation electrode segment $24'_1$ (that is, by changing the potential of the charge accumulation electrode segment $24'_3$, the potential of the charge accumulation electrode segment $24'_2$, and the potential of the charge accumulation electrode segment $24'_1$ in a step shape or a slope shape), electrons that have stopped in the region of the inorganic oxide semiconductor material layer 23B and the like facing the charge accumulation electrode segment $24'_3$ are transferred to the region of the inorganic oxide semiconductor material layer 23B and the like facing the charge accumulation electrode segment $24'_2$. Subsequently, electrons that have stopped in the region of the inorganic oxide semiconductor material layer 23B and the like facing the charge accumulation electrode segment $24'_2$ are transferred to the region of the inorganic oxide semiconductor material layer 23B and the like facing the charge accumulation electrode segment $24'_1$. Subsequently, electrons that have stopped in the region of the inorganic oxide semiconductor material layer 23B and the like facing the charge accumulation electrode segment $24'_1$ can be reliably read out to the first floating diffusion layer $FD_1$.

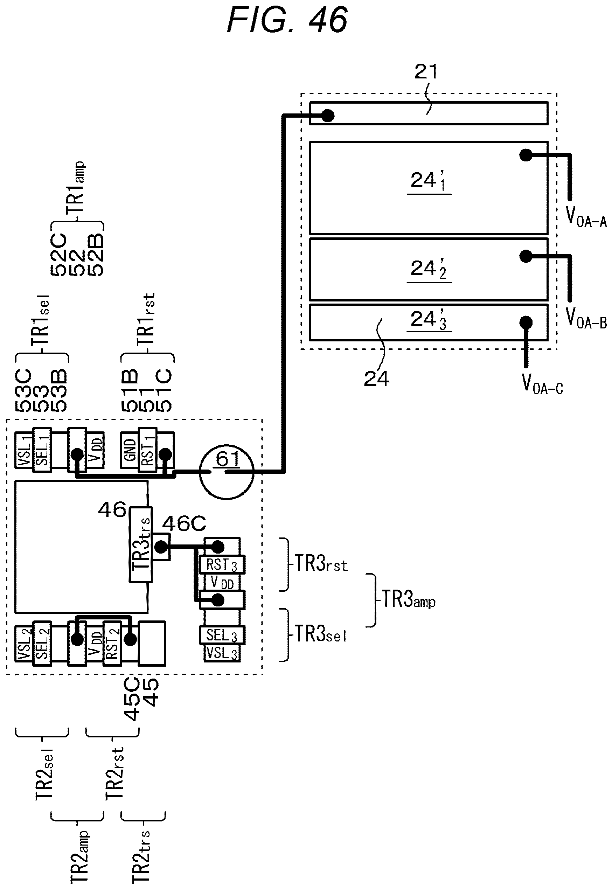

As Fig. 46 illustrates a schematic arrangement diagram of the first electrode and the charge accumulation electrode constituting a modification of the imaging element of Example 11, and a transistor constituting the control unit, the other source/drain region 51B of the reset transistor $TR3_{rst}$ may be grounded instead of being connected to the power source $V_{DD}$.

Also in the imaging element of Example 11, by adopting such a configuration, a kind of charge transfer gradient is formed. That is, the area of a charge accumulation electrode segment is gradually reduced from the first photoelectric conversion unit segment $10'_1$ to the N-th photoelectric conversion unit segment $10'N$. Therefore, when a state of $V_{12} \geq V_{11}$ is reached in a charge accumulation period, the n-th photoelectric conversion unit segment can accumulate more charges than the (n + 1)-th photoelectric conversion unit segment. Then, when a state of $V_{22} < V_{21}$ is reached in a charge transfer period, a flow of charges from the first photoelectric conversion unit segment to the first electrode, and a flow of charges from the (n + 1)-th photoelectric conversion unit segment to the n-th photoelectric conversion unit segment can be reliably ensured.

[Example 12]

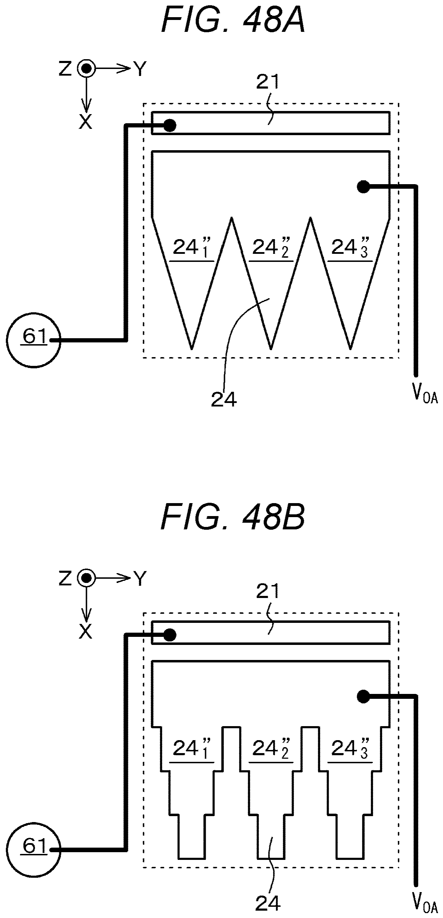

Example 12 relates to the imaging element of the sixth configuration. Fig. 47 illustrates a schematic partial cross-sectional view of the imaging element of Example 12. Furthermore, Figs. 48A and 48B illustrate schematic plan views of charge accumulation electrode segments in Example 12. The imaging element of Example 12 includes a photoelectric conversion unit formed by laminating the first electrode 21, the inorganic oxide semiconductor material layer 23B, the photoelectric conversion layer 23A, and the second electrode 22. The photoelectric conversion unit further includes the charge accumulation electrode 24 ($24"_1$, $24"_2$, and $24"_3$) disposed apart from the first electrode 21 so as to face the inorganic oxide semiconductor material layer 23B via the insulating layer 82. In addition, if a lamination direction of the charge accumulation electrode 24 ($24"_1$, $24"_2$, and $24"_3$), the insulating layer 82, the inorganic oxide semiconductor material layer 23B, and the photoelectric conversion layer 23A is defined as a Z direction, and a direction of separating from the first electrode 21 is defined as an X direction, when a laminated portion where the charge accumulation electrode 24 ($24"_1$, $24"_2$, and $24"_3$), the insulating layer 82, the inorganic oxide semiconductor material layer 23B, and the photoelectric conversion layer 23A are laminated is cut with a YZ virtual plane, the cross-sectional area of the laminated portion changes depending on a distance from the first electrode 21.

Specifically, in the imaging element of Example 12, the thickness of the cross section of the laminated portion is constant, and the width of the cross section of the laminated portion becomes narrower as the laminated portion goes away from the first electrode 21. Note that the width may be continuously narrowed (see Fig. 48A), or may be narrowed stepwise (see Fig. 48B).

In this way, in the imaging element of Example 12, when a laminated portion where the charge accumulation electrode 24 ($24"_1$, $24"_2$, and $24"_3$), the insulating layer 82, and the photoelectric conversion layer 23A are laminated is cut with a YZ virtual plane, the cross-sectional area of the laminated portion changes depending on a distance from the first electrode. Therefore, a kind of charge transfer gradient is formed, and charges generated by photoelectric conversion can be transferred more easily and reliably.

[Example 13]

Example 13 relates to solid-state imaging devices of first and second configurations.

The solid-state imaging device of Example 13 includes
a photoelectric conversion unit formed by laminating the first electrode 21, the inorganic oxide semiconductor material layer 23B, the photoelectric conversion layer 23A, and the second electrode 22.

The photoelectric conversion unit further includes a plurality of imaging elements each including the charge accumulation electrode 24 disposed apart from the first electrode 21 so as to face the inorganic oxide semiconductor material layer 23B via the insulating layer 82.

The plurality of imaging elements constitutes an imaging element block.

The first electrode 21 is shared by the plurality of imaging elements constituting the imaging element block.

Alternatively, the solid-state imaging device of Example 13 includes a plurality of the imaging elements described in Examples 1 to 12.

In Example 13, one floating diffusion layer is disposed for the plurality of imaging elements. In addition, by appropriately controlling the timing of a charge transfer period, the plurality of imaging elements can share one floating diffusion layer. In addition, in this case, the plurality of imaging elements can share one contact hole portion.

Note that the solid-state imaging device of Example 13 has substantially a similar configuration and structure to the solid-state imaging devices described in Examples 1 to 12 except that the first electrode 21 is shared by the plurality of imaging elements constituting an imaging element block.

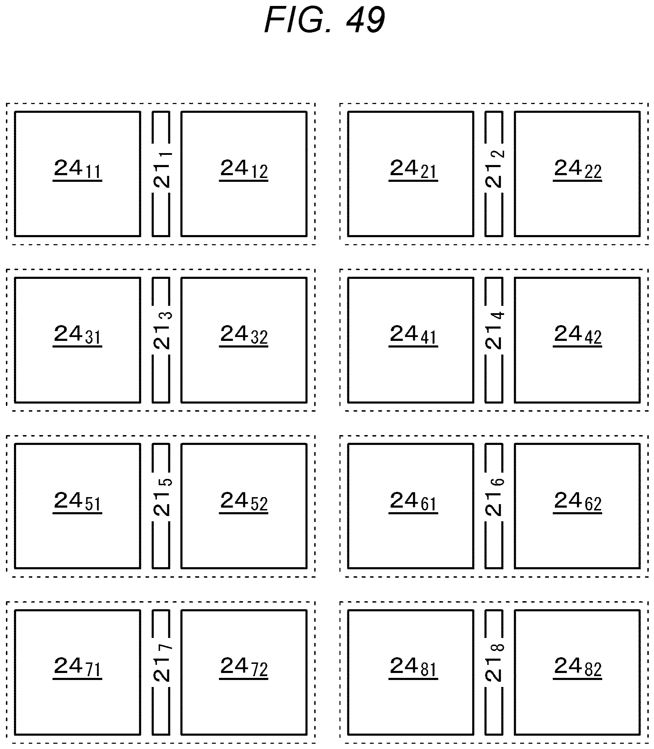

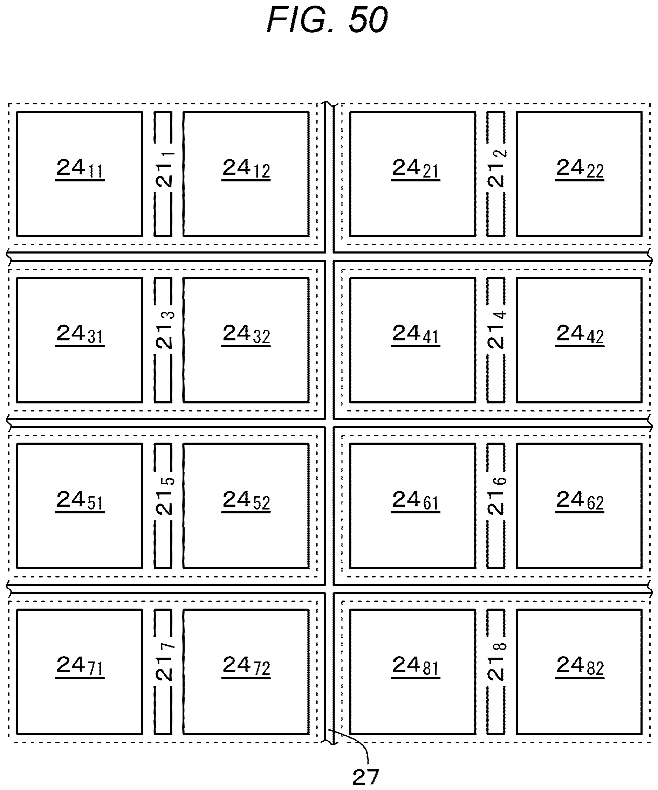

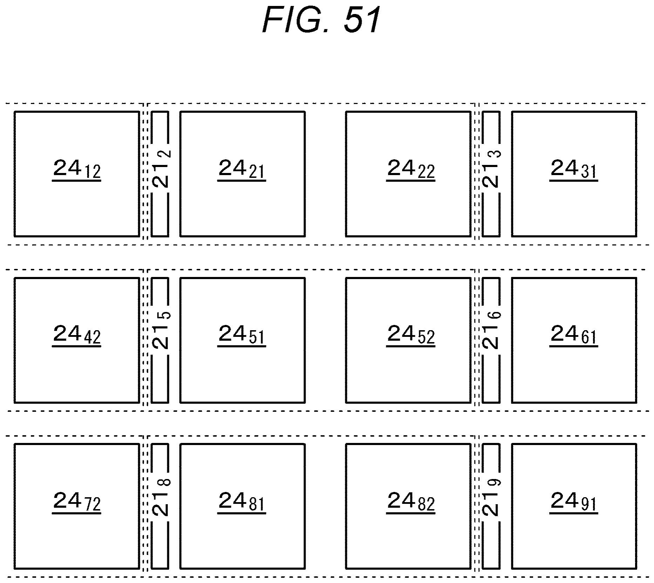

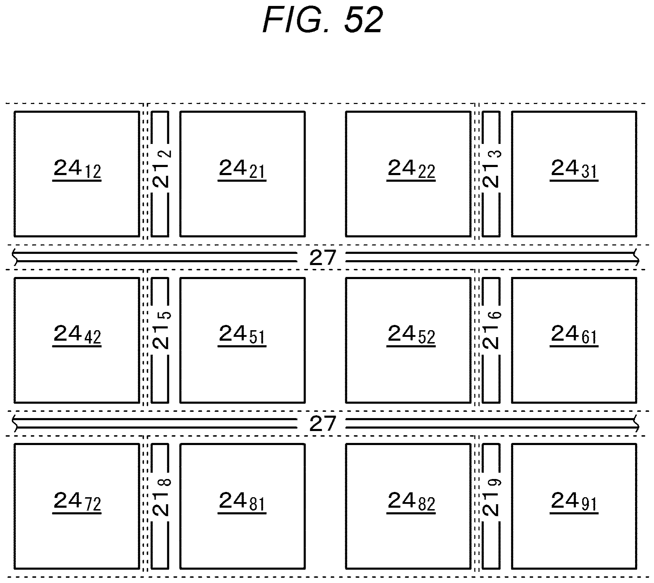

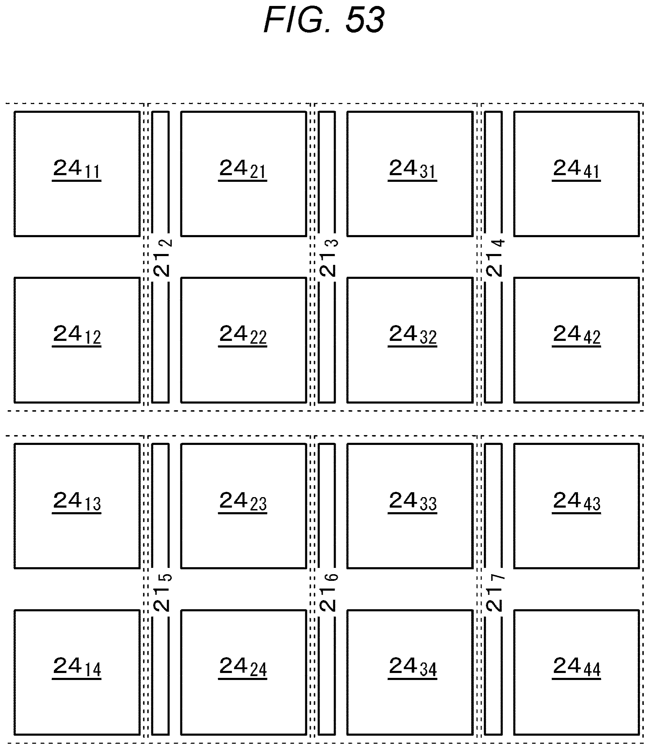

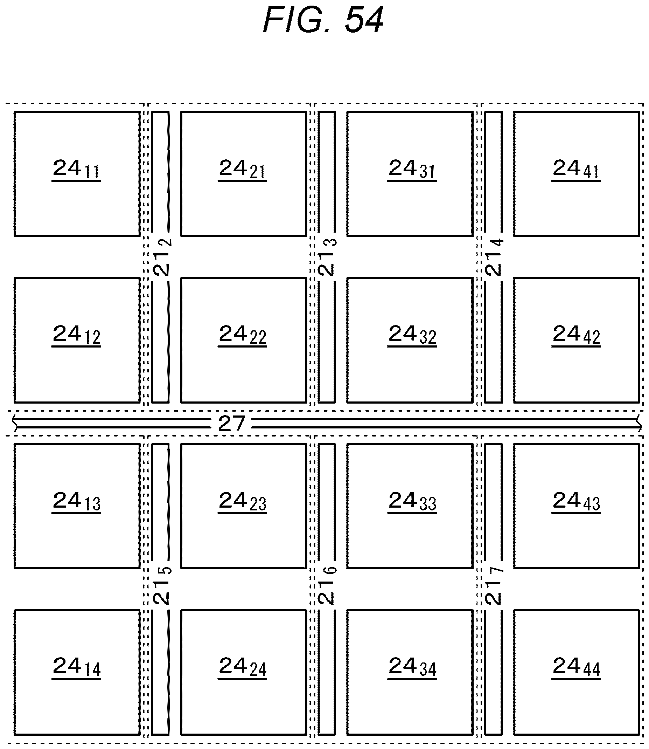

The arrangement state of the first electrode 21 and the charge accumulation electrode 24 in the solid-state imaging device of Example 13 is schematically illustrated in Fig. 49 (Example 13), Fig. 50 (first modification of Example 13), Fig. 51 (second modification of Example 13), Fig. 52 (third modification of Example 13), and Fig. 53 (fourth modification of Example 13). Figs. 49, 50, 53, and 54 illustrate 16 imaging elements, and Figs. 51 and 52 each illustrate 12 imaging elements. In addition, two imaging elements constitute an imaging element block. The imaging element block is surrounded by a dotted line. The subscripts attached to the first electrodes 21 and the charge accumulation electrodes 24 are described in order to distinguish the first electrodes 21 and the charge accumulation electrodes 24 from one another, respectively. This applies to the following description similarly. Furthermore, one on-chip micro lens (not illustrated in Figs. 49 to 58) is disposed above one imaging element. In addition, in one imaging element block, two charge accumulation electrodes 24 are disposed with the first electrode 21 interposed therebetween (see Figs. 49 and 50). Alternatively, one first electrode 21 is disposed so as to face two charge accumulation electrodes 24 arranged in parallel (see Figs. 53 and 54). That is, the first electrode is disposed adjacent to the charge accumulation electrode of each imaging element. Alternatively, the first electrode is disposed adjacent to some of the charge accumulation electrodes of the plurality of imaging elements, and is not disposed adjacent to the remaining charge accumulation electrodes of the plurality of imaging elements (see Figs. 51 and 52). In this case, transfer of charges from the rest of the plurality of imaging elements to the first electrode is transfer via some of the plurality of imaging elements. The distance A between a charge accumulation electrode constituting an imaging element and a charge accumulation electrode constituting an imaging element is preferably longer than the distance B between a first electrode and a charge accumulation electrode in an imaging element adjacent to the first electrode in order to ensure the transfer of charges from each of the imaging elements to the first electrode. Furthermore, a value of the distance A is preferably longer as an imaging element is located farther from the first electrode. Furthermore, in examples illustrated in Figs. 50, 52, and 54, the charge transfer control electrode 27 is disposed among a plurality of imaging elements constituting an imaging element block. By disposing the charge transfer control electrode 27, it is possible to reliably suppress transfer of charges in the imaging element blocks located with the charge transfer control electrode 27 interposed therebetween. Note that when a potential applied to the charge transfer control electrode 27 is referred to as $V_{17}$, $V_{12} > V_{17}$ only needs to be satisfied.

The charge transfer control electrode 27 may be formed, on the first electrode side, at the same level as the first electrode 21 or the charge accumulation electrode 24 or at a different level (specifically, at a level lower than the first electrode 21 or the charge accumulation electrode 24). In the former case, since a distance between the charge transfer control electrode 27 and the photoelectric conversion layer can be shortened, the potential can be easily controlled. Meanwhile, the latter case is advantageous for miniaturization because a distance between the charge transfer control electrode 27 and the charge accumulation electrode 24 can be shortened.

Hereinafter, an operation of an imaging element block constituted by the first electrode $21_2$ and the two charge accumulation electrodes $24_{21}$ and $24_{22}$ will be described.

In a charge accumulation period, a potential $V_a$ is applied to the first electrode $21_2$ and a potential $V_A$ is applied to the charge accumulation electrodes $24_{21}$ and $24_{22}$ from a drive circuit. Photoelectric conversion occurs in the photoelectric conversion layer 23A by light incident on the photoelectric conversion layer 23A. Holes generated by the photoelectric conversion are sent from the second electrode 22 to a drive circuit via the wiring $V_{OU}$. Meanwhile, the potential of the first electrode $21_2$ is set to be higher than the potential of the second electrode 22, that is, for example, a positive potential is applied to the first electrode $21_2$, and a negative potential is applied to the second electrode 22. Therefore, $V_A \geq V_a$ is satisfied, preferably $V_A > V_a$ is satisfied. As a result, electrons generated by the photoelectric conversion are attracted to the charge accumulation electrodes $24_{21}$ and $24_{22}$ and stop in a region of the inorganic oxide semiconductor material layer 23B and the like facing the charge accumulation electrodes $24_{21}$ and $24_{22}$. That is, charges are accumulated in the inorganic oxide semiconductor material layer 23B and the like. Since $V_A \geq V_a$ is satisfied, electrons generated inside the photoelectric conversion layer 23A are not transferred toward the first electrode $21_2$. As the time for the photoelectric conversion elapses, the potential in the region of the inorganic oxide semiconductor material layer 23B and the like facing the charge accumulation electrodes $24_{21}$ and $24_{22}$ becomes a more negative value.

In a later stage of the charge accumulation period, a reset operation is performed. As a result, the potential of the first floating diffusion layer is reset, and the potential of the first floating diffusion layer becomes the potential $V_{DD}$ of the power source.

After the reset operation is completed, charges are read out. That is, in a charge transfer period, a potential $V_b$ is applied to the first electrode $21_2$, a potential $V_{21-B}$ is applied to the charge accumulation electrode $24_{21}$, and a potential $V_{22-B}$ is applied to the charge accumulation electrode $24_{22}$ from a drive circuit. Here, $V_{21-B} < V_b < V_{22-B}$ is satisfied. As a result, electrons that have stopped in the region of the inorganic oxide semiconductor material layer 23B and the like facing the charge accumulation electrode $24_{21}$ are read out to the first electrode $21_2$ and further to the first floating diffusion layer. That is, the charges accumulated in the region of the inorganic oxide semiconductor material layer 23B and the like facing the charge accumulation electrode $24_{21}$ are read out to the control unit. When readout is completed, $V_{22-B} \leq V_{21-B} < V_b$ is satisfied. Note that in examples illustrated in Figs. 53 and 54, $V_{22-B} < V_b < V_{21-B}$ may be satisfied. As a result, electrons that have stopped in the region of the inorganic oxide semiconductor material layer 23B and the like facing the charge accumulation electrode $24_{22}$ are read out to the first electrode $21_2$ and further to the first floating diffusion layer. Furthermore, in the examples illustrated in Figs. 51 and 52, the electrons that have stopped in the region of the inorganic oxide semiconductor material layer 23B and the like facing the charge accumulation electrode $24_{22}$ may be read out to the first floating diffusion layer via the first electrode $21_3$ adjacent to the charge accumulation electrode $24_{22}$. In this way, the charges accumulated in the region of the inorganic oxide semiconductor material layer 23B and the like facing the charge accumulation electrode $24_{22}$ are read out to the control unit. Note that when readout of the charges accumulated in the region of the inorganic oxide semiconductor material layer 23B and the like facing the charge accumulation electrode $24_{21}$ to the control unit is completed, the potential of the first floating diffusion layer may be reset.

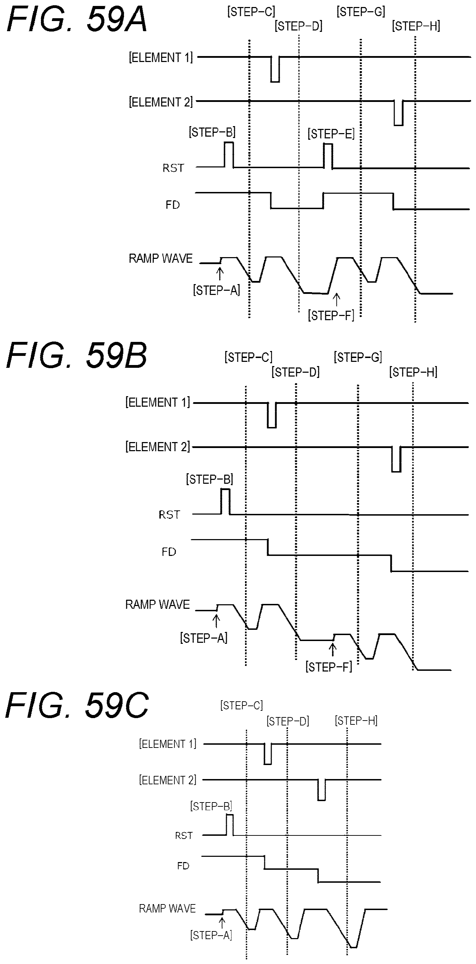

Fig. 59A illustrates a readout driving example in the imaging element block of the Example 13.

Through the following steps A to H, signals from two imaging elements corresponding to the charge accumulation electrode $24_{21}$ and the charge accumulation electrode $24_{22}$ are read out.

[Step-A]

Input of an auto zero signal to a comparator

[Step-B]

Reset operation of one shared floating diffusion layer

[Step-C]

P-phase readout and transfer of charges to the first electrode $21_2$ in an imaging element corresponding to the charge accumulation electrode $24_{21}$

[Step-D]

D-phase readout and transfer of charge to the first electrode $21_2$ in an imaging element corresponding to the charge accumulation electrode $24_{21}$

[Step-E]

Reset operation of one shared floating diffusion layer

[Step-F]

Input of an auto zero signal to a comparator

[Step-G]

P-phase readout and transfer of charges to the first electrode $21_2$ in an imaging element corresponding to the charge accumulation electrode $24_{22}$

[Step-H]

D-phase readout and transfer of charges to the first electrode $21_2$ in an imaging element corresponding to the charge accumulation electrode $24_{22}$ On the basis of a correlated double sampling (CDS) process, a difference between the P-phase readout in [step-C] and the D-phase readout in [step-D] is a signal from an imaging element corresponding to the charge accumulation electrode $24_{21}$, and a difference between the P-phase readout in [step-G] and the D-phase readout in [step-H] is a signal from an imaging element corresponding to the charge accumulation electrode $24_{22}$.

Note that the operation of [Step-E] may be omitted (see Fig. 59B). Furthermore, the operation of [Step-F] may be omitted. In this case, the operation of [Step-G] can be further omitted (see Fig. 59C). A difference between the P-phase readout in [step-C] and the D-phase readout in [step-D] is a signal from an imaging element corresponding to the charge accumulation electrode $24_{21}$, and a difference between the D-phase readout in [step-D] and the D-phase readout in [step-H] is a signal from an imaging element corresponding to the charge accumulation electrode $24_{22}$.

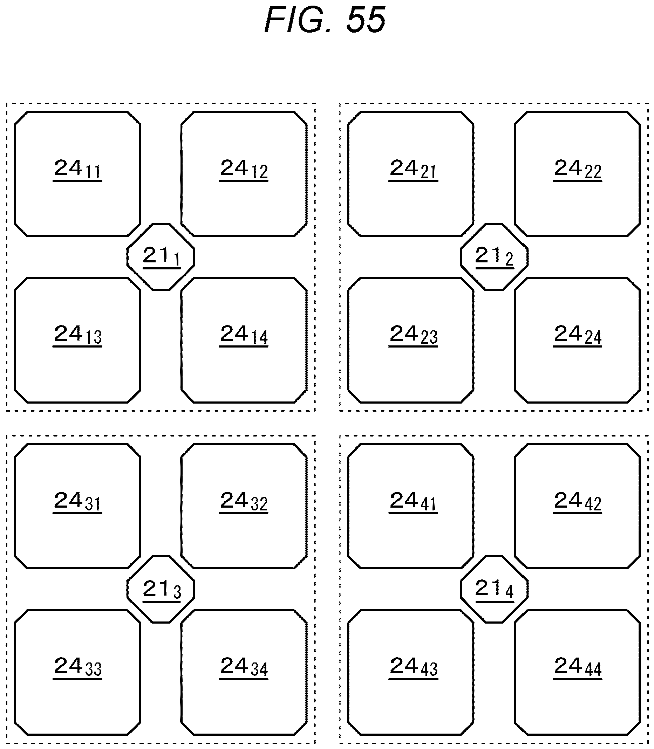

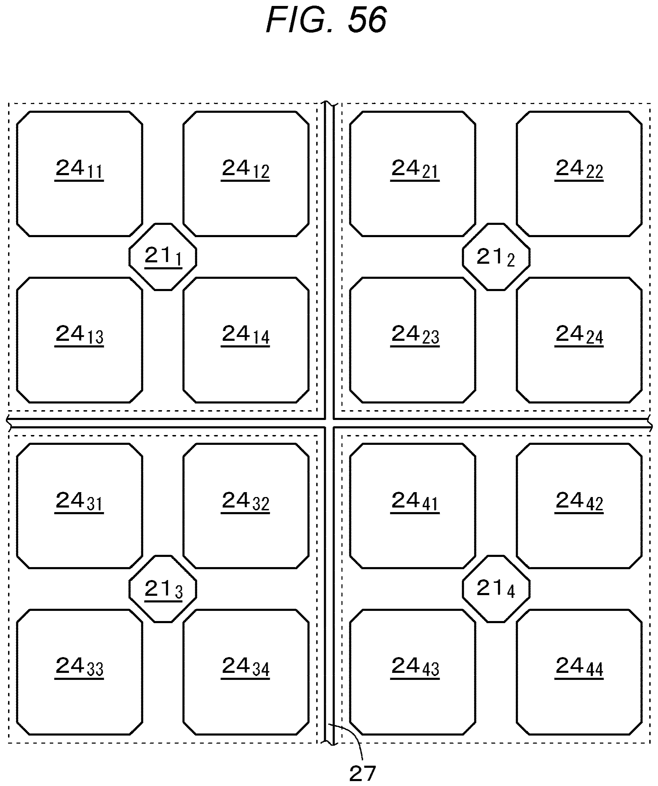

In the modifications illustrated in Fig. 55 (sixth modification of Example 13) and Fig. 56 (seventh modification of Example 13) schematically illustrating the arrangement state of the first electrode 21 and the charge accumulation electrode 24, an imaging element block includes four imaging elements. The operations of these solid-state imaging devices can be substantially similar to the operations of the solid-state imaging devices illustrated in Figs. 49 to 54.

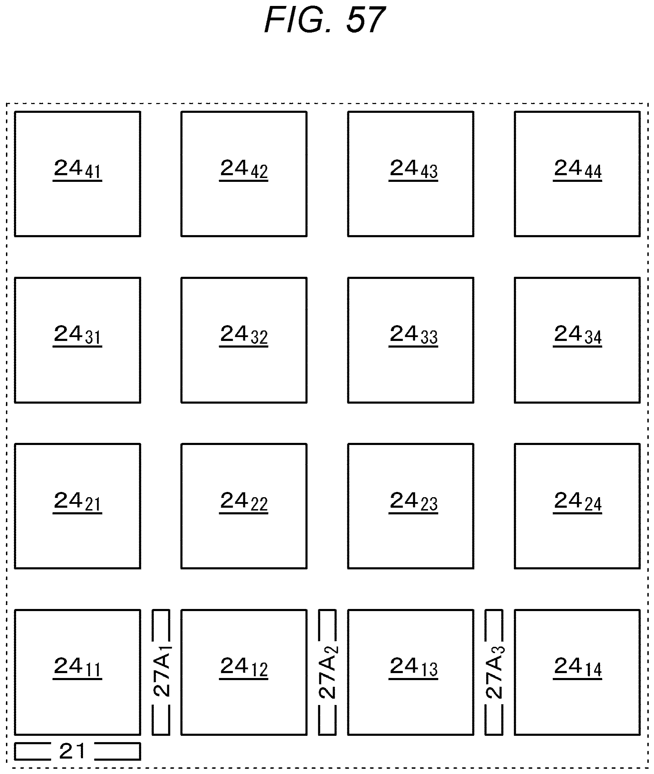

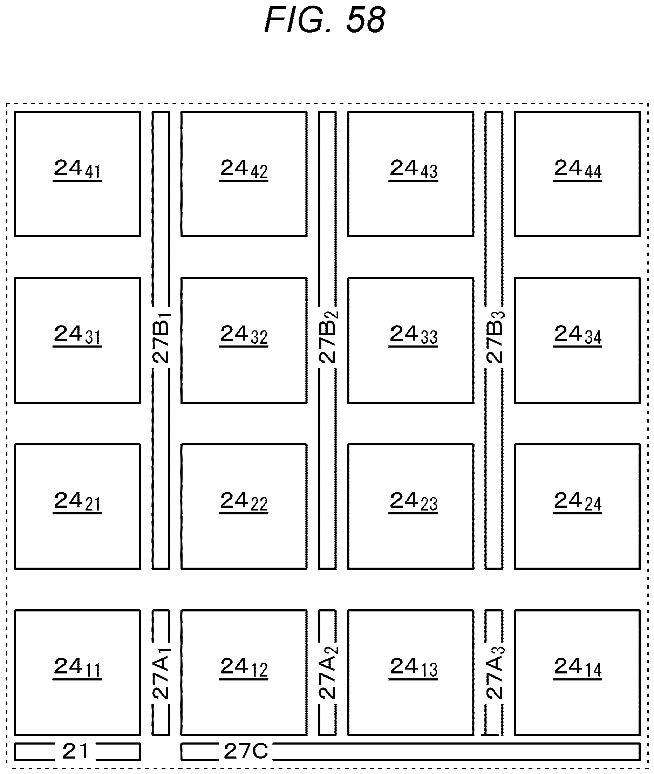

In the eighth and ninth modifications illustrated in Figs. 57 and 58 schematically illustrating the arrangement state of the first electrode 21 and the charge accumulation electrode 24, an imaging element block includes sixteen imaging elements. As illustrated in Figs. 57 and 58, charge transfer control electrodes $27A_1$, $27A_2$, and $27A_3$ are disposed

between the charge accumulation electrode $24_{11}$ and the charge accumulation electrode $24_{12}$, between the charge accumulation electrode $24_{12}$ and the charge accumulation electrode $24_{13}$, and between the charge accumulation electrode $24_{13}$ and the charge accumulation electrode $24_{14}$, respectively. Furthermore, as illustrated in Fig. 58, charge transfer control electrodes $27B_1$, $27B_2$, and $27B_3$ are disposed between the charge accumulation electrodes $24_{21}$, $24_{31}$, and $24_{41}$ and the charge accumulation electrodes $24_{22}$, $24_{32}$, and $24_{42}$, between the charge accumulation electrodes $24_{22}$, $24_{32}$, and $24_{42}$ and the charge accumulation electrodes $24_{23}$, $24_{33}$, and $24_{43}$, and between the charge accumulation electrodes $24_{23}$, $24_{33}$, and $24_{43}$ and the charge accumulation electrodes $24_{24}$, $24_{34}$, and $24_{44}$, respectively. Moreover, a charge transfer control electrode $27C$ is disposed between imaging element blocks. In addition, in these solid-state imaging devices, by controlling the 16 charge accumulation electrodes 24, the charges accumulated in the inorganic oxide semiconductor material layer 23B can be read out from the first electrode 21.

[Step-10]

Specifically, first, the charges accumulated in the region of the inorganic oxide semiconductor material layer 23B and the like facing the charge accumulation electrode $24_{11}$ are read out from the first electrode 21. Next, the charges accumulated in the region of the inorganic oxide semiconductor material layer 23B and the like facing the charge accumulation electrode $24_{12}$ are read out from the first electrode 21 via the region of the inorganic oxide semiconductor material layer 23B and the like facing the charge accumulation electrode $24_{11}$. Next, the charges accumulated in the region of the inorganic oxide semiconductor material layer 23B and the like facing the charge accumulation electrode $24_{13}$ are read out from the first electrode 21 via the region of the inorganic oxide semiconductor material layer 23B and the like facing the charge accumulation electrode $24_{12}$ and the charge accumulation electrode $24_{11}$.

[Step-20]

Thereafter, the charges accumulated in the region of the inorganic oxide semiconductor material layer 23B and the like facing the charge accumulation electrode $24_{21}$ are transferred to the region of the inorganic oxide semiconductor material layer 23B and the like facing the charge accumulation electrode $24_{11}$. The charges accumulated in the region of the inorganic oxide semiconductor material layer 23B and the like facing the charge accumulation electrode $24_{22}$ are transferred to the region of the inorganic oxide semiconductor material layer 23B and the like facing the charge accumulation electrode $24_{12}$. The charges accumulated in the region of the inorganic oxide semiconductor material layer 23B and the like facing the charge accumulation electrode $24_{23}$ are transferred to the region of the inorganic oxide semiconductor material layer 23B and the like facing the charge accumulation electrode $24_{13}$. The charges accumulated in the region of the inorganic oxide semiconductor material layer 23B and the like facing the charge accumulation electrode $24_{24}$ are transferred to the region of the inorganic oxide semiconductor material layer 23B and the like facing the charge accumulation electrode $24_{14}$.

[Step-21]

The charges accumulated in the region of the inorganic oxide semiconductor material layer 23B and the like facing the charge accumulation electrode $24_{31}$ are transferred to the region of the inorganic oxide semiconductor material layer 23B and the like facing the charge accumulation electrode $24_{21}$. The charges accumulated in the region of the inorganic oxide semiconductor material layer 23B and the like facing the charge accumulation electrode $24_{32}$ are transferred to the region of the inorganic oxide semiconductor material layer 23B and the like facing the charge accumulation electrode $24_{22}$. The charges accumulated in the region of the inorganic oxide semiconductor material layer 23B and the like facing the charge accumulation electrode $24_{33}$ are transferred to the region of the inorganic oxide semiconductor material layer 23B and the like facing the charge accumulation electrode $24_{23}$. The charges accumulated in the region of the inorganic oxide semiconductor material layer 23B and the like facing the charge accumulation electrode $24_{34}$ are transferred to the region of the inorganic oxide semiconductor material layer 23B and the like facing the charge accumulation electrode $24_{24}$.

[Step-22]

The charges accumulated in the region of the inorganic oxide semiconductor material layer 23B and the like facing the charge accumulation electrode $24_{41}$ are transferred to the region of the inorganic oxide semiconductor material layer 23B and the like facing the charge accumulation electrode $24_{31}$. The charges accumulated in the region of the inorganic oxide semiconductor material layer 23B and the like facing the charge accumulation electrode $24_{42}$ are transferred to the region of the inorganic oxide semiconductor material layer 23B and the like facing the charge accumulation electrode $24_{32}$. The charges accumulated in the region of the inorganic oxide semiconductor material layer 23B and the like facing the charge accumulation electrode $24_{43}$ are transferred to the region of the inorganic oxide semiconductor material layer 23B and the like facing the charge accumulation electrode $24_{33}$. The charges accumulated in the region of the inorganic oxide semiconductor material layer 23B and the like facing the charge accumulation electrode $24_{44}$ are transferred to the region of the inorganic oxide semiconductor material layer 23B and the like facing the charge accumulation electrode $24_{34}$.

[Step-30]

Then, by executing [step-10] again, the charges accumulated in the region of the inorganic oxide semiconductor material layer 23B and the like facing the charge accumulation electrode $24_{21}$, the charges accumulated in the region of the inorganic oxide semiconductor material layer 23B and the like facing the charge accumulation electrode $24_{22}$, the charges accumulated in the region of the inorganic oxide semiconductor material layer 23B and the like facing the charge accumulation electrode $24_{23}$, and the charges accumulated in the region of the inorganic oxide semiconductor material layer 23B and the like facing the charge accumulation electrode $24_{24}$ can be read out via the first electrode 21.

[Step-40]

Thereafter, the charges accumulated in the region of the inorganic oxide semiconductor material layer 23B and the like facing the charge accumulation electrode $24_{21}$ are transferred to the region of the inorganic oxide semiconductor material layer 23B and the like facing the charge accumulation electrode $24_{11}$. The charges accumulated in the region of the inorganic oxide semiconductor material layer 23B and the like facing the charge accumulation electrode $24_{22}$ are transferred to the region of the inorganic oxide semiconductor material layer 23B and the like facing the charge accumulation electrode $24_{12}$. The charges accumulated in the region of the inorganic oxide semiconductor material layer 23B and the like facing the charge accumulation electrode $24_{23}$ are transferred to the region of the inorganic oxide semiconductor material layer 23B and the like facing the charge accumulation electrode $24_{13}$. The charges accumulated in the region of the inorganic oxide semiconductor material layer 23B and the like facing the charge accumulation electrode $24_{24}$ are transferred to the region of the inorganic oxide semiconductor material layer 23B and the like facing the charge accumulation electrode $24_{14}$.

[Step-41]

The charges accumulated in the region of the inorganic oxide semiconductor material layer 23B and the like facing the charge accumulation electrode $24_{31}$ are transferred to the region of the inorganic oxide semiconductor material layer 23B and the like facing the charge accumulation electrode $24_{21}$. The charges accumulated in the region of the inorganic oxide semiconductor material layer 23B and the like facing the charge accumulation electrode $24_{32}$ are transferred to the region of the inorganic oxide semiconductor material layer 23B and the like facing the charge accumulation electrode $24_{22}$. The charges accumulated in the region of the inorganic oxide semiconductor material layer 23B and the like facing the charge accumulation electrode $24_{33}$ are transferred to the region of the inorganic oxide semiconductor material layer 23B and the like facing the charge accumulation electrode $24_{23}$. The charges accumulated in the region of the inorganic oxide semiconductor material layer 23B and the like facing the charge accumulation electrode $24_{34}$ are transferred to the region of the inorganic oxide semiconductor material layer 23B and the like facing the charge accumulation electrode $24_{24}$.

[Step-50]

Then, by executing [step-10] again, the charges accumulated in the region of the inorganic oxide semiconductor material layer 23B and the like facing the charge accumulation electrode $24_{31}$, the charges accumulated in the region of the inorganic oxide semiconductor material layer 23B and the like facing the charge accumulation electrode $24_{32}$, the charges accumulated in the region of the inorganic oxide semiconductor material layer 23B and the like facing the charge accumulation electrode $24_{33}$, and the charges accumulated in the region of the inorganic oxide semiconductor material layer 23B and the like facing the charge accumulation electrode $24_{34}$ can be read out via the first electrode 21.

[Step-60]

Thereafter, the charges accumulated in the region of the inorganic oxide semiconductor material layer 23B and the like facing the charge accumulation electrode $24_{21}$ are transferred to the region of the inorganic oxide semiconductor material layer 23B and the like facing the charge accumulation electrode $24_{11}$. The charges accumulated in the region of the inorganic oxide semiconductor material layer 23B and the like facing the charge accumulation electrode $24_{22}$ are

transferred to the region of the inorganic oxide semiconductor material layer 23B and the like facing the charge accumulation electrode $24_{12}$. The charges accumulated in the region of the inorganic oxide semiconductor material layer 23B and the like facing the charge accumulation electrode $24_{23}$ are transferred to the region of the inorganic oxide semiconductor material layer 23B and the like facing the charge accumulation electrode $24_{13}$. The charges accumulated in the region of the inorganic oxide semiconductor material layer 23B and the like facing the charge accumulation electrode $24_{24}$ are transferred to the region of the inorganic oxide semiconductor material layer 23B and the like facing the charge accumulation electrode $24_{14}$.

[Step-70]

Then, by executing [step-10] again, the charges accumulated in the region of the inorganic oxide semiconductor material layer 23B and the like facing the charge accumulation electrode $24_{41}$, the charges accumulated in the region of the inorganic oxide semiconductor material layer 23B and the like facing the charge accumulation electrode $24_{42}$, the charges accumulated in the region of the inorganic oxide semiconductor material layer 23B and the like facing the charge accumulation electrode $24_{43}$, and the charges accumulated in the region of the inorganic oxide semiconductor material layer 23B and the like facing the charge accumulation electrode $24_{44}$ can be read out via the first electrode 21.

In the solid-state imaging device of Example 13, since the first electrode is shared by the plurality of imaging elements constituting the imaging element block, the configuration and structure in a pixel region in which a plurality of imaging elements is arrayed can be simplified and miniaturized. Note that the plurality of imaging elements disposed for one floating diffusion layer may be constituted by a plurality of first type imaging elements, or may be constituted by at least one first type imaging element and one or more second type imaging elements.

[Example 14]

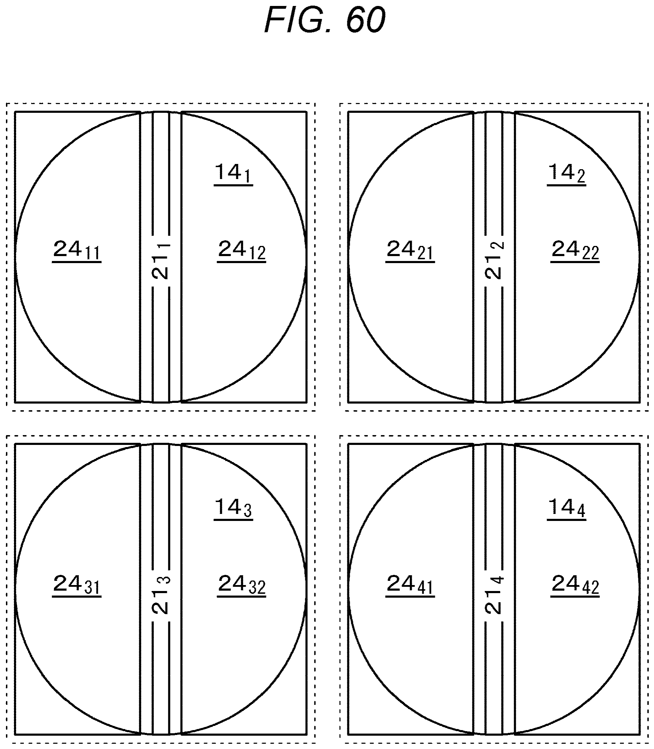

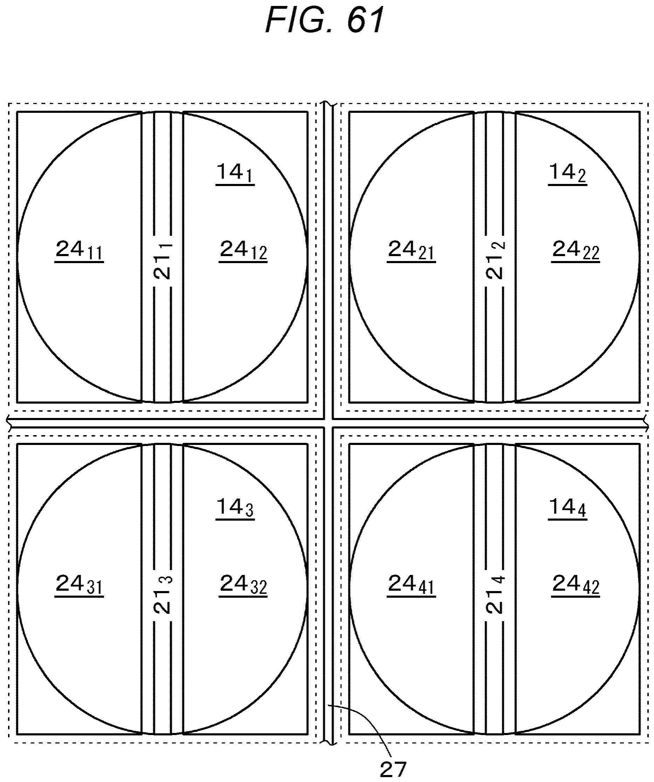

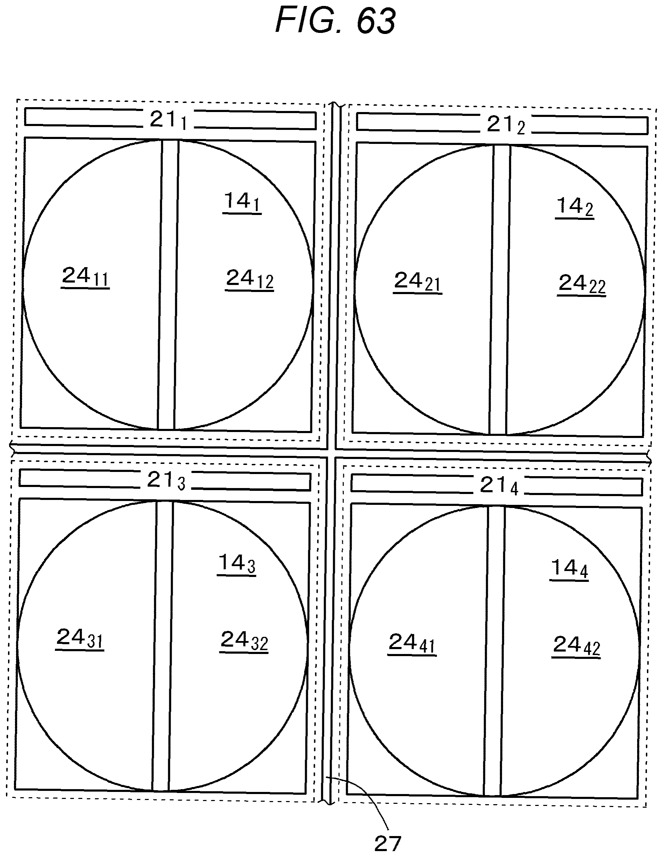

Example 14 is a modification of Example 13. In the solid-state imaging device of Example 14 illustrated in Figs. 60, 61, 62, and 63 schematically illustrating the arrangement state of the first electrode 21 and the charge accumulation electrode 24, an imaging element block includes two imaging elements. In addition, one on-chip micro lens 14 is disposed above an imaging element block. Note that in the examples illustrated in Figs. 61 and 63, the charge transfer control electrode 27 is disposed among the plurality of imaging elements constituting an imaging element block.

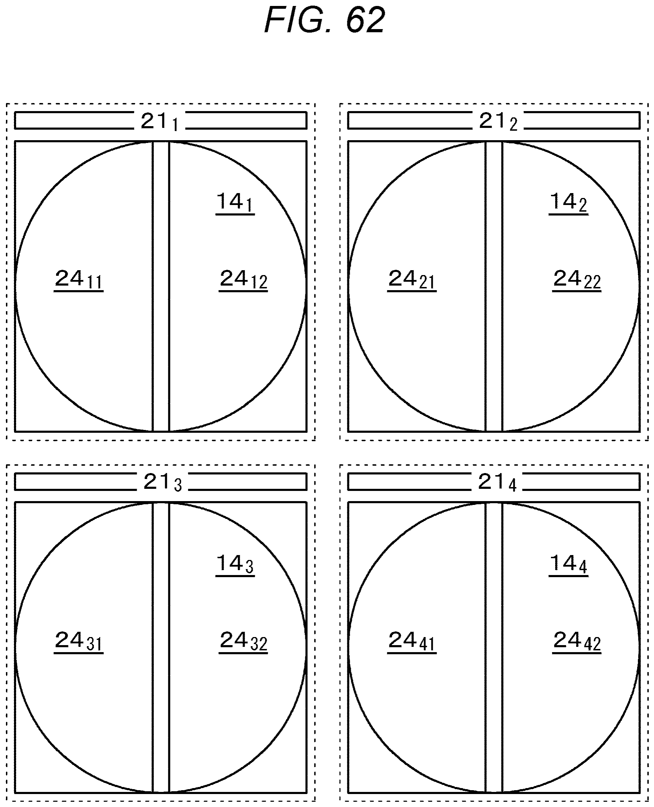

For example, photoelectric conversion layers corresponding to the charge accumulation electrodes $24_{11}$, $24_{21}$, $24_{31}$, and $24_{41}$ constituting an imaging element block are highly sensitive to incident light from the upper right in the drawings. Furthermore, photoelectric conversion layers corresponding to the charge accumulation electrodes $24_{12}$, $24_{22}$, $24_{32}$, and $24_{42}$ constituting an imaging element block are highly sensitive to incident light from the upper left in the drawing. Therefore, for example, by combining an imaging element including the charge accumulation electrode $24_{11}$ with an imaging element including the charge accumulation electrode $24_{12}$, an image plane phase difference signal can be acquired. Furthermore, if a signal from an imaging element including the charge accumulation electrode $24_{11}$ is added to a signal from an imaging element including the charge accumulation electrode $24_{12}$, one imaging element can be constituted by a combination with these imaging elements. In the example illustrated in Fig. 60, the first electrode $21_1$ is disposed between the charge accumulation electrode $24_{11}$ and the charge accumulation electrode $24_{12}$. However, as in the example illustrated in Fig. 62, by disposing one first electrode $21_1$ so as to face the two charge accumulation electrodes $24_{11}$ and $24_{12}$ arranged in parallel, the sensitivity can be further improved.

Hitherto, the present disclosure has been described on the basis of preferable Examples. However, the present disclosure is not limited to these Examples. The structures and configurations, the manufacturing conditions, the manufacturing methods, and the used materials of the laminated imaging element, the imaging element, and the solid-state imaging device described in Examples are illustrative and can be modified appropriately. The imaging elements of Examples can be combined appropriately. For example, the imaging element of Example 7, the imaging element of Example 8, the imaging element of Example 9, the imaging element of Example 10, and the imaging element of Example 11 can be arbitrarily combined. The imaging element of Example 7, the imaging element of Example 8, the imaging element of Example 9, the imaging element of Example 10, and the imaging element of Example 12 can be arbitrarily combined. The configuration and structure of the imaging element of the present disclosure can be applied to a light emitting element, for example, an organic EL element, or can be applied to a channel formation region of a thin film transistor.

In some cases, the floating diffusion layers $FD_1$, $FD_2$, $FD_3$, 51C, 45C, and 46C can be shared.

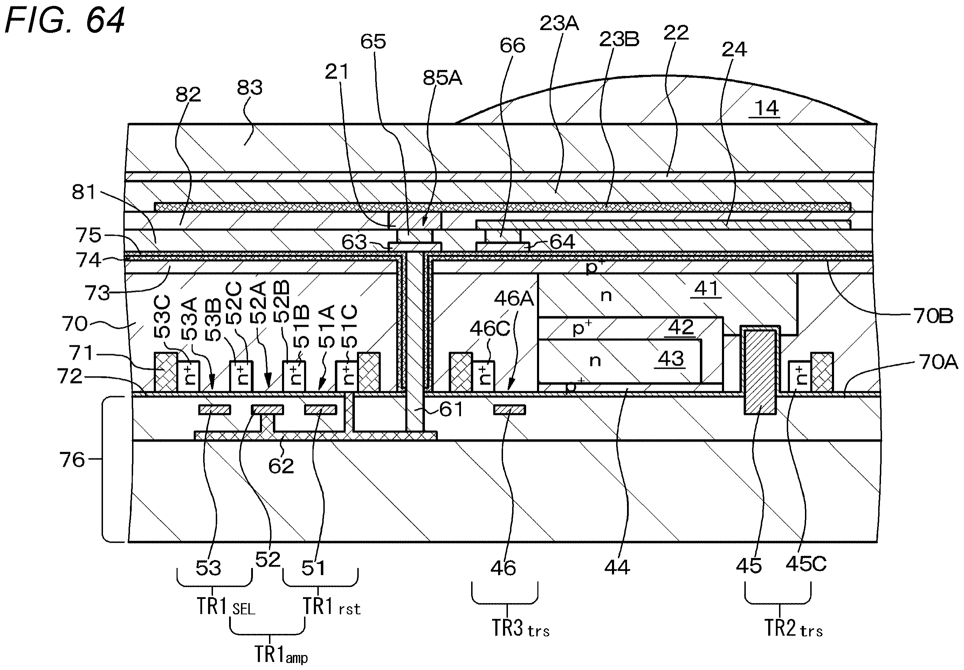

For example, as Fig. 64 illustrates a modification of the imaging element described in Example 1, the first electrode 21 can extend in an opening 85A formed in the insulating layer 82 to be connected to the inorganic oxide semiconductor material layer 23B.

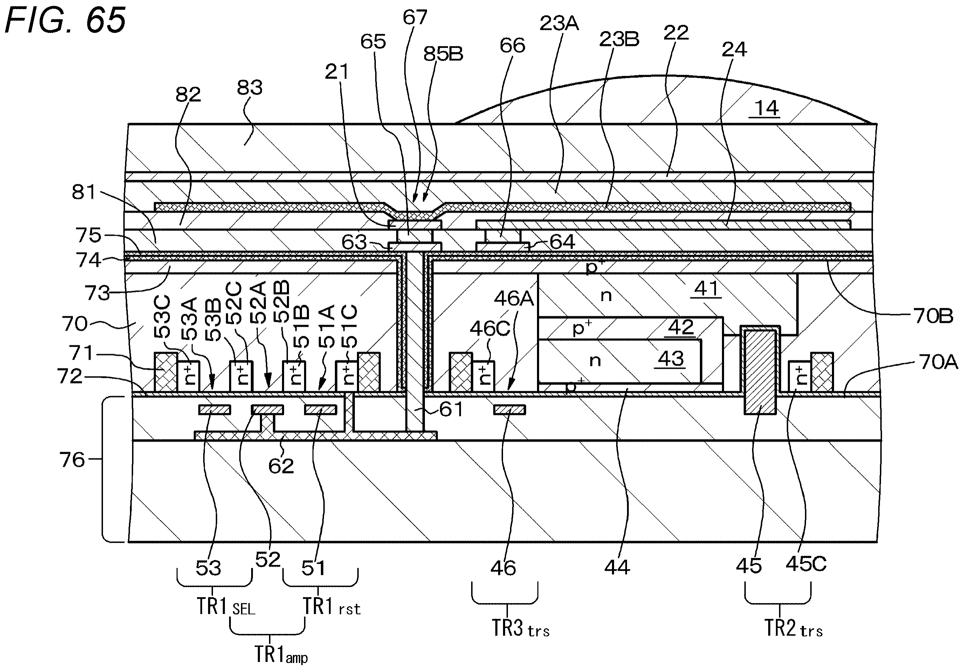

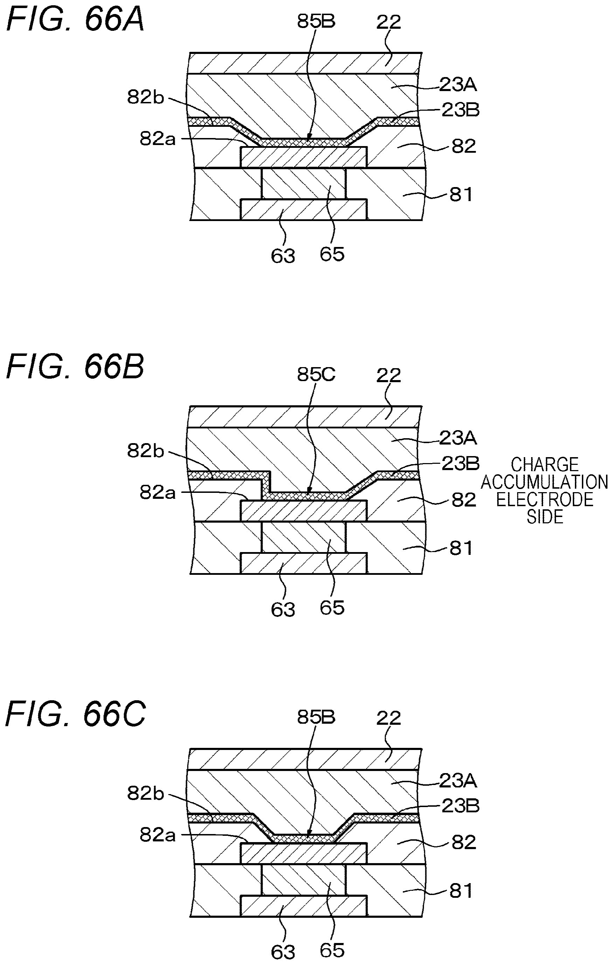

Alternatively, for example, as Fig. 65 illustrates a modification of the imaging element described in Example 1, and Fig. 66A illustrates an enlarged schematic partial cross-sectional view of the first electrode portion and the like, an edge of a top surface of the first electrode 21 is covered with the insulating layer 82, the first electrode 21 is exposed on a bottom surface of an opening 85B, and when a surface of the insulating layer 82 in contact with the top surface of the first electrode 21 is referred to as a first surface 82a and a surface of the insulating layer 82 in contact with a portion of the inorganic oxide semiconductor material layer 23B facing the charge accumulation electrode 24 is referred to as a second surface 82b, a side surface of the opening 85B has an inclination widening from the first surface 82a toward the second surface 82b. In this way, by inclining the side surface of the opening 85B, transfer of charges from the inorganic oxide semiconductor material layer 23B to the first electrode 21 becomes smoother. Note that in the example illustrated in Fig. 66A, side surfaces of the opening 85B are rotationally symmetric with each other about the axis of the opening 85B. However, as illustrated in Fig. 66B, an opening 85C may be formed such that a side surface of the opening 85C having an inclination widening from the first surface 82a toward the second surface 82b is located on the charge accumulation electrode 24 side. As a result, transfer of charges from a portion of the inorganic oxide semiconductor material layer 23B opposite to the charge accumulation electrode 24 across the opening 85C is difficult. Furthermore, the side surface of the opening 85B has an inclination widening from the first surface 82a toward the second surface 82b. However, an edge of the side surface of the opening 85B in the second surface 82b may be located outside an edge of the first electrode 21 as illustrated in Fig. 66A, or may be located inside the edge of the first electrode 21 as illustrated in Fig. 66C. By adopting the former configuration, transfer of charges is further facilitated. By adopting the latter configuration, variation in shape at the time of forming an opening can be reduced.

These openings 85B and 85C can be formed by reflowing an etching mask containing a resist material to be formed when an opening is formed in the insulating layer on the basis of an etching method to incline the opening side surface of the etching mask, and etching the insulating layer 82 using the etching mask.

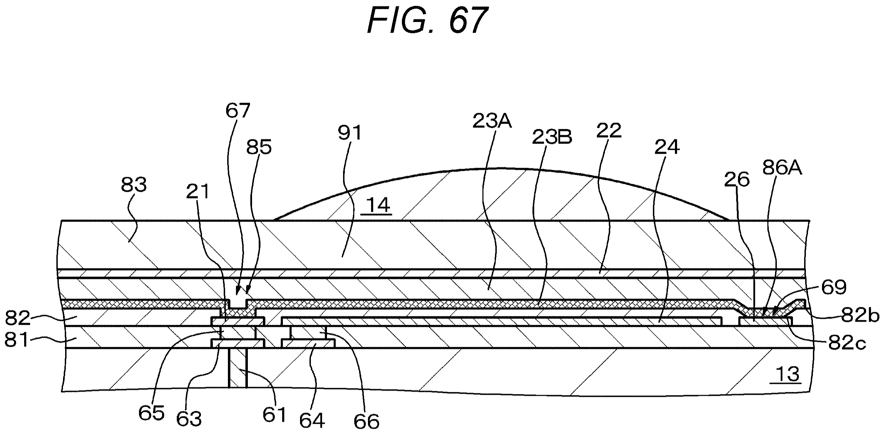

Alternatively, regarding the charge discharge electrode 26 described in Example 5, as illustrated in Fig. 67, a form can be adopted in which the inorganic oxide semiconductor material layer 23B extends in the second opening 86A formed in the insulating layer 82 to be connected to the charge discharge electrode 26, an edge of a top surface of the charge discharge electrode 26 is covered with the insulating layer 82, the charge discharge electrode 26 is exposed on a bottom surface of the second opening 86A, and when a surface of the insulating layer 82 in contact with the top surface of the charge discharge electrode 26 is referred to as a third surface 82c and a surface of the insulating layer 82 in contact with a portion of the inorganic oxide semiconductor material layer 23B facing the charge accumulation electrode 24 is referred to as a second surface 82b, a side surface of the second opening 86A has an inclination widening from the third surface 82c toward the second surface 82b.

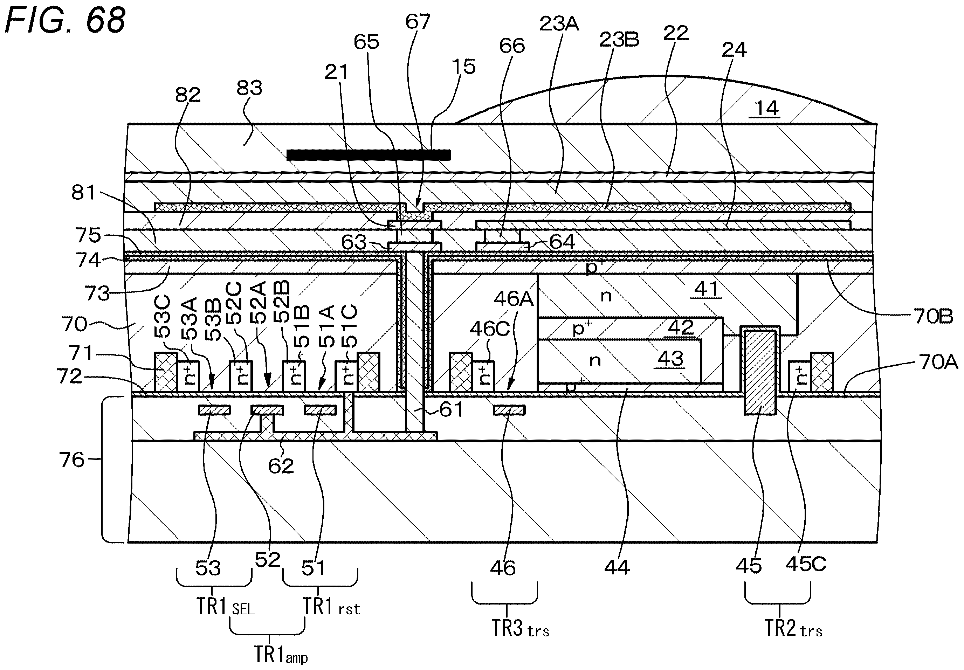

Furthermore, for example, as Fig. 68 illustrates a modification of the imaging element described in Example 1, a configuration can be adopted in which light is incident from the second electrode 22 side, and a light shielding layer 15 is formed on the light incident side of the second electrode 22. Note that various wiring lines disposed on the light incident side of the photoelectric conversion layer can function as a light shielding layer.

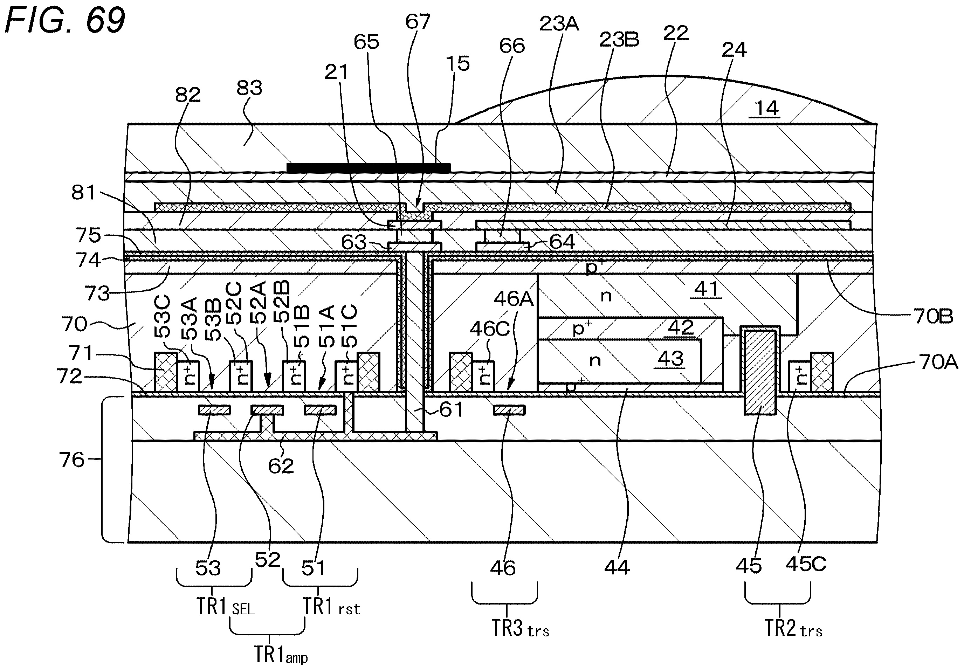

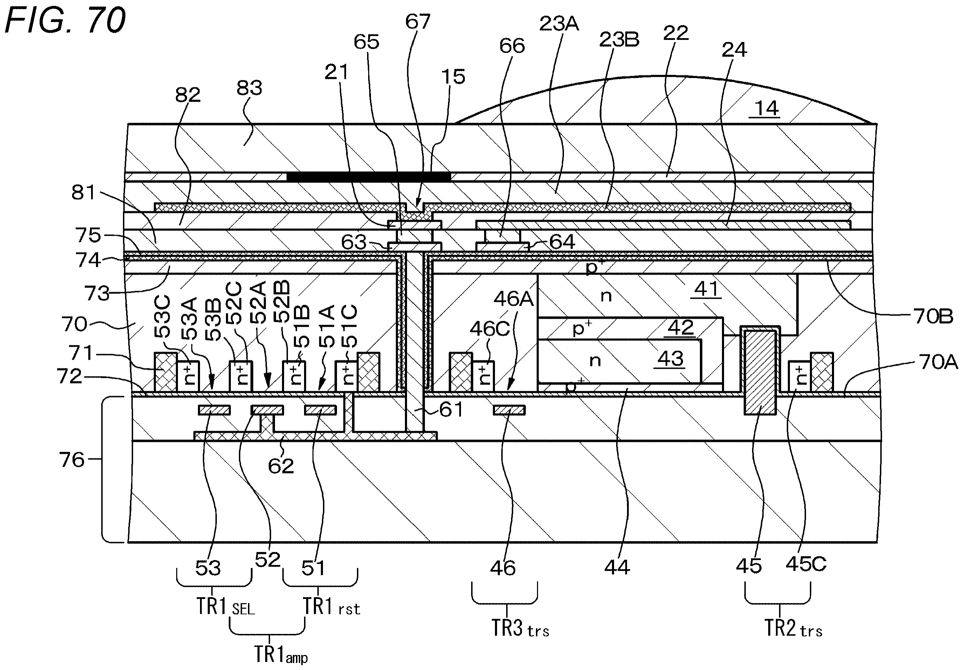

Note that in the example illustrated in Fig. 68, the light shielding layer 15 is formed above the second electrode 22, that is, the light shielding layer 15 is formed on the light incident side of the second electrode 22 and above the first electrode 21. However, as illustrated in Fig. 69, the light shielding layer 15 may be disposed on the light incident side surface of the second electrode 22. Furthermore, in some cases, the light shielding layer 15 may be formed in the second electrode 22 as illustrated in Fig. 70.

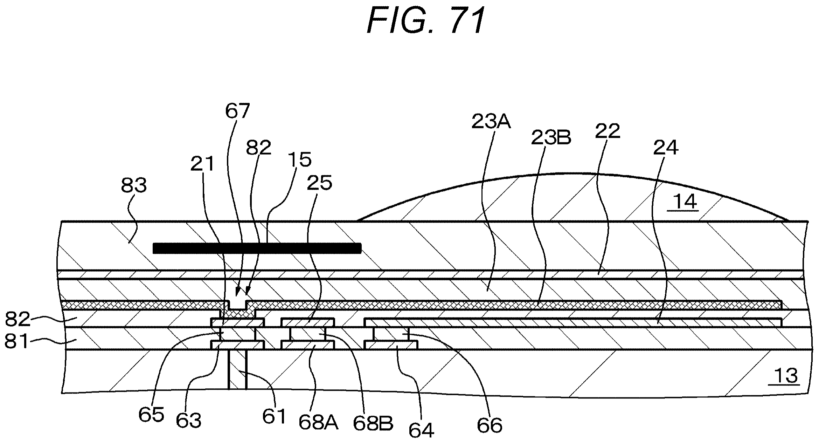

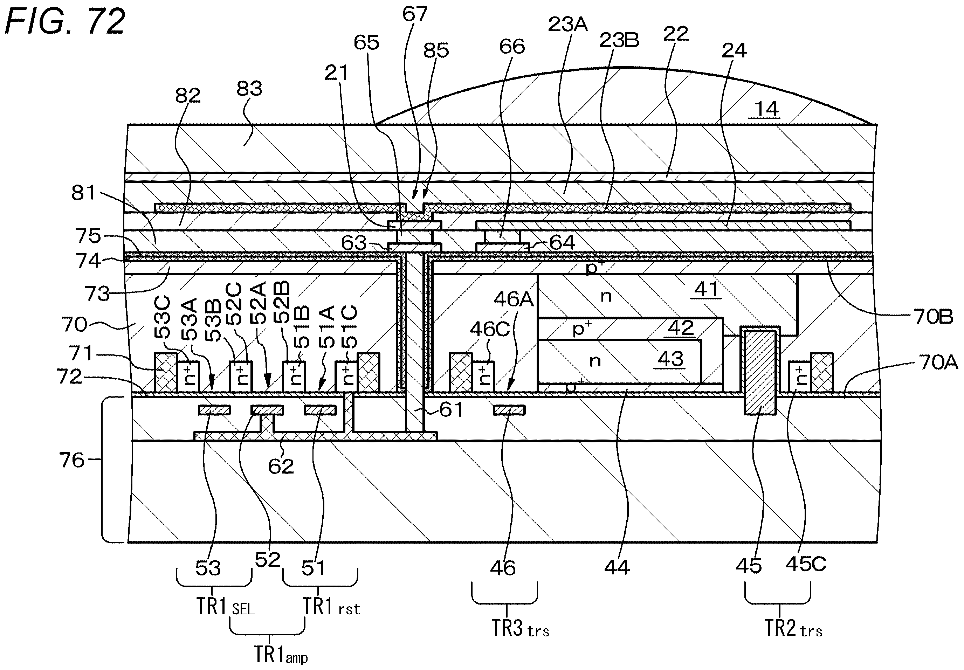

Alternatively, a structure can be adopted in which light is incident from the second electrode 22 side and light is not incident on the first electrode 21. Specifically, as illustrated in Fig. 68, the light shielding layer 15 is formed on the light incident side of the second electrode 22 and above the first electrode 21. Alternatively, as illustrated in Fig. 72, a structure can be adopted in which the on-chip micro lens 14 is disposed above the charge accumulation electrode 24 and the second electrode 22, and light incident on the on-chip micro lens 14 is collected by the charge accumulation electrode 24 and does not reach the first electrode 21. Note that as described in Example 4, in a case where the transfer control electrode 25 is disposed, a structure can be adopted in which light is not incident on the first electrode 21 and the transfer control electrode 25. Specifically, as illustrated in Fig. 71, the light shielding layer 15 can be formed above the first electrode 21 and the transfer control electrode 25. Alternatively, a structure can be adopted in which light incident on the on-chip micro lens 14 does not reach the first electrode 21 or the first electrode 21 and the transfer control electrode 25.

By adopting these configurations and structures, or alternatively by disposing the light shielding layer 15 such that light is incident only on a portion of the photoelectric conversion layer 23A located above the charge accumulation electrode 24, or alternatively by designing the on-chip micro lens 14, a portion of the photoelectric conversion layer 23A located above the first electrode 21 (or above the first electrode 21 and the transfer control electrode 25) does not contribute to photoelectric conversion. Therefore, all the pixels can be reset more reliably all at once, and a global shutter function can be achieved more easily. That is, a method for driving a solid-state imaging device including the plurality of imaging elements having these configurations and structures repeats,

discharging charges in the first electrode 21 out of the system while charges are accumulated in the inorganic oxide semiconductor material layer 23B and the like all at once in all the imaging elements, and thereafter transferring the charges accumulated in the inorganic oxide semiconductor material layer 23B and the like to the first electrode 21 all at once in all the imaging elements, and sequentially reading out the charges transferred to the first electrode 21 in each of the imaging elements after completion of the transfer.

In such a method for driving a solid-state imaging device, each of the imaging elements has a structure in which light incident from the second electrode side is not incident on the first electrode, and the charges in the first electrode are discharged out of the system while the charges are accumulated in the inorganic oxide semiconductor material layer and the like all at once in all the imaging elements. Therefore, the first electrode can be reliably reset simultaneously in all the imaging elements. Then, thereafter, the charges accumulated in the inorganic oxide semiconductor material layer and the like are transferred to the first electrode all at once in all the imaging elements, and after completion of the transfer, the charges transferred to the first electrode are sequentially read out in each of the imaging elements. Therefore, a so-called global shutter function can be easily implemented.

In a case where the single inorganic oxide semiconductor material layer 23B common to a plurality of imaging elements is formed, an end of the inorganic oxide semiconductor material layer 23B is desirably covered with at least the photoelectric conversion layer 23A from a viewpoint of protecting the end of the inorganic oxide semiconductor material layer 23B. The structure of the imaging element in such a case only needs to be a structure whose schematic cross-sectional view is illustrated at the right end of the inorganic oxide semiconductor material layer 23B illustrated in Fig. 1.

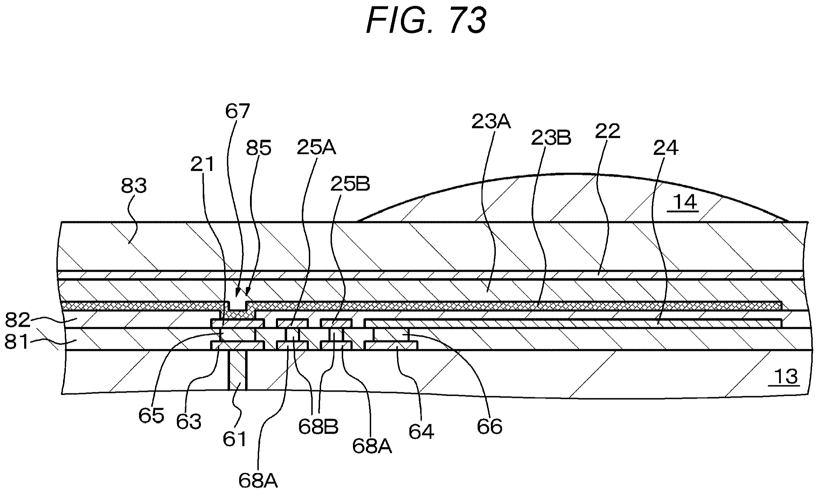

Furthermore, as a modification of Example 4, as illustrated in Fig. 73, a plurality of transfer control electrodes may be disposed from a position closest to the first electrode 21 toward the charge accumulation electrode 24. Note that Fig. 73 illustrates an example in which two transfer control electrodes 25A and 25B are disposed. In addition, a structure can be adopted in which the on-chip micro lens 14 is disposed above the charge accumulation electrode 24 and the second electrode 22, and light incident on the on-chip micro lens 14 is collected by the charge accumulation electrode 24 and does not reach the first electrode 21 and the transfer control electrodes 25A and 25B.

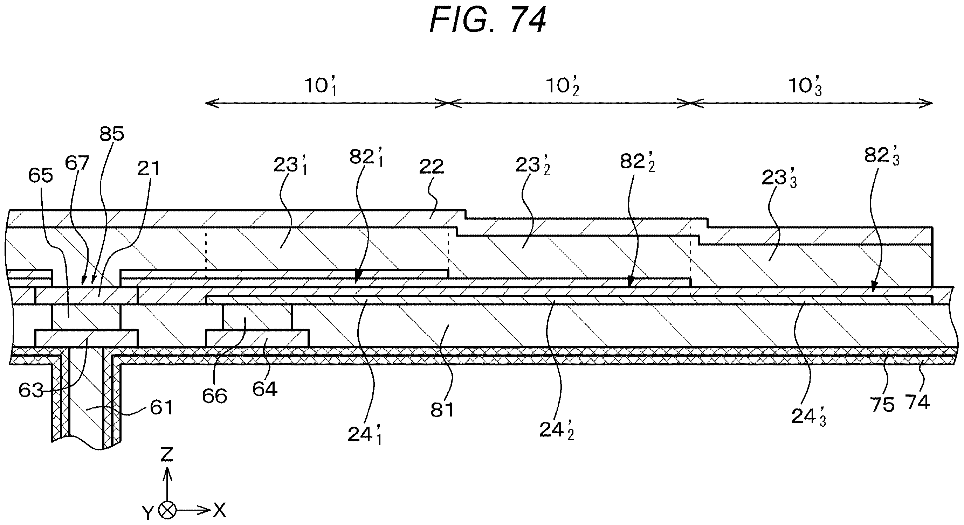

In Example 7 illustrated in Figs. 37 and 38, by gradually reducing the thicknesses of the charge accumulation electrode segments $24'_1$, $24'_2$, and $24'_3$, the thicknesses of the insulating layer segments $82'_1$, $82'_2$, and $82'_3$ are gradually increased. Meanwhile, as Fig. 74 illustrates a schematic partial cross-sectional view obtained by enlarging a portion where a charge accumulation electrode, an inorganic oxide semiconductor material layer, a photoelectric conversion layer, and a second electrode are laminated in a modification of the of Example 7, the thicknesses of the charge accumulation electrode segments $24'_1$, $24'_2$, and $24'_3$ may be constant, and the thicknesses of the insulating layer segments $82'_1$, $82'_2$, and $82'_3$ may be gradually increased. Note that the thicknesses of the photoelectric conversion layer segments $23'_1$, $23'_2$, and $23'_3$ are constant.

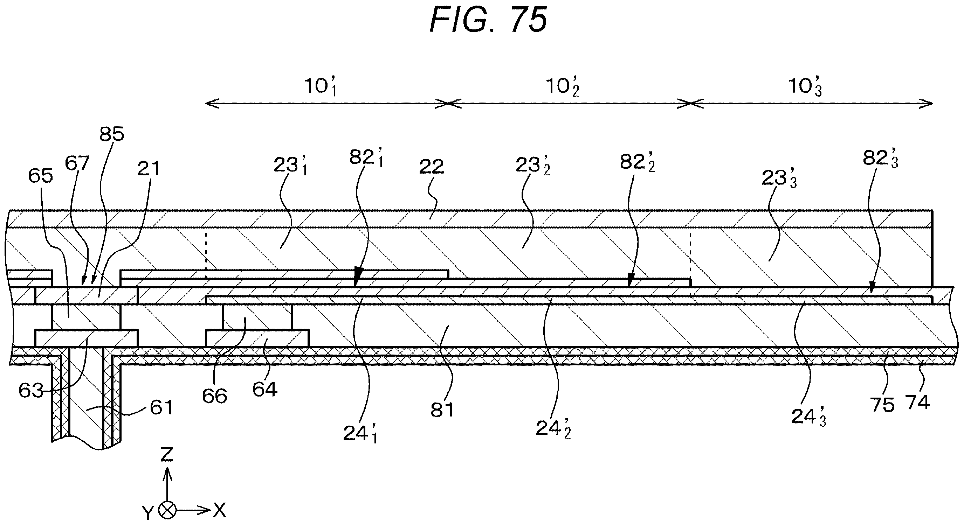

Furthermore, in Example 8 illustrated in Fig. 40, by gradually reducing the thicknesses of the charge accumulation electrode segments $24'_1$, $24'_2$, and $24'_3$, the thicknesses of the photoelectric conversion layer segments $23'_1$, $23'_2$, and $23'_3$ are gradually increased. Meanwhile, as Fig. 75 illustrates a schematic partial cross-sectional view obtained by enlarging a portion where a charge accumulation electrode, a photoelectric conversion layer, and a second electrode are laminated in a modification of the of Example 8, by making the thicknesses of the charge accumulation electrode segments $24'_1$, $24'_2$, and $24'_3$ constant, and gradually reducing the thicknesses of the insulating layer segments $82'_1$, $82'_2$, and $82'_3$, the thicknesses of the photoelectric conversion layer segments $23'_1$, $23'_2$, and $23'_3$ may be gradually increased.

It goes without saying that the various modifications described above can also be applied to Examples 2 to 14.

In Examples, the case where the present disclosure is applied to a CMOS type solid-state imaging device in which unit pixels that detect signal charges corresponding to the amount of incident light as physical quantities are arranged in a matrix has been described as an example. However, the present disclosure is not limited to application to the CMOS type solid-state imaging device, and can also be applied to a CCD type solid-state imaging device. In the latter case, signal charges are transferred in the vertical direction by a vertical transfer register having a CCD type structure, transferred in the horizontal direction by a horizontal transfer register, and amplified to output a pixel signal (image signal). Furthermore, the present disclosure is not limited to a general column type solid-state imaging device in which pixels are formed in a two-dimensional matrix and a column signal processing circuit is disposed for each pixel column. Moreover, in some cases, the selection transistor can be omitted.

Moreover, the imaging element of the present disclosure is not limited to application to a solid-state imaging device that detects distribution of the amount of incident visible light and images the distribution as an image, but can also be applied to a solid-state imaging device that images distribution of the incident amount of infrared rays, X-rays, particles, and the like as an image. Furthermore, in a broad sense, the present disclosure can be applied to a general solid-state imaging device (physical quantity distribution detection device) such as a fingerprint detection sensor that detects distribution of other physical quantities such as pressure and capacitance, and images the distribution as an image.

Moreover, the present disclosure is not limited to a solid-state imaging device that sequentially scans each unit pixel of an imaging region in row units and reads out a pixel signal from each unit pixel. The present disclosure can also be applied to an X-Y address type solid-state imaging device that selects an arbitrary pixel in pixel units and reads out a pixel signal in pixel units from a selected pixel. The solid-state imaging device may be formed as one chip, or may be a modular form having an imaging function in which an imaging region and a drive circuit or an optical system are packaged collectively.

Furthermore, the present disclosure is not limited to application to a solid-state imaging device, but can also be applied to an imaging device. Here, the imaging device refers to a camera system such as a digital still camera or a digital video camera, or an electronic device having an imaging function, such as a mobile phone. There is a case where a module form mounted on an electronic device, that is, a camera module is used as an imaging device.

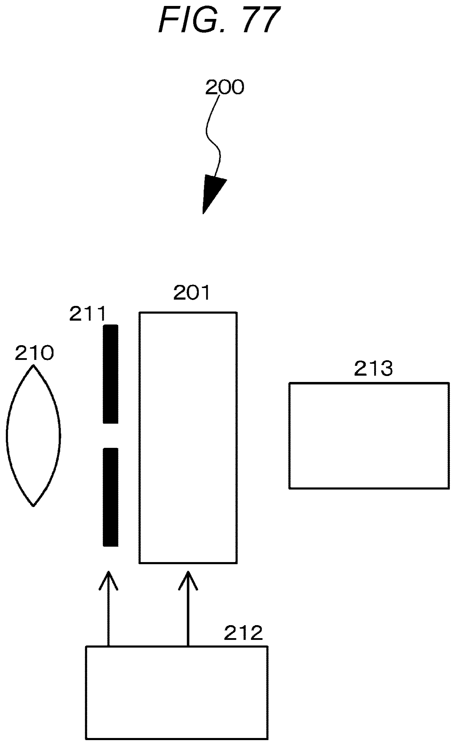

Fig. 77 illustrates an example in which a solid-state imaging device 201 including the imaging element of the present disclosure is used for an electronic device (camera) 200 as a conceptual diagram. The electronic device 200 includes the solid-state imaging device 201, an optical lens 210, a shutter device 211, a drive circuit 212, and a signal processing circuit 213. The optical lens 210 forms an image of image light (incident light) from a subject on an imaging surface of the solid-state imaging device 201. As a result, signal charges are accumulated in the solid-state imaging device 201 for a certain period of time. The shutter device 211 controls a light irradiation period and a light shielding period for the solid-state imaging device 201. The drive circuit 212 supplies a driving signal for controlling a transfer operation and the like of the solid-state imaging device 201 and a shutter operation of the shutter device 211. The solid-state imaging device 201 transfers a signal by a driving signal (timing signal) supplied from the drive circuit 212. The signal processing circuit 213 performs various signal processes. A video signal that has been subjected to signal processing is stored in a storage medium such as a memory or is output to a monitor. In such an electronic device 200, the pixel size in the solid-state imaging device 201 can be reduced and the charge transfer efficiency can be improved, and therefore the electronic device 200 with improved pixel characteristics can be obtained. The electronic device 200 to which the solid-state imaging device 201 can be applied is not limited to a camera, and can be applied to an imaging device such as a digital still camera or a camera module for a mobile device such as a mobile phone.

The technology according to the present disclosure (the present technology) can be applied to various products. For example, the technology according to the present disclosure may be achieved as an apparatus mounted on any type of mobile body such as an automobile, an electric vehicle, a hybrid electric vehicle, a motorcycle, a bicycle, a personal mobility, an airplane, a drone, a ship, or a robot.

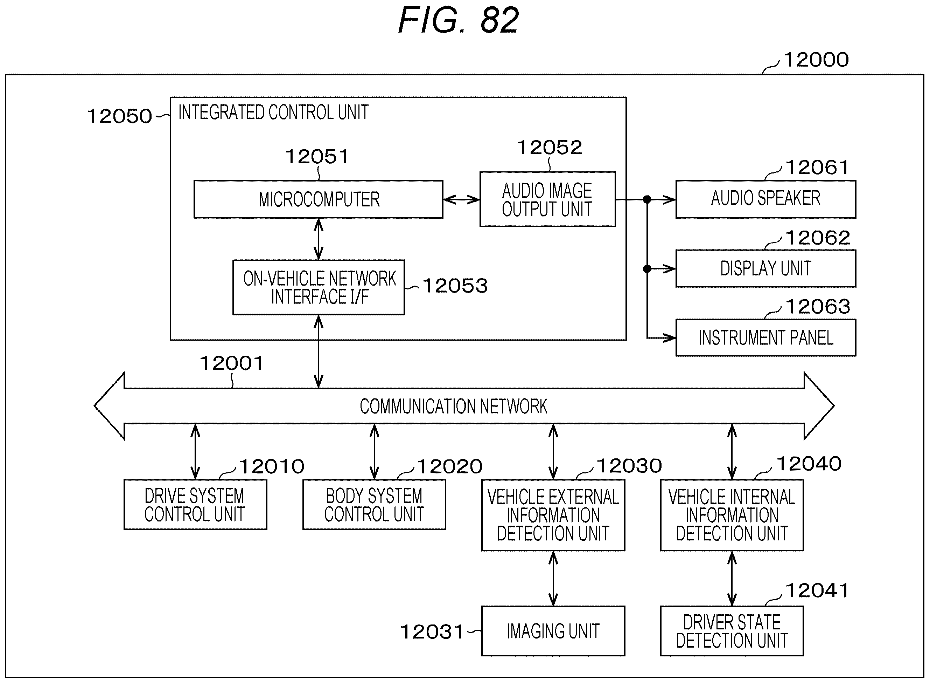

Fig. 82 is a block diagram illustrating an example of a schematic configuration of a vehicle control system which is an example of a mobile body control system to which the technology according to the present disclosure can be applied.

A vehicle control system 12000 includes a plurality of electronic control units connected to one another via a communication network 12001. In the example illustrated in Fig. 82, the vehicle control system 12000 includes a drive system control unit 12010, a body system control unit 12020, a vehicle external information detection unit 12030, a vehicle internal information detection unit 12040, and an integrated control unit 12050. Furthermore, as a functional configuration of the integrated control unit 12050, a microcomputer 12051, an audio image output unit 12052, and an on-vehicle network interface (I/F) 12053 are illustrated.

The drive system control unit 12010 controls an operation of a device related to a drive system of a vehicle according to various programs. For example, the drive system control unit 12010 functions as a control device of a driving force generating device for generating a driving force of a vehicle such as an internal combustion engine or a driving motor, a driving force transmitting mechanism for transmitting a driving force to wheels, a steering mechanism for adjusting a rudder angle of a vehicle, a braking device for generating a braking force of a vehicle, or the like.

The body system control unit 12020 controls operations of various devices mounted on a vehicle body according to various programs. For example, the body system control unit 12020 functions as a control device of a keyless entry system, a smart key system, a power window device, or various lamps such as a head lamp, a back lamp, a brake lamp, a turn indicator, and a fog lamp. In this case, to the body system control unit 12020, a radio wave transmitted from a portable device substituted for a key or signals of various switches can be input. The body system control unit 12020 receives input of the radio wave or signals and controls a door lock device, a power window device, a lamp, and the like of a vehicle.

The vehicle external information detection unit 12030 detects information outside a vehicle on which the vehicle control system 12000 is mounted. For example, to the vehicle external information detection unit 12030, an imaging unit 12031 is connected. The vehicle external information detection unit 12030 causes the imaging unit 12031 to image an image outside a vehicle and receives an imaged image. The vehicle external information detection unit 12030 may perform object detection processing or distance detection processing of a person, a car, an obstacle, a sign, a character on a road surface, or the like on the basis of the received image.

The imaging unit 12031 is a light sensor for receiving light and outputting an electric signal corresponding to the amount of light received. The imaging unit 12031 can output an electric signal as an image or output the electric signal as distance measurement information. Furthermore, the light received by the imaging unit 12031 may be visible light or invisible light such as infrared light.

The vehicle internal information detection unit 12040 detects information inside a vehicle. To the vehicle internal information detection unit 12040, for example, a driver state detection unit 12041 for detecting the state of a driver is connected. The driver state detection unit 12041 includes, for example, a camera for imaging a driver. The vehicle internal information detection unit 12040 may calculate the degree of fatigue or the degree of concentration of a driver or may determine whether or not the driver is dozing off on the basis of detection information input from the driver state detection unit 12041.

The microcomputer 12051 can calculate a control target value of a driving force generating device, a steering mechanism, or a braking device on the basis of information inside and outside a vehicle, acquired by the vehicle external information detection unit 12030 or the vehicle internal information detection unit 12040, and can output a control command to the drive system control unit 12010. For example, the microcomputer 12051 can perform cooperative control aiming at realizing a function of advanced driver assistance system (ADAS) including collision avoidance or impact mitigation of a vehicle, following travel based on inter-vehicle distance, vehicle speed maintenance travel, vehicle collision warning, vehicle lane departure warning, and the like.

Furthermore, the microcomputer 12051 can perform cooperative control aiming at, for example, automatic driving that autonomously travels without depending on driver's operation by controlling a driving force generating device, a steering mechanism, a braking device, or the like on the basis of information around a vehicle, acquired by the vehicle external information detection unit 12030 or the vehicle internal information detection unit 12040.

Furthermore, the microcomputer 12051 can output a control command to the body system control unit 12020 on the basis of vehicle external information acquired by the vehicle external information detection unit 12030. For example, the microcomputer 12051 can perform cooperative control aiming at antiglare such as switching from high beam to low beam by controlling a headlamp according to the position of a preceding vehicle or an oncoming vehicle detected by the vehicle external information detection unit 12030.

The audio image output unit 12052 transmits at least one of an audio output signal or an image output signal to an output device capable of visually or audibly notifying a passenger of a vehicle or the outside of the vehicle of information. In the example of Fig. 82, as the output device, an audio speaker 12061, a display unit 12062, and an instrument panel 12063 are illustrated. The display unit 12062 may include an on-board display and/or a head-up display, for example.

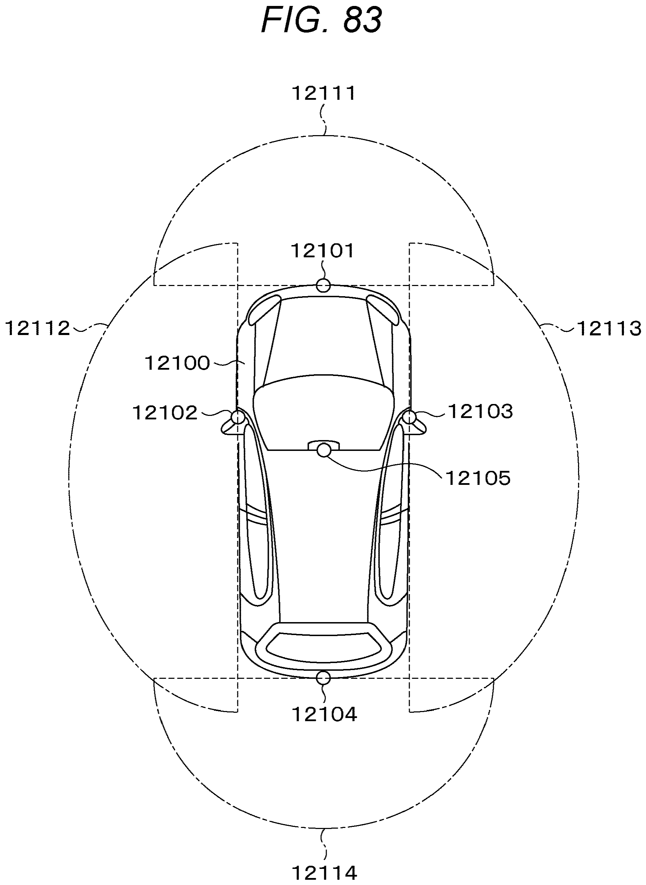

Fig. 83 is a diagram illustrating an example of an installation position of the imaging unit 12031.

In Fig. 83, the vehicle 12100 includes imaging units 12101, 12102, 12103, 12104, and 12105 as the imaging unit 12031.

The imaging units 12101, 12102, 12103, 12104, and 12105 are disposed, for example, in a front nose, a side mirror, a rear bumper, and a back door of the vehicle 12100, in an upper portion of a front glass in a passenger compartment, and the like. The imaging unit 12101 disposed in a front nose and the imaging unit 12105 disposed in an upper portion of a front glass in a passenger compartment mainly acquire images in front of the vehicle 12100. The imaging units 12102 and 12103 disposed in side mirrors mainly acquire images on sides of the vehicle 12100. The imaging unit 12104 disposed in a rear bumper or a back door mainly acquires an image behind the vehicle 12100. The front images acquired by the imaging units 12101 and 12105 are mainly used for detecting a preceding vehicle, a pedestrian, an obstacle, a traffic signal, a traffic sign, a lane, or the like.

Note that Fig. 83 illustrates examples of imaging ranges of the imaging units 12101 to 12104. An imaging range 12111 indicates an imaging range of the imaging unit 12101 disposed in a front nose. Imaging ranges 12112 and 12113 indicate imaging ranges of the imaging units 12102 and 12103 disposed in side mirrors, respectively. An imaging range 12114 indicates an imaging range of the imaging unit 12104 disposed in a rear bumper or a back door. For example, by superimposing image data imaged by the imaging units 12101 to 12104 on one another, an overhead view image of the vehicle 12100 viewed from above is obtained.

At least one of the imaging units 12101 to 12104 may have a function of acquiring distance information. For example, at least one of the imaging units 12101 to 12104 may be a stereo camera including a plurality of imaging elements, or may be an imaging element having pixels for phase difference detection.

For example, the microcomputer 12051 determines a distance to each three-dimensional object in the imaging range 12111 to 12114 and a temporal change (relative speed with respect to the vehicle 12100) of the distance on the basis of the distance information obtained from the imaging units 12101 to 12104, and can thereby particularly extract a three-dimensional object which is the nearest three-dimensional object on a traveling path of the vehicle 12100 and is traveling at a predetermined speed (for example, 0 km/h or more) in substantially the same direction as the vehicle 12100 as a preceding vehicle. Moreover, the microcomputer 12051 can set an inter-vehicle distance to be secured in advance in front of the preceding vehicle, and can perform automatic brake control (including following stop control), automatic acceleration control (including following start control), and the like. In this way, it is possible to perform cooperative control aiming at, for example, automatic driving that autonomously travels without depending on driver's operation.

For example, the microcomputer 12051 classifies three-dimensional object data related to a three-dimensional object into a two-wheeled vehicle, a regular vehicle, a large vehicle, a pedestrian, and another three-dimensional object such as a telegraph pole on the basis of the distance information obtained from the imaging units 12101 to 12104 and extracts data, and can use the extracted data for automatic avoidance of an obstacle. For example, the microcomputer 12051 identifies an obstacle around the vehicle 12100 as an obstacle that a driver of the vehicle 12100 can see and an obstacle that is difficult to see. Then, the microcomputer 12051 judges a collision risk indicating a risk of collision with each obstacle. When the collision risk is higher than a set value and there is a possibility of collision, the microcomputer 12051 can perform driving assistance for avoiding collision by outputting an alarm to a driver via the audio speaker 12061 or the display unit 12062, or performing forced deceleration or avoiding steering via the drive system control unit 12010.

At least one of the imaging units 12101 to 12104 may be an infrared camera for detecting an infrared ray. For example, the microcomputer 12051 can recognize a pedestrian by determining whether or not a pedestrian exists in imaged images of the imaging units 12101 to 12104. Such recognition of a pedestrian is performed by, for example, a procedure of extracting characteristic points in imaged images of the imaging units 12101 to 12104 as infrared cameras and a procedure of performing pattern matching processing on a series of characteristic points indicating an outline of an object and determining whether or not a pedestrian exists. If the microcomputer 12051 determines that a pedestrian exists in imaged images of the imaging units 12101 to 12104 and recognizes a pedestrian, the audio image output unit 12052 controls the display unit 12062 such that the display unit 12062 superimposes and displays a rectangular contour line for emphasis on the recognized pedestrian. Furthermore, the audio image output unit 12052 may control the display unit 12062 such that the display unit 12062 displays an icon or the like indicating a pedestrian at a desired position.

Furthermore, for example, the technology according to the present disclosure may be applied to an endoscopic surgical system.

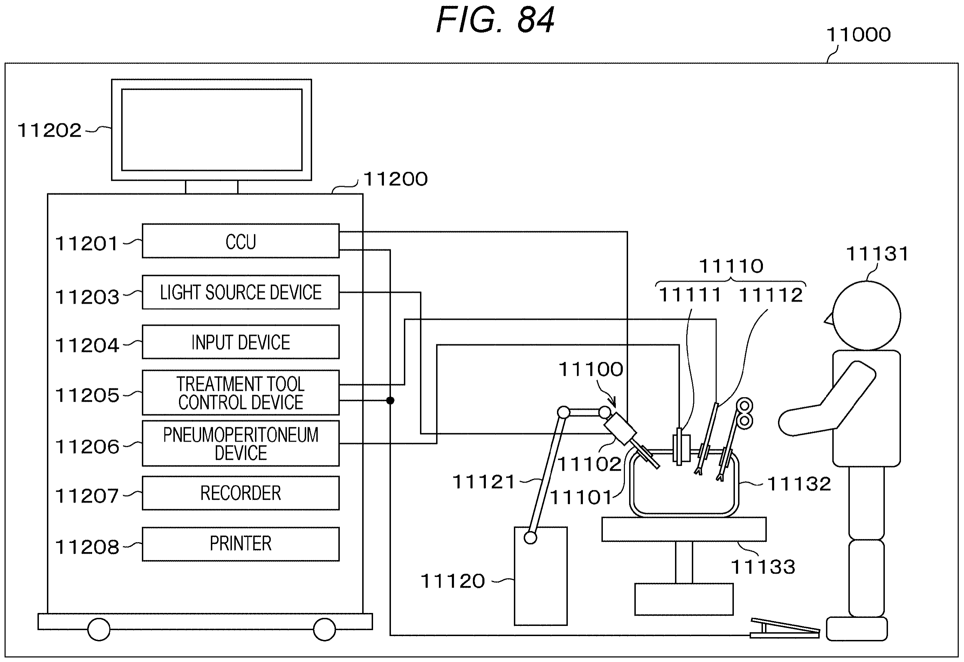

Fig. 84 is a diagram illustrating an example of a schematic configuration of an endoscopic surgical system to which the technology according to the present disclosure (the present technology) can be applied.

Fig. 84 illustrates a situation in which a surgeon (physician) 11131 is performing surgery on a patient 11132 on a patient bed 11133 using an endoscopic surgical system 11000. As illustrated in the drawing, the endoscopic surgical system 11000 includes an endoscope 11100, another surgical tool 11110 such as a pneumoperitoneum tube 11111 or an energy treatment tool 11112, a support arm device 11120 for supporting the endoscope 11100, and a cart 11200 on which various devices for endoscopic surgery are mounted.

The endoscope 11100 includes a lens barrel 11101 to be inserted into a body cavity of the patient 11132 in a region of a predetermined length from a tip thereof, and a camera head 11102 connected to a proximal end of the lens barrel 11101. In the illustrated example, the endoscope 11100 configured as a so-called rigid mirror including the rigid lens barrel 11101 is illustrated, but the endoscope 11100 may be configured as a so-called flexible mirror including a flexible lens barrel.

At the tip of the lens barrel 11101, an opening into which an objective lens is fitted is disposed. A light source device 11203 is connected to the endoscope 11100. Light generated by the light source device 11203 is guided to the tip of the lens barrel by a light guide extended inside the lens barrel 11101, and is emitted toward an observation target in a body cavity of the patient 11132 via the objective lens. Note that the endoscope 11100 may be a forward-viewing endoscope, an oblique-viewing endoscope, or a side-viewing endoscope.

An optical system and an imaging element are disposed inside the camera head 11102. Reflected light (observation light) from an observation target is converged on the imaging element by the optical system. The observation light is photoelectrically converted by the imaging element, and an electric signal corresponding to the observation light, that is, an image signal corresponding to an observation image is generated. The image signal is transmitted as RAW data to a camera control unit (CCU) 11201.

The CCU 11201 includes a central processing unit (CPU), a graphics processing unit (GPU), and the like, and integrally controls operations of the endoscope 11100 and the display device 11202. Moreover, the CCU 11201 receives an image signal from the camera head 11102, and performs, on the image signal, various image processing for displaying an image based on the image signal, such as development processing (demosaic processing), for example.

The display device 11202 displays an image based on an image signal subjected to image processing by the CCU 11201 under the control of the CCU 11201.

The light source device 11203 includes a light source such as a light emitting diode (LED), for example, and supplies irradiation light for imaging a surgical site or the like to the endoscope 11100.

An input device 11204 is an input interface to the endoscopic surgical system 11000. A user can input various kinds of information and instructions to the endoscopic surgical system 11000 via the input device 11204. For example, the user inputs an instruction or the like to change imaging conditions (type of irradiation light, magnification, focal length, and the like) by the endoscope 11100.

A treatment tool control device 11205 controls driving of the energy treatment tool 11112 for cauterizing and cutting a tissue, sealing a blood vessel, or the like. A pneumoperitoneum device 11206 feeds a gas into a body cavity via the pneumoperitoneum tube 11111 in order to inflate the body cavity of the patient 11132 for the purpose of securing a field of view by the endoscope 11100 and securing a working space of a surgeon. A recorder 11207 is a device capable of recording various kinds of information regarding surgery. A printer 11208 is a device capable of printing various kinds of information regarding surgery in various formats such as a text, an image, and a graph.

Note that the light source device 11203 for supplying irradiation light used for imaging a surgical site to the endoscope 11100 may include an LED, a laser light source, or a white light source constituted by a combination thereof, for example. In a case where the white light source is constituted by a combination of RGB laser light sources, the output intensity and the output timing of each color (each wavelength) can be controlled with high precision, and therefore adjustment of a white balance of an imaged image can be performed by the light source device 11203. Furthermore, in this case, by irradiating an observation target with laser light from each of the RGB laser light sources in a time division manner and controlling driving of an imaging element of the camera head 11102 in synchronization with the irradiation timing, it is also possible to image an image corresponding to each of RGB in a time division manner. According to this method, a color image can be obtained without disposing a color filter in the imaging element.

Furthermore, driving of the light source device 11203 may be controlled so as to change the intensity of light output at predetermined time intervals. By controlling driving of the imaging element of the camera head 11102 in synchronization with the timing of the change of the intensity of the light to acquire an image in a time division manner and synthesizing the image, a high dynamic range image without so-called blocked up shadows or blown out highlights can be generated.

Furthermore, the light source device 11203 may be configured so as to be able to supply light in a predetermined wavelength band corresponding to special light observation. In the special light observation, for example, by irradiation with light in a narrower band than irradiation light (in other words, white light) at the time of ordinary observation using wavelength dependency of light absorption in a body tissue, a predetermined tissue such as a blood vessel of a mucosal surface layer is imaged at a high contrast, that is, so-called narrow band imaging is performed. Alternatively, in the special light observation, fluorescence observation for obtaining an image by fluorescence generated by irradiation with excitation light may be performed. In the fluorescence observation, it is possible to observe fluorescence from a body tissue (autofluorescence observation) by irradiating the body tissue with excitation light, or to obtain a fluorescent image by injecting a reagent such as indocyanine green (ICG) into a body tissue and irradiating the body tissue with excitation light corresponding to a fluorescence wavelength of the reagent, for example. The light source device 11203 can be configured so as to be able to supply narrow band light and/or excitation light corresponding to such special light observation.

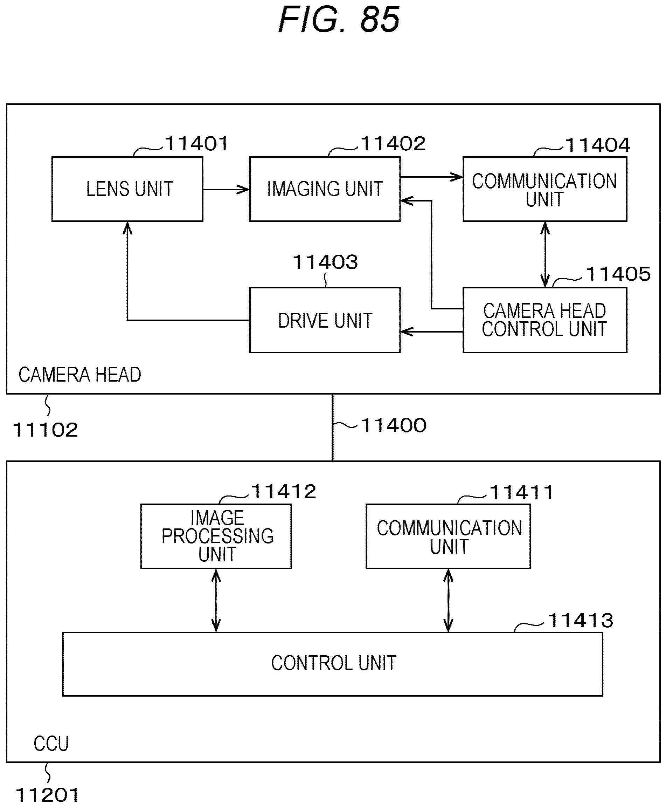

Fig. 85 is a block diagram illustrating examples of functional configurations of the camera head 11102 and the CCU 11201 illustrated in Fig. 84.

The camera head 11102 includes a lens unit 11401, an imaging unit 11402, a drive unit 11403, a communication unit 11404, and a camera head control unit 11405. The CCU 11201 includes a communication unit 11411, an image processing unit 11412, and a control unit 11413. The camera head 11102 and the CCU 11201 are communicably connected to each other by a transmission cable 11400.

The lens unit 11401 is an optical system disposed at a connecting portion with the lens barrel 11101. Observation light taken in from a tip of the lens barrel 11101 is guided to the camera head 11102 and is incident on the lens unit 11401. The lens unit 11401 includes a combination of a plurality of lenses including a zoom lens and a focus lens.

The imaging unit 11402 includes an imaging element. The imaging unit 11402 may include one imaging element (so-called single plate type) or a plurality of imaging elements (so-called multiplate type). In a case where the imaging unit 11402 includes multiplate type imaging elements, for example, an image signal corresponding to each of RGB may be generated by each imaging element, and a color image may be obtained by synthesizing these image signals. Alternatively, the imaging unit 11402 may include a pair of imaging elements for acquiring an image signal for each of the right eye and the left eye corresponding to three-dimensional (3D) display. By performing the 3D display, the surgeon 11131 can grasp the depth of a living tissue in a surgical site more accurately. Note that in a case where the imaging unit 11402 includes multiplate type imaging elements, a plurality of lens units 11401 can be disposed corresponding to the respective imaging elements.

Furthermore, the imaging unit 11402 is not necessarily disposed in the camera head 11102. For example, the imaging unit 11402 may be disposed just behind an objective lens inside the lens barrel 11101.

The drive unit 11403 includes an actuator, and moves a zoom lens and a focus lens of the lens unit 11401 by a predetermined distance along an optical axis under control of the camera head control unit 11405. Therefore, the magnification and the focus of an image imaged by the imaging unit 11402 can be appropriately adjusted.

The communication unit 11404 includes a communication device for transmitting and receiving various kinds of information to and from the CCU 11201. The communication unit 11404 transmits an image signal obtained from the imaging unit 11402 as RAW data to the CCU 11201 via the transmission cable 11400.

Furthermore, the communication unit 11404 receives a control signal for controlling driving of the camera head 11102 from the CCU 11201, and supplies the control signal to the camera head control unit 11405. The control signal includes information regarding imaging conditions such as information indicating designation of a frame rate of an imaged image, information indicating designation of an exposure value at the time of imaging, and/or information indicating designation of the magnification and the focus of an imaged image, for example.

Note that the imaging conditions such as the above-described frame rate, exposure value, magnification, and focus may be appropriately designated by a user, or may be automatically set by the control unit 11413 of the CCU 11201 on the basis of an acquired image signal. In the latter case, the endoscope 11100 has a so-called auto exposure (AE) function, a so-called auto focus (AF) function, and a so-called auto white balance (AWB) function.

The camera head control unit 11405 controls driving of the camera head 11102 on the basis of a control signal from the CCU 11201 received via the communication unit 11404.

The communication unit 11411 includes a communication device for transmitting and receiving various kinds of information to and from the camera head 11102. The communication unit 11411 receives an image signal transmitted from the camera head 11102 via the transmission cable 11400.

Furthermore, the communication unit 11411 transmits a control signal for controlling driving of the camera head 11102 to the camera head 11102. The image signal and the control signal can be transmitted by electric communication, optical communication, or the like.

The image processing unit 11412 performs various kinds of image processing on the image signal which is RAW data transmitted from the camera head 11102.

The control unit 11413 performs various kinds of control concerning imaging of a surgical site or the like by the endoscope 11100 and display of an imaged image obtained by imaging a surgical site or the like. For example, the control unit 11413 generates a control signal for controlling driving of the camera head 11102.

Furthermore, the control unit 11413 causes the display device 11202 to display an imaged image of a surgical site or the like on the basis of an image signal subjected to image processing by the image processing unit 11412. In this case, the control unit 11413 may recognize various objects in the imaged image using various image recognition techniques. For example, by detecting the shape, color, and the like of an edge of an object included in the imaged image, the control unit 11413 can recognize a surgical tool such as forceps, a specific living body part, bleeding, a mist at the time of using the energy treatment tool 11112, and the like. When the display device 11202 displays the imaged image, the control unit 11413 may cause the display device 11202 to superimpose and display various kinds of surgical support information on the image of the surgical site using the recognition result. The surgical support information is superimposed and displayed, and presented to the surgeon 11131. This makes it possible to reduce a burden on the surgeon 11131 and makes it possible for the surgeon 11131 to reliably perform surgery.

The transmission cable 11400 connecting the camera head 11102 to the CCU 11201 is an electric signal cable corresponding to communication of an electric signal, an optical fiber corresponding to optical communication, or a composite cable thereof.

Here, in the illustrated example, communication is performed by wire using the transmission cable 11400, but communication between the camera head 11102 and the CCU 11201 may be performed wirelessly.

Note that the endoscopic surgical system has been described as an example here. However, the technology according to the present disclosure may also be applied to, for example, a microscopic surgery system or the like.

Note that the present disclosure can have the following

REFERENCE SIGNS LIST

10'$_1$, 10'$_2$, 10'$_3$ Photoelectric conversion unit segment
13 Various imaging element components located below interlayer insulating layer
14 On-chip micro lens (OCL)
15 Light shielding layer
21 First electrode
22 Second electrode
23A Photoelectric conversion layer
23B Inorganic oxide semiconductor material layer
23'$_1$, 23'$_2$, 23'$_3$ Photoelectric conversion layer segment
24, 24"$_1$, 24"$_2$, 24"$_3$ Charge accumulation electrode
24A, 24B, 24C, 24'$_1$, 24'$_2$, 24'$_3$ Charge accumulation electrode segment
25, 25A, 25B Transfer control electrode (charge transfer electrode)
26 Charge discharge electrode
27, 27A$_1$, 27A$_2$, 27A$_3$, 27B$_1$, 27B$_2$, 27B$_3$, 27C Charge transfer control electrode
41, 43 n-Type semiconductor region

42, 44, 73 p$^+$ layer

45, 46 Gate portion of transfer transistor

51 Gate portion of reset transistor TR1$_{rst}$

51A Channel formation region of reset transistor TR1$_{rst}$

51B, 51C Source/drain region of reset transistor TR1$_{rst}$

52 Gate portion of amplification transistor TR1$_{amp}$

52A Channel formation region of amplification transistor TR1$_{amp}$

52B, 52C Source/drain region of amplification transistor TR1$_{amp}$

53 Gate portion of selection transistor TR1$_{sel}$

53A Channel formation region of selection transistor TR1$_{sel}$

53B, 53C Source/drain region of selection transistor TR1$_{sel}$

61 Contact hole portion

62 Wiring layer

63, 64, 68A Pad portion

65, 68B Connection hole

66, 67, 69 Connection portion

70 Semiconductor substrate

70A First surface (front surface) of semiconductor substrate

70B Second surface (back surface) of semiconductor substrate

71 Element isolation region

72 Oxide film

74 HfO$_2$ film

75 Insulating material film

76, 81 Interlayer insulating layer

82 Insulating layer

82'$_1$, 82'$_2$, 82'$_3$ Insulating layer segment

82a First surface of insulating layer

82b Second surface of insulating layer

82c Third surface of insulating layer

83 Insulating layer

85, 85A, 85B, 85C Opening

86, 86A Second opening

100 Solid-state imaging device

101 Laminated imaging element

111 Imaging region

112 Vertical drive circuit

113 Column signal processing circuit

114 Horizontal drive circuit

115 Output circuit

116 Drive control circuit

117 Signal line (data output line)

118 Horizontal signal line

200 Electronic device (camera)

201 Solid-state imaging device

210 Optical lens

211 Shutter device

212 Drive circuit

213 Signal processing circuit

FD$_1$, FD$_2$, FD$_3$, 45C, 46C Floating diffusion layer

TR1$_{trs}$, TR2$_{trs}$, TR3$_{trs}$ Transfer transistor

TR1$_{rst}$, TR2$_{rst}$, TR3$_{rst}$ Reset transistor

TR1$_{amp}$, TR2$_{amp}$, TR3$_{amp}$ Amplification transistor

TR1$_{sel}$, TR3$_{sel}$, TR3$_{sel}$ Selection transistor

V$_{DD}$ Power source

TG$_1$, TG$_2$, TG$_3$ Transfer gate line

RST$_1$, RST$_2$, RST$_3$ Reset line

SEL$_1$, SEL$_2$, SEL$_3$ Selection line

VSL, VSL$_1$, VSL$_2$, VSL$_3$ Signal line (data output line)

$V_{OA}$, $V_{OT}$, $V_{OU}$ Wiring

**Claims**

1. An imaging element comprising

   a photoelectric conversion unit formed by laminating a first electrode (21), a photoelectric conversion layer (23A), and a second electrode (22), wherein
   an inorganic oxide semiconductor material layer (23B) is formed between the first electrode (21) and the photoelectric conversion layer (23A), and
   **characterised in that** the inorganic oxide semiconductor material layer (23B) is represented by $Ga_aSn_bO_c$, and

   $$a + b + c = 1.00$$

   and

   $$0.20 < b/(a + b) < 0.40$$

   are satisfied, or
   wherein the inorganic oxide semiconductor material layer (23B) is represented by $Ga_dIn_eO_f$, and

   $$d + e + f = 1.00$$

   and

   $$0.20 < e/(d + e) < 0.40$$

   are satisfied.

2. The imaging element according to claim 1, wherein when the inorganic oxide semiconductor material layer (23B) is represented by $Ga_aSn_bO_c$, $a > b$ is satisfied.

3. The imaging element according to claim 1, wherein when the inorganic oxide semiconductor material layer (23B) is represented by $Ga_dIn_eO_f$, $d > e$ is satisfied.

4. The imaging element according to any one of the preceding claims, wherein the photoelectric conversion unit further includes an insulating layer (82) and a charge accumulation electrode (24) disposed apart from the first electrode (21) so as to face the inorganic oxide semiconductor material layer (23B) via the insulating layer (82).

5. The imaging element according to any one of the preceding claims, wherein a LUMO value $E_1$ of a material constituting a portion of the photoelectric conversion layer (23A) located near the inorganic oxide semiconductor material layer (23B) and a LUMO value $E_2$ of a material constituting the inorganic oxide semiconductor material layer (23B) satisfy the following formula:

   $$E_2 - E_1 \geq 0.1 \text{ eV}.$$

6. The imaging element according to claim 5, wherein the following formula is satisfied:

   $$E_2 - E_1 > 0.1 \text{ eV}.$$

7. The imaging element according to any one of the preceding claims, wherein a material constituting the inorganic oxide semiconductor material layer (23B) has a carrier mobility of 10 cm$^2$/V·s or more.

8.  The imaging element according to any one of the preceding claims, wherein the inorganic oxide semiconductor material layer (23B) is amorphous, or has a thickness of $1 \times 10^{-8}$ m to $1.5 \times 10^{-7}$ m.

9.  The imaging element according to any one of the preceding claims, wherein

    light is incident from the second electrode (22),
    surface roughness Ra of the inorganic oxide semiconductor material layer (22B) at an interface between the photoelectric conversion layer (23A) and the inorganic oxide semiconductor material layer (23B) is 1.5 nm or less, and a value of root mean square roughness Rq of the inorganic oxide semiconductor material layer (23B) is 2.5 nm or less.

10. A laminated imaging element comprising at least one of the imaging elements according to any one of claims 1 to 9.

11. A solid-state imaging device comprising a plurality of the imaging elements according to any one of claims 1 to 10.

12. A solid-state imaging device comprising a plurality of the laminated imaging elements according to claim 10

**Patentansprüche**

1.  Bildgebungselement, das Folgendes umfasst:

    eine fotoelektrische Umwandlungseinheit, die durch Laminieren einer ersten Elektrode (21), einer fotoelektrischen Umwandlungsschicht (23A) und einer zweiten Elektrode (22) gebildet ist, wobei eine anorganische Oxidhalbleitermaterialschicht (23B) zwischen der ersten Elektrode (21) und der fotoelektrischen Umwandlungsschicht (23A) gebildet ist,
    und
    **dadurch gekennzeichnet, dass**
    die anorganische Oxidhalbleitermaterialschicht (23B) durch Ga$_a$Sn$_b$O$_c$ repräsentiert wird, und

$$a + b + c = 1,00$$

    und

$$0,20 < b / (a + b) < 0,40$$

    erfüllt werden, oder
    wobei die anorganische Oxidhalbleitermaterialschicht (23B) durch Ga$_d$In$_e$O$_f$ repräsentiert wird, und

$$d + e + f = 1,00$$

    und

$$0,20 < e / (d + e) < 0,40$$

    erfüllt werden.

2.  Bildgebungselement nach Anspruch 1, wobei, wenn die anorganische Oxidhalbleitermaterialschicht (23B) durch Ga$_a$Sn$_b$O$_c$ repräsentiert wird, a > b erfüllt ist.

3.  Bildgebungselement nach Anspruch 1, wobei, wenn die anorganische Oxidhalbleitermaterialschicht (23B) durch Ga$_d$In$_e$O$_f$ repräsentiert wird, d > e erfüllt ist.

**4.** Bildgebungselement nach einem der vorhergehenden Ansprüche, wobei die fotoelektrische Umwandlungseinheit ferner eine Isolationsschicht (82) und eine Ladungsakkumulationselektrode (24) beinhaltet, die von der ersten Elektrode (21) entfernt angeordnet ist, so dass sie über die Isolationsschicht (82) der anorganischen Oxidhalbleitermaterialschicht (23B) zugewandt ist.

**5.** Bildgebungselement nach einem der vorhergehenden Ansprüche, wobei ein LUMO-Wert $E_1$ eines Materials, das einen Teil der fotoelektrischen Umwandlungsschicht (23A) darstellt, der sich nahe der anorganischen Oxidhalbleitermaterialschicht (23B) befindet, und ein LUMO-Wert $E_2$ eines Materials, das die anorganische Oxidhalbleitermaterialschicht (23B) darstellt, die folgende Formel erfüllen:

$$E_2 - E_1 \geq 0,1 \text{ eV}.$$

**6.** Bildgebungselement nach Anspruch 5, wobei die folgende Formel erfüllt wird:

$$E_2 - E_1 > 0,1 \text{ eV}.$$

**7.** Bildgebungselement nach einem der vorhergehenden Ansprüche, wobei ein Material, das die anorganische Oxidhalbleitermaterialschicht (23B) darstellt, eine Ladungsträgermobilität von 10 cm$^2$/V·s oder mehr aufweist.

**8.** Bildgebungselement nach einem der vorhergehenden Ansprüche, wobei die anorganische Oxidhalbleitermaterialschicht (23B) amorph ist oder eine Dicke von $1 \times 10^{-8}$ m bis $1,5 \times 10^{-7}$ m aufweist.

**9.** Bildgebungselement nach einem der vorhergehenden Ansprüche, wobei

Licht von der zweiten Elektrode (22) einfällt,
eine Oberflächenrauigkeit Ra der anorganischen Oxidhalbleitermaterialschicht (22B) an einer Grenzfläche zwischen der fotoelektrischen Umwandlungsschicht (23A) und der anorganischen Oxidhalbleitermaterialschicht (23B) 1,5 nm oder weniger beträgt und ein Wert einer mittleren quadratisch Rauigkeit Rq der anorganischen Oxidhalbleitermaterialschicht (23B) 2,5 nm oder weniger beträgt.

**10.** Laminiertes Bildgebungselement, das wenigstens eines der Bildgebungselemente nach einem der Ansprüche 1 bis 9 umfasst.

**11.** Festkörperbildgebungsvorrichtung, die mehrere Bildgebungselemente nach einem der Ansprüche 1 bis 10 umfasst.

**12.** Festkörperbildgebungsvorrichtung, die mehrere der laminierten Bildgebungselemente nach Anspruch 10 umfasst.

**Revendications**

**1.** Élément d'imagerie comprenant :

une unité de conversion photoélectrique formée en stratifiant une première électrode (21), une couche de conversion photoélectrique (23A) et une seconde électrode (22),
une couche de matériau semi-conducteur d'oxyde inorganique (23B) étant formée entre la première électrode (21) et la couche de conversion photoélectrique (23A), et
**caractérisé en ce que** la couche de matériau semi-conducteur d'oxyde inorganique (23B) est représentée par $Ga_aSn_bO_c$, et

$$a + b + c = 1,00$$

et

$$0,20 < b/(a + b) < 0,40$$

sont satisfaites, ou
la couche de matériau semi-conducteur d'oxyde inorganique (23B) étant représentée par $Ga_dIn_eO_f$, et

$$d + e + f = 1,00$$

et

$$0,20 < e/(d + e) < 0,40$$

sont satisfaites.

2. Élément d'imagerie selon la revendication 1, lorsque la couche de matériau semi-conducteur d'oxyde inorganique (23B) est représentée par $Ga_aSn_bO_c$, a > b étant satisfait.

3. Élément d'imagerie selon la revendication 1, lorsque la couche de matériau semi-conducteur d'oxyde inorganique (23B) est représentée par $Ga_dIn_eO_f$, d > e étant satisfait.

4. Élément d'imagerie selon l'une quelconque des revendications précédentes, l'unité de conversion photoélectrique comprenant en outre une couche isolante (82) et une électrode d'accumulation de charge (24) disposée à l'écart de la première électrode (21) de manière à faire face à la couche de matériau semi-conducteur d'oxyde inorganique (23B) par l'intermédiaire de la couche isolante (82).

5. Élément d'imagerie selon l'une quelconque des revendications précédentes, une valeur LUMO $E_1$ d'un matériau constituant une partie de la couche de conversion photoélectrique (23A) située près de la couche de matériau semi-conducteur d'oxyde inorganique (23B) et une valeur LUMO $E_2$ d'un matériau constituant la couche de matériau semi-conducteur d'oxyde inorganique (23B) satisfaisant la formule suivante :

$$E_2 - E_1 \geq 0,1 \ eV.$$

6. Élément d'imagerie selon la revendication 5, la formule suivante étant satisfaite :

$$E_2 - E_1 > 0,1 \ eV.$$

7. Élément d'imagerie selon l'une quelconque des revendications précédentes, un matériau constituant la couche de matériau semi-conducteur d'oxyde inorganique (23B) ayant une mobilité des porteurs de 10 $cm^2$/V.s ou plus.

8. Élément d'imagerie selon l'une quelconque des revendications précédentes, la couche de matériau semi-conducteur d'oxyde inorganique (23B) étant amorphe, ou ayant une épaisseur de $1 \times 10^{-8}$ m à $1,5 \times 10^{-7}$ m.

9. Élément d'imagerie selon l'une quelconque des revendications précédentes,

la lumière étant incidente à partir de la deuxième électrode (22),
la rugosité de surface Ra de la couche de matériau semi-conducteur d'oxyde inorganique (22B) à une interface entre la couche de conversion photoélectrique (23A) et la couche de matériau semi-conducteur d'oxyde inorganique (23B) étant de 1,5 nm ou moins, et une valeur de rugosité moyenne quadratique Rq de la couche de matériau semi-conducteur d'oxyde inorganique (23B) étant de 2,5 nm ou moins.

10. Élément d'imagerie stratifié comprenant au moins un des éléments d'imagerie selon l'une quelconque des revendications 1 à 9.

11. Dispositif d'imagerie à semi-conducteurs comprenant une pluralité d'éléments d'imagerie selon l'une quelconque des revendications 1 à 10.

12. Dispositif d'imagerie à semi-conducteurs comprenant une pluralité d'éléments d'imagerie stratifiés selon la reven-

dication 10.

FIG. 1

## FIG. 2

# FIG. 3

# FIG. 4

*FIG. 5*

## FIG. 6A

## FIG. 6B

## FIG. 6C

# FIG. 7

ONE PIXEL

21

24

# FIG. 8

EP 3 783 652 B1

## FIG. 9

## FIG. 10

FIG. 11

EP 3 783 652 B1

FIG. 12

EP 3 783 652 B1

# FIG. 13

EP 3 783 652 B1

FIG. 14

# FIG. 15

## FIG. 16

# FIG. 17

## FIG. 18

# FIG. 19

# FIG. 20

[DURING CHARGE ACCUMULATION]  [DURING RESET]  [DURING CHARGE TRANSFER]

INSULATING LAYER    RST

$V_{OA}$   $P_B$   $P_D$   $P_A$   FD   $V_{DD}$

ELECTRON

$V_{12}$   $(V_{13})$   $V_{11}$

$V_{22}$   $(V_{23})$   $V_{21}$

[DURING CHARGE ACCUMULATION] [DURING RESET] [DURING CHARGE TRANSFER] [DURING CHARGE ACCUMULATION] [DURING RESET] [DURING CHARGE TRANSFER]

$V_{OA}$

$V_{OT}$

$P_B$

$P_A$

$P_D$

FD

RST

EP 3 783 652 B1

# FIG. 21

[DURING CHARGE ACCUMULATION]

$V_{12}$  $(V_{13})$  $V_{11}$

[DURING RESET]

[DURING CHARGE TRANSFER]

$V_{22}$  $(V_{23})$  $V_{21}$

# FIG. 22

*FIG. 23*

## FIG. 24

# FIG. 25

EP 3 783 652 B1

# FIG. 26

EP 3 783 652 B1

## FIG. 27

WIRING FOR CHARGE DISCHARGE ELECTRODE

# FIG. 28

EP 3 783 652 B1

## FIG. 29

## FIG. 30

## FIG. 31

FIG. 32

# FIG. 33

EP 3 783 652 B1

# FIG. 34

# FIG. 35

# FIG. 36

# FIG. 37

EP 3 783 652 B1

FIG. 38

## FIG. 39

# FIG. 40

# FIG. 41

FIG. 42

## FIG. 43A

Z⊙→Y
↓
X

21

24'₁ — 64₁

24'₂ — 64₂

24'₃ — 64₃

24

61

V₀ₐ

## FIG. 43B

Z⊙→Y
↓
X

21

24'₁ — 64₁

24'₂ — 64₂

24'₃ — 64₃

24

61

V₀ₐ

# FIG. 44A

# FIG. 44B

# FIG. 45

## FIG. 46

FIG. 47

EP 3 783 652 B1

## FIG. 48A

## FIG. 48B

# FIG. 49

| | | | | | |
|---|---|---|---|---|---|
| $24_{11}$ | $21_1$ | $24_{12}$ | $24_{21}$ | $21_2$ | $24_{22}$ |
| $24_{31}$ | $21_3$ | $24_{32}$ | $24_{41}$ | $21_4$ | $24_{42}$ |
| $24_{51}$ | $21_5$ | $24_{52}$ | $24_{61}$ | $21_6$ | $24_{62}$ |
| $24_{71}$ | $21_7$ | $24_{72}$ | $24_{81}$ | $21_8$ | $24_{82}$ |

# FIG. 50

# FIG. 51

| $24_{12}$ | $21_2$ | $24_{21}$ | | $24_{22}$ | $21_3$ | $24_{31}$ |
|---|---|---|---|---|---|---|
| $24_{42}$ | $21_5$ | $24_{51}$ | | $24_{52}$ | $21_6$ | $24_{61}$ |
| $24_{72}$ | $21_8$ | $24_{81}$ | | $24_{82}$ | $21_9$ | $24_{91}$ |

# FIG. 52

# FIG. 53

# FIG. 54

| | | | |
|---|---|---|---|
| $24_{11}$ | $24_{21}$ | $24_{31}$ | $24_{41}$ |

$21_2$  $21_3$  $21_4$

| | | | |
|---|---|---|---|
| $24_{12}$ | $24_{22}$ | $24_{32}$ | $24_{42}$ |

$27$

| | | | |
|---|---|---|---|
| $24_{13}$ | $24_{23}$ | $24_{33}$ | $24_{43}$ |

$21_5$  $21_6$  $21_7$

| | | | |
|---|---|---|---|
| $24_{14}$ | $24_{24}$ | $24_{34}$ | $24_{44}$ |

# FIG. 55

## FIG. 56

$24_{11}$ $24_{12}$ $21_1$ $24_{13}$ $24_{14}$

$24_{21}$ $24_{22}$ $21_2$ $24_{23}$ $24_{24}$

$24_{31}$ $24_{32}$ $21_3$ $24_{33}$ $24_{34}$

$24_{41}$ $24_{42}$ $21_4$ $24_{43}$ $24_{44}$

27

# FIG. 57

$24_{41}$

$24_{42}$

$24_{43}$

$24_{44}$

$24_{31}$

$24_{32}$

$24_{33}$

$24_{34}$

$24_{21}$

$24_{22}$

$24_{23}$

$24_{24}$

$24_{11}$

$27A_1$

$24_{12}$

$27A_2$

$24_{13}$

$27A_3$

$24_{14}$

21

# FIG. 58

*FIG. 59A*

*FIG. 59B*

*FIG. 59C*

FIG. 60

# FIG. 61

# FIG. 62

# FIG. 63

FIG. 64

EP 3 783 652 B1

FIG. 65

EP 3 783 652 B1

## FIG. 66A

## FIG. 66B

CHARGE
ACCUMULATION
ELECTRODE
SIDE

## FIG. 66C

## FIG. 67

EP 3 783 652 B1

FIG. 68

FIG. 69

EP 3 783 652 B1

FIG. 70

FIG. 71

FIG. 72

EP 3 783 652 B1

# FIG. 73

EP 3 783 652 B1

FIG. 74

# FIG. 75

EP 3 783 652 B1

# FIG. 76

# FIG. 77

*FIG. 78*

EP 3 783 652 B1

## FIG. 79

*FIG. 80A*

*FIG. 80B*

*FIG. 80C*

## FIG. 81

FIG. 82

## FIG. 83

FIG. 84

# FIG. 85

## REFERENCES CITED IN THE DESCRIPTION

**Patent documents cited in the description**

- WO 2018025540 A1
- JP 2016063165 A
- JP 2011138927 A
- EP 3496147 A1
- JP 2008177191 A